# EUROPEAN PATENT APPLICATION

(11) **EP 4 583 136 A1**
(43) Date of publication of application: **09.07.2025**
(21) Application number: 24866577.0
(22) Date of filing: 21.11.2024
(51) Int. Cl.: H01H 13/14, H01H 13/56, H01H 13/85, H04M 1/23

(54) **ELECTRONIC DEVICE COMPRISING SIDE KEY**

(30) Priority: 23.11.2023 KR 20230164665; 30.01.2024 KR 20240014230
(71) Applicant: Samsung Electronics Co., Ltd, Suwon-si, Gyeonggi-do 16677 (KR)
(72) Inventor: CHOI, Hyoksu, Suwon-si, Gyeonggi-do 16677 (KR); YANG, Hyunjune, Suwon-si, Gyeonggi-do 16677 (KR); JUNG, Gwangchae, Suwon-si, Gyeonggi-do 16677 (KR); CHO, Yunsu, Suwon-si, Gyeonggi-do 16677 (KR); HA, Dohyung, Suwon-si, Gyeonggi-do 16677 (KR)
(74) Representative: Appleyard Lees IP LLP
(86) International application number: PCT/KR2024/018554
(87) International publication number: WO 2025/110770

(57) **Abstract**

An electronic device according to an embodiment of the disclosure includes a housing including a side surface. A hole is formed in the side surface of the housing. The electronic device includes a side key including a first part exposed to the outside through the hole in the side surface, and a second part connected to the first part and having a portion disposed inside the side surface. The electronic device includes a plurality of vibration structures disposed to contact the second part of the side key. The electronic device includes a plurality of sensors for sensing pressing or a touch of the side key. In addition to these, various other embodiments may be possible.

## Description

### [Technical Field]

Embodiments of the disclosure relate to an electronic device including a side key for providing a haptic function.

### [Background Art]

Electronic devices can perform designated functions according to installed programs. Electronic devices include mobile phones, electronic notebooks, portable multimedia players, mobile communication terminals, tablets, video/audio devices, desktop/laptop computers, or vehicle navigation devices. Electronic devices may provide various functions such as a call/phone function and a multi-media file playback function. In order to perform various functions such as adjusting a call volume, adjusting a multi-media file playback volume, or turning the screen on/off, a side key (e.g., side button) may be disposed at a side surface of a housing of the electronic device. When the side key is pressed, a part of the side key is moved to the inside of the housing. By a movement of the side key, a switch module in contact with the side key is activated, thereby generating an electrical signal. The electrical signal generated by pressing the side key is sent to a processor, so that a designated function is performed.

Tactile feedback, also known as a vibration, haptic feedback, vibration feedback, or tremor feedback, is used in electronic devices to provide feedback about an event to a user. For example, a notification from a mobile phone application can be accompanied by haptic feedback to alert the user. As another example, touching a key of a virtual keyboard on an electronic device can be accompanied by haptic feedback to confirm that a key has been pressed. In this way, users can feel tactile feedback related to the event.

It is desirable to provide an increased number of options for different haptic feedback configurations so that an increased number of events can be indicated to the user.

### [Disclosure of Invention]

### [Solution to Problem]

According to an embodiment of the disclosure, an electronic device may include a housing including a bottom surface and a side surface enclosing the bottom surface. A hole may be formed in at least a portion of the side surface of the housing. The electronic device may include a side key including a first part exposed to the outside through the hole of the side surface, and a second part connected to the first part and having at least a portion disposed inside the side surface. The electronic device may include a plurality of vibration structures disposed to contact the second part of the side key. The electronic device may include a plurality of sensors for sensing pressing or a touch of the side key.

According to an embodiment of the disclosure, an electronic device may include a housing including a bottom surface and a side surface enclosing the bottom surface, a first side key structure, a second side key structure, a first vibration structure, a second vibration structure, and a plurality of sensors. A hole may be formed in at least a portion of a side surface of the housing. A portion of the first side key structure may be exposed to the outside through a first hole of the side surface. A portion of the second side key structure may be exposed to the outside through a second hole of the side surface. The first vibration structure may be disposed to contact at least a portion of the first side key structure. The second vibration structure may be disposed to contact at least a portion of the second side key structure. The plurality of sensors may sense pressing or a touch of the first side key structure and the second side key structure.

There is described an electronic device 200, 300, 400, 500, 600, or 1000, comprising: a housing 610 including a bottom surface 611 and a side surface 612 configured to enclose the bottom surface 611, wherein a hole is formed in at least a portion of the side surface 612 of the housing 610; a side key 620 or 1020 including a first part exposed to the outside through the hole of the side surface 612 and a second part connected to the first part and having at least a portion disposed inside the side surface 612; a plurality of vibration structures 630 disposed to contact a second part of the side key 620 or 1020; and a plurality of sensors 640 or 1040 configured to sense pressing or a touch of the side key 620 or 1020.

In an embodiment, the side key 620 or 1020 comprises: a first key structure 621 or 1021 including a first part exposed to the outside for pressing or a touch, and a second part having a first side connected to the first part and a second side contacting a portion of the plurality of vibration structures 630; a second key structure 622 or 1022 including a third part exposed to the outside for pressing or a touch, and a fourth part having a first side connected to the third part and a second side contacting a portion of the plurality of vibration structures 630; and a third key structure 623 or 1023 including a fifth part exposed to the outside for pressing or a touch, and a sixth part having a first side connected to the fifth part and a second side contacting a portion of the plurality of vibration structures 630.

In an embodiment, a first part of the first key structure 621 or 1021 and a third part of the second key structures 622 or 1022 are connected.

In an embodiment, a fifth part of the third key structure 623 or 1023 is separated from a first part of the first key structure 621 or 1021 and a third part of the second key structure 622 or 1022.

In an embodiment, the plurality of vibration structures 630 comprise: a first vibration structure 631 or 1031 disposed to contact a second part of the first key structure 621 or 1021 to apply a first vibration to the first key structure 621 or 1021; a second vibration structure 632 or 1032 disposed to contact a fourth part of the second key structure 622 or 1022 to apply a second vibration to the second key structure 622 or 1022; and a third vibration structure 633 or 1033 disposed to contact a sixth part of the third key structure 623 or 1023 to apply a third vibration to the third key structure 623 or 1023.

In an embodiment, the first vibration structure 631 or 1031 comprises a first groove 631a or 1031a formed to insert at least a portion of a second part of the first key structure 621 or 1021, the second vibration structure 632 or 1032 comprises a second groove 632a or 1032a formed to insert at least a portion of a fourth part of the second key structure 622 or 1022, and the third vibration structure 633 or 1033 comprises a third groove 633a or 1033a formed to insert at least a portion of a sixth part of the third key structure 623 or 1023.

In an embodiment, the plurality of sensors 640 or 1040 comprise: a first sensor 641 or 1041 configured to sense pressing of the first key structure 621 or 1021; a second sensor 642 or 1042 configured to sense pressing of the second key structure 622 or 1022; and a third sensor 643 or 1043 configured to sense pressing of the third key structure 623 or 1023.

In an embodiment, the first sensor 641 or 1041, the second sensor 642 or 1042, and the third sensor 643 or 1043 are disposed in a lower part of the plurality of vibration structures 630.

In an embodiment, the plurality of sensors 640 or 1040 comprise: a first sensor 1041 configured to sense a touch of a first part of the first key structure 621 or 1021; a second sensor 1042 configured to sense a touch of a third part of the second key structure 622 or 1022; and a third sensor 1043 configured to sense a touch of a fifth part of the third key structures 623 or 1023.

In an embodiment, the first sensor 1041, the second sensor 1042, and the third sensor 1043 are disposed in an upper part of the plurality of vibration structures 630.

In an embodiment, the electronic device further comprises: a vibration structure driving integrated circuit (IC) 550 configured to operate the plurality of vibration structures; and a sensor driving integrated circuit (IC) 560 configured to operate the plurality of sensors 640 and 1040.

In an embodiment, the electronic device further comprises a processor 120 configured to control an operation of the vibration structure driving IC 550 and the sensor driving IC 560.

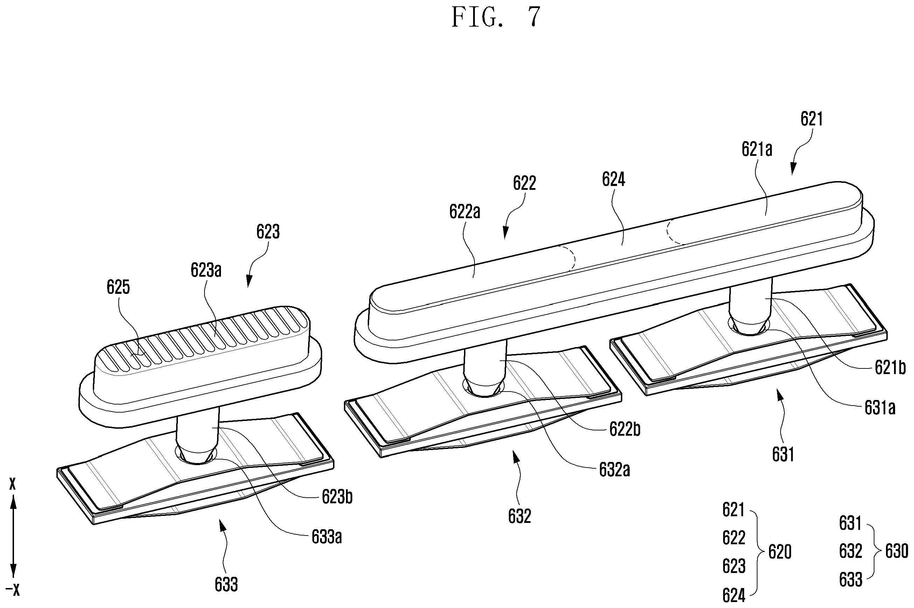

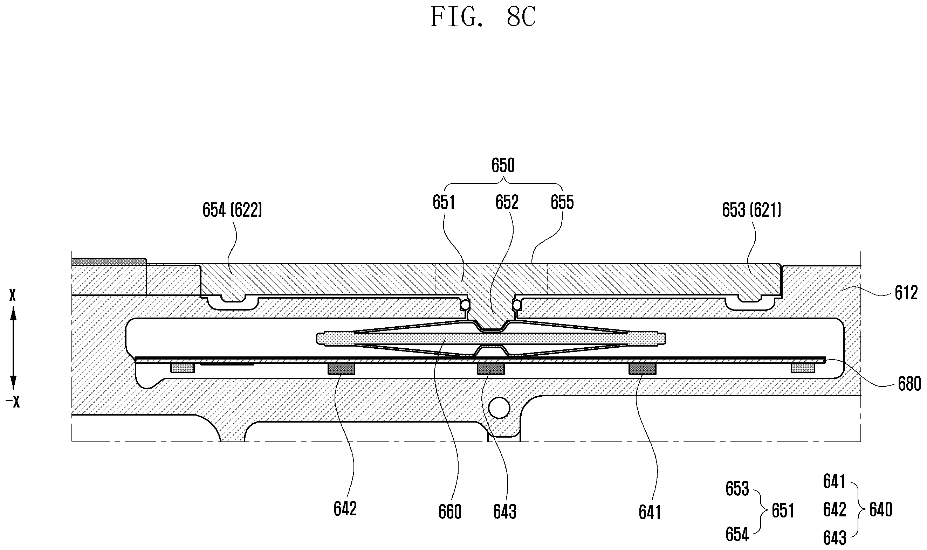

There is also described an electronic device 200, 300, 400, 500, 600, or 1000, comprising: a housing 610 including a bottom surface 611 and a side surface 612 configured to enclose the bottom surface 611, wherein a hole is formed in at least a portion of the side surface 612 of the housing 610; a first side key structure (e.g., a complex key structure 650 of FIG. 8C) having a portion exposed to the outside through a first hole of the side surface 612; a second side key structure (e.g., a third key structure 623 of FIG. 7) having a portion exposed to the outside through a second hole of the side surface 612; a first vibration structure (e.g., a first vibration structure 660 of FIG. 8C) disposed to contact at least a portion of the first side key structure 650; a second vibration structure (e.g., a third vibration structure 633 of FIG. 7) disposed to contact at least a portion of the second side key structure 623; and a plurality of sensors (e.g., a plurality of sensors 640 of FIG. 8C) configured to sense pressing or a touch of the first side key structure 650 and the second side key structure 623.

In an embodiment, pressing or a touch of a plurality of buttons is sensed using the first side key structure 650, and pressing or a touch of one button is sensed using the second side key structure 623.

In an embodiment, the first side key structure 650 comprises: a first part (e.g., a first part 651 of FIG. 8C) exposed to the outside through the first hole; and a second part 652 connected to the first part 651 and having at least a portion disposed inside the side surface 612.

In an embodiment, the first vibration structure 660 comprises a first groove formed to insert at least a portion of the second part 652 of the first side key structure 650, and at least a portion of the second part 652 of the first side key structure 650 is disposed to be inserted into the first groove.

In an embodiment, the second side key structure 623 comprises: a first part 623a exposed to the outside through the second hole; and a second part 623b connected to the first part 623a and having at least a portion disposed inside the side surface 612.

In an embodiment, the second vibration structure 633 comprises a second groove formed to insert at least a portion of the second part 623b of the second side key structure 623, and at least a portion of the second part 623b of the second side key structure 623 is disposed to be inserted into the second groove.

In an embodiment, the first side key structure 650 and the second side key structure 623 are disposed separately, or the first side key structure 650 and the second side key structure 623 are disposed to be connected.

In an embodiment, the plurality of sensors 640 comprise: a first sensor 641 configured to sense pressing of a first area 653 of the first side key structure 650; a second sensor 642 configured to sense pressing of a second area 654 of the first side key structure 650; and a third sensor 643 configured to sense pressing of a connection part 655 of the first side key structure 650.

An electronic device according to an embodiment of the disclosure can independently provide a haptic function with a plurality of side keys disposed at one side surface (or both side surfaces) of a housing.

An electronic device according to an embodiment of the disclosure can provide various haptic responses according to a user's manipulation of a side key.

An electronic device according to an embodiment of the disclosure can prevent a plurality of side keys from being deviated from original positions thereof by pressing the plurality of side keys disposed at one side surface (or both side surfaces) of a housing.

An electronic device according to an embodiment of the disclosure can provide a haptic function with a plurality of side keys disposed at one side surface (or both side surfaces) of a housing and perform a function according to a user's swipe key input (e.g., sliding key input).

An electronic device according to an embodiment of the disclosure can provide a haptic function with a plurality of side keys disposed at one side surface (or both side surfaces) of a housing and perform a function according to a user's scroll key input.

An electronic device according to an embodiment of the disclosure can provide a haptic function with a plurality of side keys disposed at one side surface (or both side surfaces) of a housing and perform a function by pressing a plurality of side keys disposed at one side surface (or both side surfaces) of the housing.

An electronic device according to an embodiment of the disclosure can provide a haptic function with a plurality of side keys disposed at one side surface (or both side surfaces) of a housing and perform a function by touching the plurality of side keys.

An electronic device according to an embodiment of the disclosure can sense a user's touch on a plurality of side keys, thereby reducing a thickness of the plurality of side keys.

The effects that can be obtained from this disclosure are not limited to those mentioned above. Other effects not explicitly stated will be clearly understood by those of ordinary skill in the relevant technical field based on the description below.

### [Brief Description of Drawings]

In relation to the description of the drawings, identical or similar reference numerals may be used for identical or similar components. The subject-matter of the present disclosure is best understood with reference to the accompanying figures, in which:
FIG. 1 is a block diagram illustrating an electronic device in a network environment.
FIGS. 2A and 2B are diagrams illustrating a first state (e.g., unfolded state) of an electronic device when viewed from a front surface and a rear surface.
FIGS. 2C and 2D are diagrams illustrating a second state (e.g., folded state) of an electronic device when viewed from a front surface and a rear surface.
FIG. 3A is a perspective view illustrating a first surface (e.g., front surface) of an electronic device.
FIG. 3B is a perspective view illustrating a second surface (e.g., rear surface) of an electronic device according to an embodiment of the disclosure.
FIG. 4 is a block diagram illustrating a constitution of an electronic device.
FIG. 5 is a block diagram illustrating a constitution of an electronic device.
FIG. 6 is a diagram illustrating an electronic device.
FIG. 7 is a diagram illustrating a side key and a plurality of vibration structures of an electronic device.
FIG. 8A is a cross-sectional view illustrating a side surface, a side key, and a plurality of vibration structures of a housing.
FIG. 8B is a cross-sectional view illustrating a side surface, a side key, and a plurality of vibration structures of a housing.
FIG. 8C is a cross-sectional view illustrating a side surface, a side key, and a vibration structure of a housing.
FIG. 9A is a cross-sectional view illustrating a side surface of a housing in which a side key and a plurality of vibration structures are disposed when viewed in a direction A of FIG. 6.
FIG. 9B is a cross-sectional view illustrating a side surface of a housing in which a side key and a plurality of vibration structures are disposed when viewed in a direction B of FIG. 6.
FIG. 9C is a cross-sectional view illustrating a side surface of a housing in which a side key and a vibration structure are disposed when viewed in a direction A of FIG. 6.
FIG. 10 is a diagram illustrating an electronic device.
FIG. 11 is a diagram illustrating a side key and a plurality of vibration structures of an electronic device.
FIG. 12 is a diagram illustrating a side key and a plurality of vibration structures of an electronic device.
FIG. 13 is a cross-sectional view illustrating a side surface, a side key, and a plurality of vibration structures of a housing.
FIG. 14 is a cross-sectional view illustrating a side surface of a housing in which a side key and a plurality of vibration structures are disposed when viewed in a direction A of FIG. 10.
FIG. 15 is a cross-sectional view illustrating a side key, a plurality of vibration structures, and a plurality of sensors of an electronic device.
FIG. 16 is a diagram illustrating one key structure of a plurality of key structures constituting a side key and one vibration structure of a plurality of vibration structures.
FIG. 17 is a diagram illustrating a key structure and a vibration structure.
FIG. 18 is a diagram illustrating a key structure and a vibration structure.
FIGS. 19A and 19B are diagrams illustrating a side key and a plurality of vibration structures disposed to contact each other.
FIGS. 20 and 21 are diagrams illustrating a key structure and a vibration structure.
FIG. 22 is a diagram illustrating a key structure and a vibration structure.
FIG. 23 is a diagram illustrating a key structure and a vibration structure.
FIGS. 24A and 24B are diagrams illustrating a key structure and a vibration structure.
FIGS. 25A and 25B are diagrams illustrating a key structure and a vibration structure.
FIG. 26 is a diagram illustrating a key structure disposed at a side surface of a housing.
FIG. 27 is a diagram illustrating a key structure disposed at a side surface of a housing.
FIG. 28 is a diagram illustrating a key structure disposed at a side surface of a housing.
FIGS. 29A and 29B are diagrams illustrating a key structure and a vibration structure.
FIGS. 30A and 30B are diagrams illustrating a key structure and a vibration structure.
FIG. 31 is a diagram illustrating a key structure and a vibration structure.
FIG. 32 is a diagram illustrating a key structure and a vibration structure.
FIG. 33 is a diagram illustrating a key structure and a vibration structure.
FIG. 34 is a diagram illustrating a key structure and a vibration structure.
FIG. 35 is a diagram illustrating a key structure and a vibration structure.
FIG. 36 is a diagram illustrating a key structure and a vibration structure.
FIG. 37 is a diagram illustrating a key structure and a vibration structure.
FIG. 38 is a diagram illustrating a key structure and a vibration structure.
FIG. 39 is a diagram illustrating a key structure and a vibration structure.
FIG. 40 is a diagram illustrating a key structure and a vibration structure.
FIGS. 41 and 42 are diagrams illustrating sensing a user's swipe key input using a side key.
FIG. 43 is a diagram illustrating a plurality of sensors and vibration structures disposed on a printed circuit board.

### [Mode for Disclosure]

The following description, with reference to the accompanying drawings, is provided to facilitate comprehensive understanding of various embodiments of the disclosure. Further, for clarity and conciseness, descriptions of well-known functions and constitutions may be omitted. The terms and words used in the following description and claims are not limited to meanings in the literature, but are merely used by the applicant to enable clear and consistent understanding of this document. The singular form should be understood to include plural indication targets unless the context clearly dictates otherwise. Accordingly, for example, reference to a "component surface" may include reference to one or more of such surfaces.

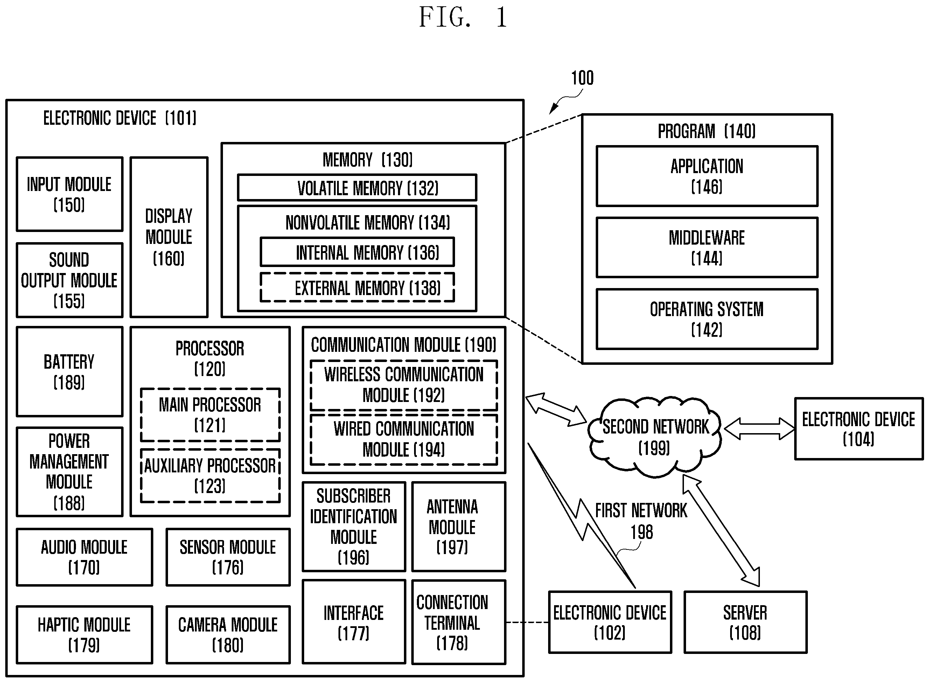

Fig. 1 is a block diagram illustrating an electronic device 101 in a network environment 100 according to various embodiments.

Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultrareliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an interperipheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

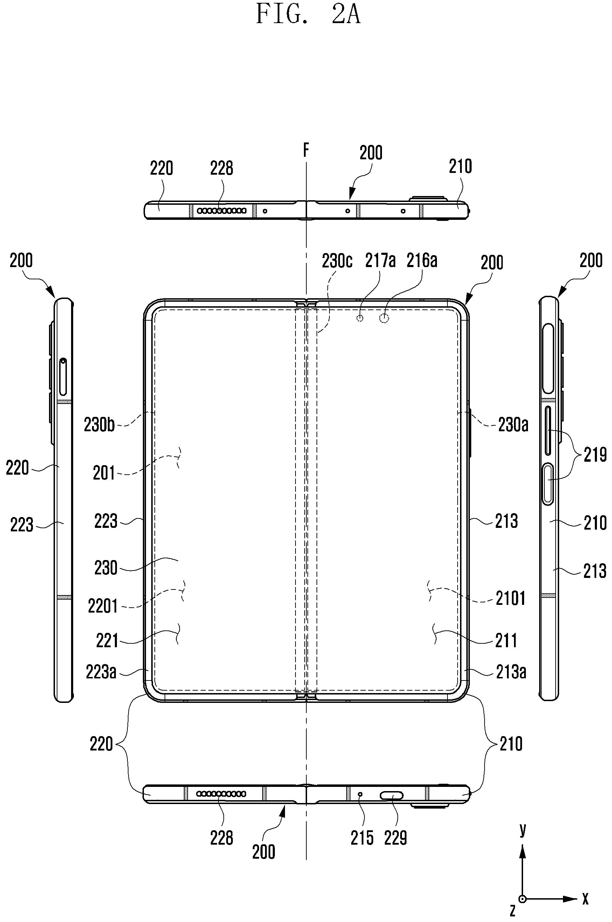

The electronic device 101 may be configured to be folded or unfolded (e.g., an electronic device 200 of FIGS. 2A to 2D), and the display module 160 may include a flexible display configured to be folded or unfolded.

The electronic device 101 may be configured to slide to change the size of the screen (e.g., slidable electronic device), and the display module 160 may include a flexible display disposed to slide to provide the screen (e.g., display screen).

The display module 160 may be referred to as a variable display (e.g., stretchable display), an expandable display, or a slide-in/out display.

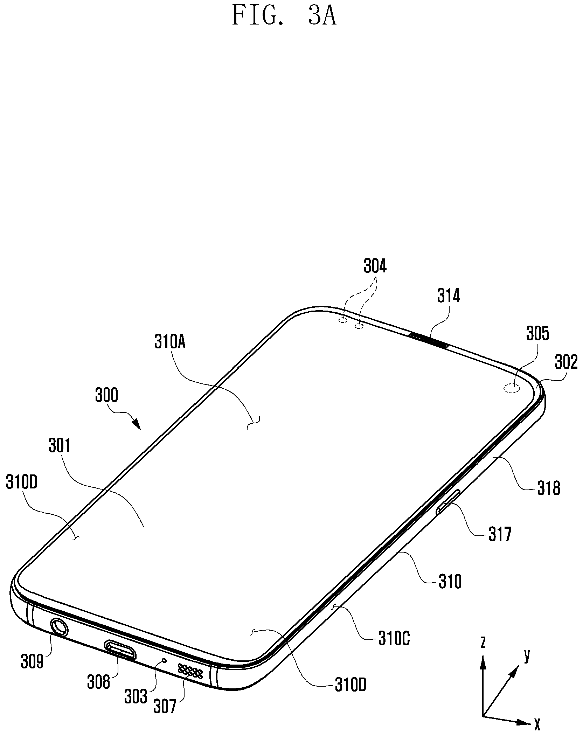

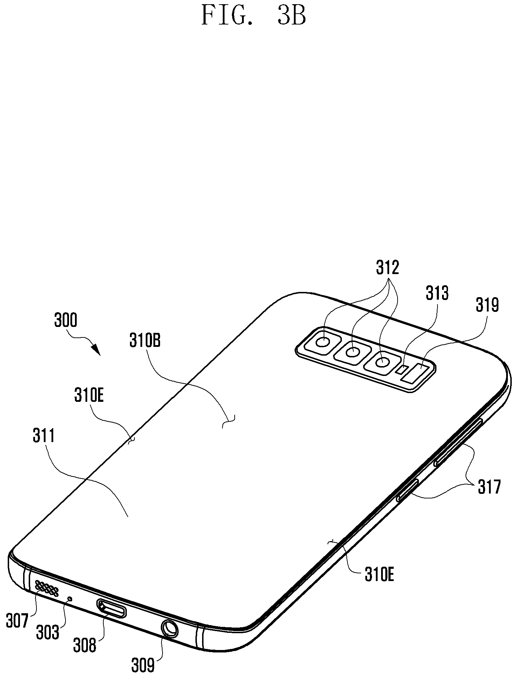

The electronic device 101 may be a bar type or flat type electronic device (e.g., an electronic device 300 of FIGS. 3A and 3B), and the display module 160 may include a bar type or plate type display.

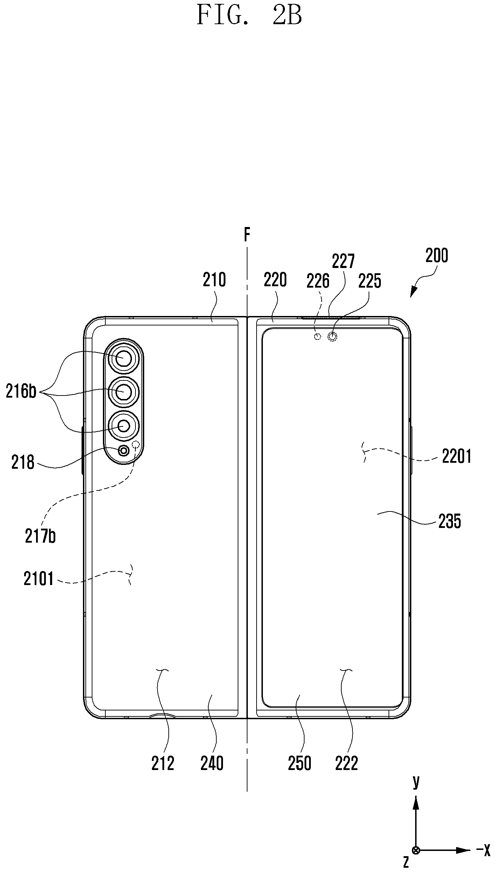

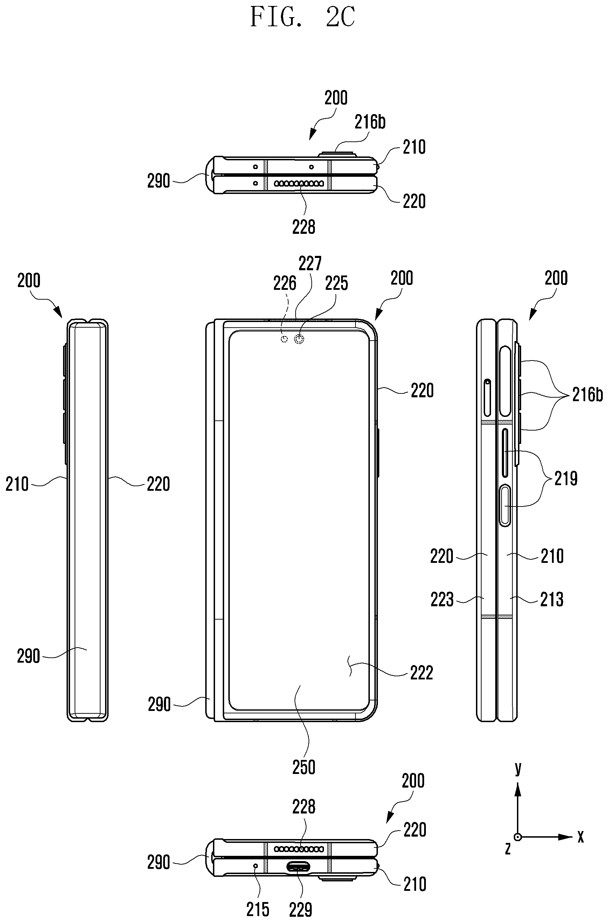

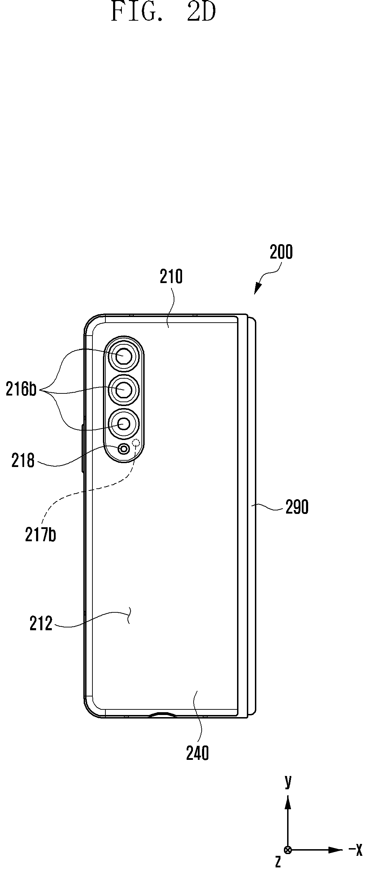

FIGS. 2A and 2B are diagrams illustrating a first state, i.e., an unfolded state, of an electronic device when viewed from a front surface and a rear surface, respectively. FIGS. 2C and 2D are diagrams illustrating a second state, i.e., a folded state, of an electronic device when viewed from a front surface and a rear surface, respectively.

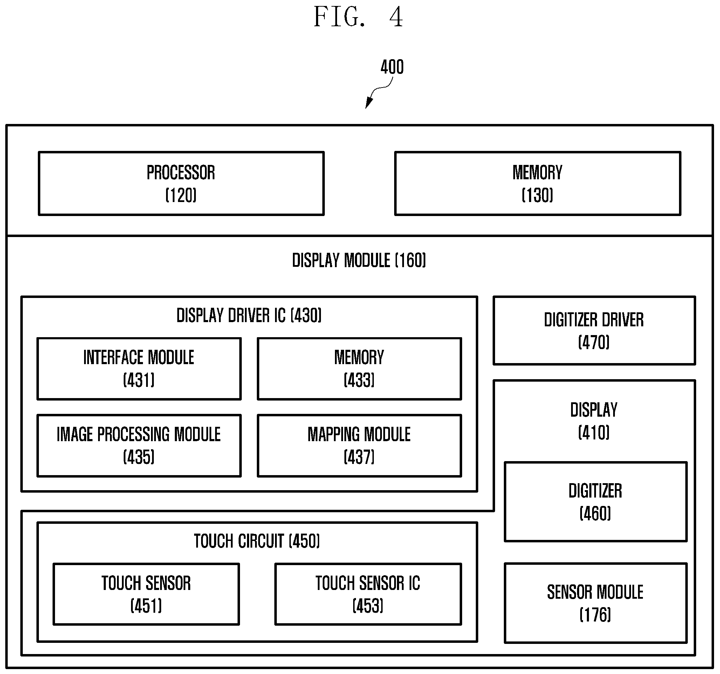

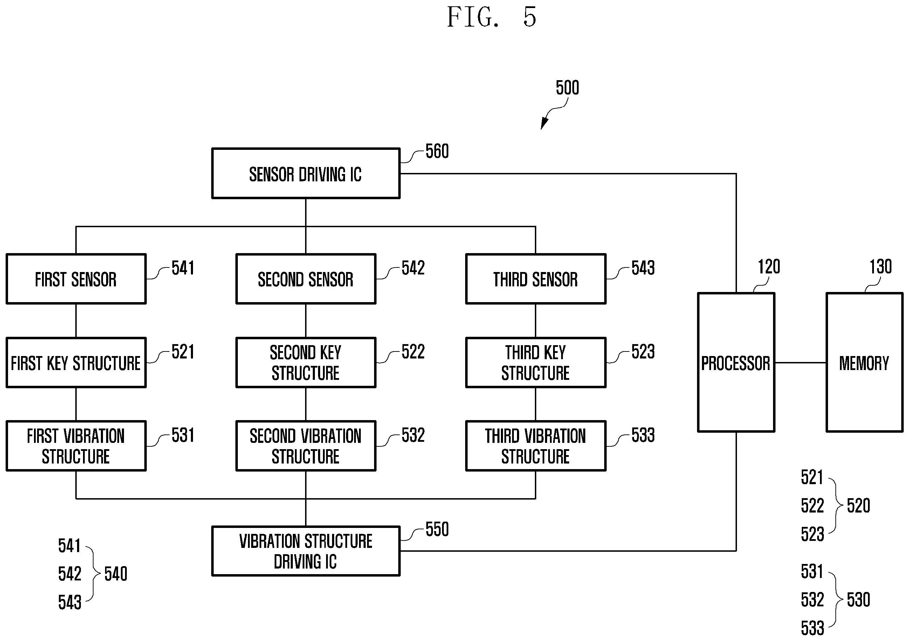

With reference to FIG. 2A to 2D, an electronic device 200 (e.g., the electronic device 101 of FIG. 1, an electronic device 400 of FIG. 4, an electronic device 500 of FIG. 5) includes a pair of housings 210 and 220 (e.g., foldable housing structure) rotatably coupled with a folding axis F through at least one hinge device (e.g., hinge module or hinge structure) so as to be foldable with respect to each other. The electronic device 200 also includes a first display 230 (e.g., flexible display, foldable display, or front display) disposed in the pair of housings 210 and 220, and/or a second display 235 (e.g., rear display) disposed in the second housing 220.

At least a portion of at least one hinge device is not visible from the outside of the electronic device due to a hinge housing 290 (e.g., hinge cover). In this document, a surface in which the first display 230 is disposed is defined as a front surface of the electronic device 200. In this document, a surface opposite to the front surface is defined as a rear surface of the electronic device 200. Further, a surface enclosing a space between the front surface and the rear surface is defined as a side surface of the electronic device 200.

The pair of housings 210 and 220 are not limited to the shape and coupling illustrated in FIGS. 2A to 2D, and may be implemented by combining and/or coupling other shapes or parts.

The first housing 210 and the second housing 220 are disposed on either side of the folding axis F, to give the electronic device 200 an overall symmetrical shape with respect to the folding axis F. The first housing 210 and the second housing 220 can be folded to match each other.

According to an embodiment, the first housing 210 and the second housing 220 may have a different angle or distance therebetween according to whether the electronic device 200 is in a first state (e.g., unfolded state), a second state (e.g., folded state), or a third state (e.g., intermediate state). For example, the electronic device 200 may sense whether it is in a first state (e.g., unfolded state), a second state (e.g., folded state), or a third state (e.g., intermediate state) using a sensor module (e.g., the sensor module 176 of FIG. 1). The electronic device 200 may sense an angle between the first housing 210 and the second housing 220 using the sensor module (e.g., the sensor module 176 of FIG. 1).

According to an embodiment, the first housing 210 may be connected to at least one hinge device in the first state (e.g., unfolded state) of the electronic device 200. The first housing 210 may include a first surface 211 disposed to face the front surface of the electronic device 200, a second surface 212 facing in a direction opposite to that of the first surface 211, and/or a first lateral member 213 enclosing at least a portion of a first space 2101 between the first surface 211 and the second surface 212.

According to an embodiment, the second housing 220 may be connected to at least one hinge device in the first state (e.g., unfolded state) of the electronic device 200. The second housing 220 may include a third surface 221 disposed to face the front surface of the electronic device 200, a fourth surface 222 facing in a direction opposite to that of the third surface 221, and/or a second lateral member 223 enclosing at least a portion of a second space 2201 between the third surface 221 and the fourth surface 222.

According to an embodiment, the first surface 211 may face in substantially the same direction as that of the third surface 221 in the first state (e.g., unfolded state), and at least partially face the third surface 221 in the second state (e.g., folded state).

According to an embodiment, the electronic device 200 may include a recess 201 formed to receive the first display 230 through structural coupling of the first housing 210 and the second housing 220.

According to an embodiment, the recess 201 may have substantially the same size as that of the first display 230.

According to an embodiment, the first housing 210 may be coupled to the first lateral member 213 when the first display 230 is viewed from above. The first housing 210 may include a first protection frame 213a (e.g., first decorative member) disposed to overlap an edge of the first display 230 to cover the edge of the first display 230 so that it is invisible from the outside.

According to an embodiment, the first protection frame 213a may be formed integrally with the first lateral member 213.

According to an embodiment, the second housing 220 may be coupled to a second lateral member 223 when the first display 230 is viewed from above. The second housing 220 may include a second protection frame 223a disposed to overlap an edge of the first display 230 to cover the edge of the first display 230 so that it is invisible from the outside.

According to an embodiment, the second protection frame 223a may be formed integrally with the second lateral member 223. In an embodiment, the first protection frame 213a and the second protection frame 223a may be omitted.

According to an embodiment, the hinge housing 290 (e.g., hinge cover) may be disposed between the first housing 210 and the second housing 220. The hinge housing 290 may be disposed to cover a portion (e.g., at least one hinge module) of at least one hinge device.

According to an embodiment, the hinge housing 290 may be covered by a portion of the first housing 210 and the second housing 220 or may be exposed to the outside according to the first state (e.g., unfolded state), the second state (e.g., folded state), or the third state (e.g., intermediate state) of the electronic device 200. For example, in the case that the electronic device 200 is in a first state (e.g., unfolded state), at least a portion of the hinge housing 290 may be covered by the first housing 210 and the second housing 220 to be disposed to be substantially invisible from the outside.

According to an embodiment, in the case that the electronic device 200 is in a second state (folded state), at least a portion of the hinge housing 290 may be disposed to be visible from the outside between the first housing 210 and the second housing 220.

According to an embodiment, in the case that the first housing 210 and the second housing 220 are in a third state (intermediate state) in which the first housing 210 and the second housing 220 are folded with a certain angle, the hinge housing 290 may be disposed between the first housing 210 and the second housing 220 so as to be at least partially visible from the outside of the electronic device 200. For example, in the third state (intermediate state), an area of the hinge housing 290 exposed to the outside may be smaller than that in a state in which the first housing 210 and the second housing 220 are fully folded. According to an embodiment, the hinge housing 290 may include a curved surface.

According to an embodiment, in the case that the electronic device 200 is in the first state (e.g., unfolded state), the first housing 210 and the second housing 220 may form an angle of about 180 degrees, and a first area 230a, a second area 230b, and a folding area 230c of the first display 230 may form substantially the same plane. The first area 230a, the second area 230b, and the folding area 230c of the first display 230 may be disposed to face substantially the same direction (e.g., z-axis direction). As an example, in the case that the electronic device 200 is in the first state (e.g., unfolded state), the first housing 210 may rotate to an angle of about 360 degrees with respect to the second housing 220 to be folded in the opposite direction so that the second surface 212 and the fourth surface 222 face each other (e.g., out folding manner).

According to an embodiment, in the case that the electronic device 200 is in the second state (folded state), the first surface 211 of the first housing 210 and the third surface 221 of the second housing 220 may be disposed to face each other. In this case, the first area 230a and the second area 230b of the first display 230 may form a narrow angle (e.g., the range of 0 degrees to about 10 degrees) with each other through the folding area 230c and be disposed to face each other. According to an embodiment, at least a portion of the folding area 230c may be transformed into a curved shape with a predetermined curvature.

According to an embodiment, in the case that the electronic device 200 is in the third state (intermediate state), the first housing 210 and the second housing 220 may be disposed at a certain angle to each other. In this case, the first area 230a and the second area 230b of the first display 230 may form an angle greater than that in the second state (e.g., folded state) and smaller than that in the first state (e.g., unfolded state), and a curvature of the folding area 230c may be smaller than that in the second state (e.g., folded state) and greater than that in the first state (e.g., unfolded state). In an embodiment, the first housing 210 and the second housing 220 may form an angle that may stop at a designated folding angle between the second state (e.g., folded state) and the third state (e.g., intermediate state) through at least one hinge device (e.g., free stop function). In an embodiment, the first housing 210 and the second housing 220 may be continuously operated while being pressed in an unfolding or folding direction based on a designated inflection angle through at least one hinge device.

As shown in FIGS. 2A, 2B, 2C and 2D, the electronic device 200 includes a display 230 and 235, an input device 215, sound output devices 227 and 228, sensor modules 217a, 217b, and 226, camera modules 216a, 216b, and 225, a key input device 219, an indicator (not illustrated), or a connector port 229 disposed in the first housing 210 and/or the second housing 220. The key input device 219 includes a side key, and may optionally include other keys, such as a power button. The electronic device 200 may omit at least one of the components or additionally include at least one other component.

According to an embodiment, the at least one display 230 and 235 may include a first display 230 (e.g., flexible display) from the first surface 211 of the first housing 210 to be disposed to be supported by the third surface 221 of the second housing 220 through at least one hinge device, and a second display 235 disposed to be at least partially visible from the outside through the fourth surface 222 in an inner space of the second housing 220.

In an embodiment, the second display 235 may be disposed to be visible from the outside through the second surface 212 in an inner space of the first housing 210.

According to an embodiment, the first display 230 may be mainly used in the first state (e.g., unfolded state) of the electronic device 200. The second display 235 may be used even in the first state (e.g., unfolded state) of the electronic device 200.

According to an embodiment, the second display 235 may be mainly used in the second state (e.g., folded state) of the electronic device 200. The first display 230 may be used even in the second state (e.g., folded state) of the electronic device 200.

According to an embodiment, in the case of the third state (e.g., intermediate state), the electronic device 200 may control to use the first display 230 and/or the second display 235 based on a folding angle of the first housing 210 and the second housing 220.

According to an embodiment, the first display 230 may be disposed in a receiving space formed by a pair of housings 210 and 220. For example, the first display 200 may be disposed in the recess 201 formed by a pair of housings 210 and 220, and be disposed to occupy substantially most of the front surface of the electronic device 200 in the first state (e.g., unfolded state). According to an embodiment, the first display 230 may include a flexible display having at least a partial area that may be transformed into a flat surface or a curved surface.

According to an embodiment, the first display 230 may include a first area 230a facing the first housing 210 and a second area 230b facing the second housing 220. According to an embodiment, the first display 230 may include a folding area 230c including a portion of the first area 230a and a portion of the second area 230b based on the folding axis F.

According to an embodiment, at least a portion of the folding area 230c may include an area corresponding to at least one hinge device.

According to an embodiment, area division of the first display 230 is only exemplary physical division by a pair of housings 210 and 220 and at least one hinge device, and the first display 230 may be displayed as a substantially seamless and single full screen through a pair of housings 210 and 220 and at least one hinge device.

According to an embodiment, the first area 230a and the second area 230b may have an overall symmetrical shape or a partially asymmetrical shape based on the folding area 230c.

According to an embodiment, the electronic device 200 may include a first rear cover 240 disposed at the second surface 212 of the first housing 210, and a second rear cover 250 disposed at the fourth surface 222 of the second housing 220. In an embodiment, at least a portion of the first rear cover 240 may be formed integrally with the first lateral member 213. In an embodiment, at least a portion of the second rear cover 250 may be formed integrally with the second lateral member 223.

According to an embodiment, at least one of the first rear cover 240 and the second rear cover 250 may be formed with a substantially transparent plate (e.g., a glass plate or a polymer plate including various coating layers) or an opaque plate. According to an embodiment, the first rear cover 240 may be formed by an opaque plate, for example, coated or colored glass, ceramic, polymer, metal (e.g., aluminum, stainless steel (STS), or magnesium), or a combination of at least two of the above materials.

According to an embodiment, the second rear cover 250 may be formed through a substantially transparent plate, for example, glass or polymer. Accordingly, the second display 235 may be disposed in an inner space of the second housing 220 to be visible from the outside through the second rear cover 250.

According to an embodiment, the input device 215 may include a microphone. In an embodiment, the input device 215 may include a plurality of microphones disposed to detect a direction of sound.

According to an embodiment, the sound output devices 227 and 228 may include speakers. According to an embodiment, the sound output devices 227 and 228 may include a call receiver 227 disposed through the fourth surface 222 of the second housing 220, and an external speaker 228 disposed through at least a portion of the second lateral member 223 of the second housing 220.

In an embodiment, the input device 215, the sound output devices 227, 228, and the connector port 229 may be disposed in spaces of the first housing 210 and/or the second housing 220. The input device 215, the sound output devices 227 and 228, and the connector port 229 may be exposed to an external environment through at least one hole formed in the first housing 210 and/or the second housing 220. In an embodiment, the holes formed in the first housing 210 and/or the second housing 220 may be commonly used for the input device 215 and the sound output devices 227 and 228. In an embodiment, the sound output devices 227 and 228 may include a speaker (e.g., piezo speaker) for operating without the hole formed in the first housing 210 and/or the second housing 220.

According to an embodiment, the camera modules 216a, 216b, and 225 may include a first camera module 216a disposed at the first surface 211 of the first housing 210, a second camera module 216b disposed at the second surface 212 of the first housing 210, and/or a third camera module 225 disposed at the fourth surface 222 of the second housing 220.

According to an embodiment, the electronic device 200 may include a flash 218 disposed near the second camera module 216b. According to an embodiment, the flash 218 may include, for example, a light emitting diode or a xenon lamp.

According to an embodiment, the camera modules 216a, 216b, and 225 may include one or more lenses, an image sensor, and/or an image signal processor. In an embodiment, at least one of the camera modules 216a, 216b, and 225 may include two or more lenses (e.g., wide angle and telephoto lenses) and image sensors, and be disposed together at any one surface of the first housing 210 and/or the second housing 220.

According to an embodiment, the sensor modules 217a, 217b, and 226 (e.g., the sensor module 176 of FIG. 1) may generate electrical signals or data values corresponding to an internal operating state or an external environmental state of the electronic device 200.

According to an embodiment, the sensor modules 217a, 217b, and 226 (e.g., the sensor module 176 of FIG. 1) may include a first sensor module 217a disposed at the first surface 211 of the first housing 210, a second sensor module 217b disposed at the second surface 212 of the first housing 210, and/or a third sensor module 226 disposed at the fourth surface 222 of the second housing 220.

In an embodiment, the sensor modules 217a, 217b, and 226 (e.g., the sensor module 176 of FIG. 1) may include at least one of a gesture sensor, a gyro sensor, a grip sensor, a color sensor, an infrared (IR) sensor, an illumination sensor, an ultrasonic sensor, a proximity sensor, a biometric sensor (e.g., iris recognition sensor), a distance detection sensor (e.g., time of flight (TOF) sensor, light detection and ranging (LiDAR) sensor), an atmospheric pressure sensor, a magnetic sensor (e.g., 6-axis sensor, geomagnetic sensor), an acceleration sensor, a temperature sensor, a humidity sensor, and/or a fingerprint recognition sensor.

According to an embodiment, the processor (e.g., the processor 120 of FIG. 1) of the electronic device 200 may operate the sensor modules 217a, 217b, and 226 (e.g., the sensor module 176 of FIG. 1) to sense the illuminance and/or IR intensity around the electronic device 200. The processor 120 may acquire information on ambient illuminance and information on the IR intensity of the electronic device 200.

According to an embodiment, the electronic device 200 may include at least one of a gesture sensor, a gyro sensor, a grip sensor, a color sensor, an infrared (IR) sensor, an illumination sensor, an ultrasonic sensor, a proximity sensor, a biometric sensor (e.g., iris recognition sensor), a distance detection sensor (e.g., time of flight (TOF) sensor, light detection and ranging (LiDAR) sensor), an atmospheric pressure sensor, a magnetic sensor (e.g., 6-axis sensor, geomagnetic sensor), an acceleration sensor, a temperature sensor, a humidity sensor, and/or a fingerprint recognition sensor that are/is not illustrated.

In an embodiment, the fingerprint recognition sensor may be disposed through at least one of the first lateral member 213 of the first housing 210 and/or the second lateral member 223 of the second housing 220.

The key input device 219 is disposed to be exposed to the outside through the first lateral member 213, i.e., a side surface, of the first housing 210. In an embodiment, the key input device 219 may be disposed to be exposed to the outside through the second lateral member 223, i.e., a side surface, of the second housing 220.

According to an embodiment, the connector port 229 may include a connector (e.g., USB connector or an interface connector port module (IF module)) for transmitting and receiving power and/or data to and from an external electronic device. In an embodiment, the connector port 229 may perform together a function for transmitting and receiving audio signals to and from an external electronic device, or further include a separate connector port (e.g., ear jack hole) for performing a function of transmitting and receiving audio signals.

According to an embodiment, at least one camera module 216a and 225 of the camera modules 216a, 216b, and 225, at least one sensor module 217a and 226 of the sensor modules 217a, 217b, and 226, and/or the indicator may be disposed to be visually exposed through at least one display 230 and 235. For example, at least one camera module 216a and 225, at least one sensor module 217a and 226, and/or an indicator may be disposed under an activation area (display area) of at least one display 230 and 235 in an inner space of at least one housing 210 and 220. At least one camera module 216a and 225, at least one sensor module 217a and 226, and/or an indicator may be disposed to contact an external environment to a cover member (e.g., window layer (not illustrated) of the first display 230 and/or the second rear cover 250) through a perforated opening or transmission area.

According to an embodiment, an area in which at least one display 230 and 235 and at least one camera module 216a and 225 face each other is part of an area that displays contents and may be formed as a transmission area with a predetermined transmittance.

According to an embodiment, the transmission area may be formed to have a transmittance of a range of about 5% to about 20%. Such a transmission area may include an area overlapped with an effective area (e.g., field of view area) of at least one camera module 216a and 225 through which light for generating an image by the image sensor passes. For example, the transmission area of the displays 230 and 235 may include an area in which a density of pixels is lower than that of a peripheral area. For example, the transmission area may replace an opening. For example, at least one camera module 216a and 225 may include an under display camera (UDC) or an under panel camera (UPC). As an example, some camera module or the sensor module 217a and 226 may be disposed to perform functions thereof without being visually exposed through the display. For example, an area facing the camera modules 216a and 225 and/or the sensor modules 217a and 226 disposed under the displays 230 and 235 (e.g., display panel) has an under display camera (UDC) structure and may not require a perforated opening.

The electronic device 200 includes a plurality of vibration structures (e.g., a plurality of vibration structures 530 of FIG. 5). These vibration structures are configured to generate a vibration and provide, i.e., transfer, this vibration to the key input device 219. In this way, a vibration is applied to the key input device 219 by the plurality of vibration structures 530. In this way, the key input device 219 is configured to provide a haptic function, i.e., is configured to vibrate. The plurality of vibration structures 530 are disposed inside the housing 210 and/or 220.

FIG. 3A is a perspective view illustrating a first surface (e.g., front surface) of an electronic device 300. FIG. 3B is a perspective view illustrating a second surface (e.g., rear surface) of the electronic device 300.

With reference to FIGS. 3A and 3B, the electronic device 300 (e.g., the electronic device 101 of FIG. 1, an electronic device 400 of FIG. 4, an electronic device 500 of FIG. 5) includes a first surface (or front surface) 310A, a second surface (or rear surface) 310B, and a housing 310. The electronic device 300 (e.g., the electronic device 101 of FIG. 1, an electronic device 400 of FIG. 4, an electronic device 500 of FIG. 5) includes a display 301 (e.g., a display 410 of FIG. 4).

According to an embodiment, the display 301 may be supported by the housing 310. For example, the display 310 may include a liquid crystal display (LCD) display, an organic light emitting diode (OLED) display, or a micro LED display.

According to an embodiment, the housing 310 may include a side surface 310C enclosing a space between the first surface 310A and the second surface 310B. According to an embodiment, the housing 310 may refer to a structure that forms a portion of the first surface 310A, the second surface 310B, and the side surface 310C.

According to an embodiment, the first surface 310A may be formed by a front plate 302 (e.g., a glass plate or a polymer plate including various coating layers) having at least a portion substantially transparent.

According to an embodiment, the second surface 310B may be formed by a substantially opaque rear plate 311. The rear plate 311 may be made of, for example, coated or colored glass, ceramic, polymer, metal (e.g., aluminum, stainless steel (STS), or magnesium), or a combination of at least two of the above materials. However, the disclosure is not limited thereto, and the rear plate 311 may be made of transparent glass.

According to an embodiment, the side surface 310C may be coupled to the front plate 302 and the rear plate 311 and be formed by a side bezel structure 318 (or "lateral member") including metal and/or polymer. According to an embodiment, the rear plate 311 and the side bezel structure 318 may be integrally formed and include the same material (e.g., metal material such as aluminum).

According to an embodiment, the front plate 302 may include two first areas 310D that are curved from the first surface 310A toward the rear plate 311 to be extended seamlessly. Two first areas 310D may be disposed at both ends of a long edge of the front plate 302.

According to an embodiment, the rear plate 311 may include two second areas 310E that are curved from the second surface 310B toward the front plate 302 to be extended seamlessly.

According to an embodiment, the front plate 302 (or the rear plate 311) may include only one of the first areas 310D (or the second areas 310E). According to an embodiment, some of the first areas 310D or the second areas 310E may not be included.

In embodiments, when viewed from the side surface of the electronic device 300, the side bezel structure 318 may have a first thickness (or width) at the side surface that does not include the first areas 310D or the second areas 310E. In embodiments, when viewed from the side surface of the electronic device 300, the side bezel structure 318 may have a second thickness (or width) smaller than the first thickness at the side surface including the first areas 310D or the second areas 310E.

As shown in FIGS. 3A and 3B, the electronic device 300 includes a display 301, a sound input device 303 (e.g., the input module 150 of FIG. 1, microphone), sound output devices 307 and 314 (e.g., the sound output module 155 of FIG. 1, speaker) (e.g., audio module), sensor modules 304 and 319 (e.g., the sensor module 176 of FIG. 1), camera modules 305 and 312 (e.g., the camera module 180 of FIG. 1), a flash 313, a key input device 317 (e.g., the key input device 219 of FIG 2A), an indicator (not illustrated), or connectors 308 and 309. The key input device 317 includes a side key, and may optionally include other keys, such as a power button.

According to an embodiment, the display 301 may be visually visible through an upper end portion of the front plate 302.

According to an embodiment, at least a portion of the display 301 may be visible through the front plate 302 forming the first area 310D of the side surface 310C and the first surface 310A.

For example, the display module (e.g., the display module 160 of FIG. 1, a display module 160 of FIG. 4) may include a touch circuit (e.g., a touch circuit 450 of FIG. 4) including a touch sensor (e.g., a touch sensor 451 of FIG. 4) and a touch sensor integrated circuit (IC) (e.g., a touch sensor IC 453 of FIG. 4). The display module (e.g., the display module 160 of FIG. 1, the display module 160 of FIG. 4) may include a pressure sensor capable of measuring the intensity (pressure) of a touch. For example, the display 301 may be coupled to or disposed adjacent to a touch circuit (e.g., a touch circuit 450 of FIG. 4) and/or a pressure sensor. For example, the display 301 may be coupled to or disposed adjacent to a digitizer (e.g., a digitizer 460 of FIG. 4) for detecting a magnetic field type electronic pen (e.g., stylus pen).

According to an embodiment, at least a portion of the sensor modules 304 and 319 may be disposed in the first area 310D and/or the second area 310E.

According to an embodiment, at least one of the first sensor module 304, the camera modules 305 and 312 (e.g., image sensor), the sound output device 314 (e.g., audio module), or the fingerprint sensor may be disposed at a rear surface of a screen display area of the display 301.

According to an embodiment, the sound input device 303 may include a microphone. According to an embodiment, the input device 303 may include a plurality of microphones disposed to detect a direction of sound.

According to an embodiment, the sound output devices 307 and 314 may include a sound output device 307 operating as an external speaker and a sound output device 314 operating as a call receiver.

In some embodiments, the sound input device 303 (e.g., microphone), the sound output devices 307 and 314, and the connectors 308 and 309 may be disposed in an inner space of the electronic device 300. The sound input device 303 (e.g., microphone), the sound output devices 307 and 314, and the connectors 308 and 309 may be exposed to an external environment through at least one hole formed in the housing 310. In some embodiments, the hole formed in the housing 310 may be commonly used for the sound input device 303 (e.g., microphone) and the sound output devices 307 and 314. In some embodiments, the sound output devices 307 and 314 may include speakers (e.g., piezo speakers) that operate without the hole formed in the housing 310.

According to an embodiment, the sensor modules 304 and 319 (e.g., the sensor module 176 of FIG. 1) may generate an electrical signal or a data value corresponding to an internal operating state or an external environmental state of the electronic device 300. The sensor modules 304 and 319 may include a first sensor module 304 (e.g., proximity sensor) disposed at the first surface 310A of the housing 310, and/or a second sensor module 319 (e.g., heart rate monitor (HRM) sensor) and/or a third sensor module (not illustrated) (e.g., fingerprint sensor) disposed at the second surface 310B of the housing 310. As an example, the fingerprint sensor may be disposed at the first surface 310A (e.g., the display 301) and/or the second surface 310B of the housing 310.

The electronic device 300 may further include at least one of a gesture sensor, a gyro sensor, an atmospheric pressure sensor, a magnetic sensor (e.g., a geomagnetic sensor 700 of FIG. 7), an acceleration sensor, a grip sensor, a color sensor, an infrared (IR) sensor, a biometric sensor, a temperature sensor, a humidity sensor, and/or an illumination sensor that are/is illustrated.

According to an embodiment, the camera modules 305 and 312 may include a first camera module 305 disposed at the first surface 310A and a second camera module 312 disposed at the second surface 310B of the electronic device 300. A flash 313 may be disposed around the camera modules 305 and 312. The camera modules 305 and 312 may include one or more lenses, an image sensor, and/or an image signal processor. The flash 313 may include, for example, a light emitting diode or a xenon lamp.

According to an embodiment, the first camera module 305 may be disposed in a lower part of a display panel of the display 301 in an under display camera (UDC) manner. According to an embodiment, two or more lenses (wide angle and telephoto lenses) and image sensors may be disposed at one surface of the electronic device 300. According to an embodiment, a plurality of first camera modules 305 may be disposed at the first surface (e.g., a surface in which the screen is displayed) of the electronic device 300 in an under display camera (UDC) manner.

As shown in FIG. 3A and 3B, the key input device 317 is disposed at the side surface 310C of the housing 310. The key input device 317 is described hereinbefore as the key input device 219, in relation to the electronic device 200 of FIGS. 2A, 2B, 2C and 2D.

According to an embodiment, the connectors 308 and 309 may include a first connector hole 308 capable of receiving a connector (e.g., USB connector) for transmitting and receiving power and/or data to and from an external electronic device, and/or a second connector hole 309 (or earphone jack) capable of receiving a connector for transmitting and receiving audio signals to and from an external electronic device. The first connector hole 308 may include a universal serial bus (USB) type A, USB type B, or USB type C port. In the case that the first connector hole 308 supports the USB type C, the electronic device 300 (e.g., the electronic device 101 of FIG. 1, the electronic device 200 of FIG. 2A, an electronic device 400 of FIG. 4) may support USB power delivery (PD) charging.

According to an embodiment, the first camera module 305 of the camera modules 305 and 312 and/or the first sensor module 304 of the sensor modules 304 may be disposed to be visually visible through the display 301.

According to an embodiment, in the case that the first camera module 305 is disposed in an under display camera (UDC) manner, the first camera module 305 may be visually invisible to the outside.

According to an embodiment, the first camera module 305 may be disposed to overlap the display area, and display a screen in the display area corresponding to the first camera module 305. The first sensor module 304 may be disposed to perform a function thereof in an inner space of the electronic device 300 without being visually exposed through the front plate 302.

The electronic device 300 includes a plurality of vibration structures, as described hereinbefore in relation to the electronic device 200 of FIGS. 2A, 2B, 2C and 2D..

FIG. 4 is a block diagram illustrating components of an electronic device 400.

With reference to FIG. 4, the electronic device 400 includes a processor 120 (e.g., the processor 120 of FIG. 1), a memory 130 (e.g., the memory 130 of FIG. 1), a sensor module 176 (e.g., the sensor module 176 of FIG. 1), and a display module 160 (e.g., the display module 160 of FIG. 1).

The memory 130 (e.g., the memory 130 of FIG. 1) may include at least one of a high bandwidth memory (HBM), a dynamic random access memory (DRAM), a static random access memory (SRAM), a phase-change random access memory (PRAM), a magnetic random access memory (MRAM), a resistive random access memory (RRAM), a flash memory, and/or an electrically erasable programmable read-only memory (EEPROM).

The display module 160 (e.g., the display module 160 of FIG. 1) may include a display 410, a display driver IC (hereinafter, 'DDIC') 430 (e.g., display driver) for driving the display 410, a touch circuit 450, a digitizer 460, and a digitizer driver 470. All or part of the sensor module 176 may be included in the display module 160.

According to an embodiment, the DDIC 430 may include an interface module 431 (e.g., interface circuit), a memory 433 (e.g., buffer memory), an image processing module 435 (e.g., image processing circuit), or a mapping module 437 (e.g., mapping circuit).

According to an embodiment, the DDIC 430 may receive image data or image information including an image control signal corresponding to a command for controlling the image data from other components of the electronic device (e.g., the electronic device 101 of FIG. 1, the electronic device 200 of FIGS. 2 and 3) through the interface module 431.

According to an embodiment, image information may be received from the processor (e.g., the processor 120 of FIG. 1).

According to an embodiment, image information may be received from the application processor (e.g., main processor) (e.g., the main processor 121 of FIG. 1).

According to an embodiment, image information may be received from an auxiliary processor (e.g., the auxiliary processor 123 of FIG. 1) (e.g., graphics processer) for operating independently of a function of the application processor (e.g., main processor).

According to an embodiment, the DDIC 430 may communicate with the touch circuit 450 or the sensor module 176 through the interface module 431. Further, the DDIC 430 may store at least some of the received image information in the memory 433. As an example, the DDIC 430 may store at least a portion of the received image information in the memory 433 in units of frames.

According to an embodiment, the image processing module 435 may perform pre-processing or post-processing (e.g., resolution, brightness, or size adjustment) of at least a portion of the image data based on at least characteristics of the image data or characteristics of the display 410.

According to an embodiment, the mapping module 437 may generate a voltage value or a current value corresponding to the image data pre-processed or post-processed through the image processing module 435. According to an embodiment, the generation of a voltage value or a current value may be performed based on at least a portion of attributes (e.g., an array of pixels (RGB stripe or pentile structure) or size of each of subpixels) of pixels of the display 410.

According to an embodiment, at least some pixels of the display 410 may be driven based at least a portion of the voltage value or the current value. As at least some pixels are driven based on at least a portion of the voltage value or current value, visual information (e.g., text, image, or icon) corresponding to the image data may be displayed through the display 410.

According to an embodiment, the touch circuit 450 may include a touch sensor 451 and a touch sensor integrated circuit (IC) 453 for controlling the touch sensor 451.

According to an embodiment, the touch sensor IC 453 may control the touch sensor 451 to detect a touch input or a hovering input for a specific position of the display 410. For example, the touch sensor IC 453 may measure a change in a signal (e.g., voltage, light amount, resistance, or charge amount) for a specific position of the display 410 to detect a touch input or a hovering input. The touch sensor IC 453 may provide information (e.g., position, area, pressure, or time) on the detected touch input or hovering input to the processor 120.

According to an embodiment, at least a portion (e.g., the touch sensor IC 453) of the touch circuit 450 may be included as a portion of the DDIC 430 or the display 410.

According to an embodiment, at least a portion (e.g., the touch sensor IC 453) of the touch circuit 450 may be included as a portion of another component (e.g., the auxiliary processor 123) disposed outside the display module 160.

According to an embodiment, the display module 160 may further include at least one sensor (e.g., fingerprint sensor, iris sensor, pressure sensor, or illumination sensor) of the sensor module 176, or a control circuit therefor. In this case, the at least one sensor or the control circuit therefor may be embedded in a portion (e.g., the display 410 or the DDIC 430) of the display module 160 or a portion of the touch circuit 450.

For example, in the case that the sensor module 176 embedded in the display module 160 includes a biometric sensor (e.g., fingerprint sensor), the biometric sensor may acquire biometric information (e.g., fingerprint image) associated with a touch input through a partial area of the display 410.

For example, in the case that the sensor module 176 embedded in the display module 160 includes a pressure sensor, the pressure sensor may acquire pressure information associated with a touch input through a partial area or an entire area of the display 410.

According to an embodiment, the touch sensor 451 or the sensor module 176 may be disposed between pixels of a pixel layer of the display 410, or over or under the pixel layer.

According to an embodiment, the display module 160 may include a digitizer 460 for detecting an input (e.g., touch input or hovering input) of an electronic pen (e.g., stylus pen). For example, the digitizer 460 may convert analog coordinates (e.g., position) of an electronic pen (e.g., stylus pen) into digital coordinate data. The digitizer 460 may transfer digital coordinate data to the processor 120 and/or the DDIC 430.

According to an embodiment, the processor 120 may acquire digital coordinate data input from the digitizer 460. The processor 120 may detect an input (e.g., touch input or hovering input) through an electronic pen (e.g., stylus pen) based on digital coordinate data. For example, the digitizer 460 may include a plurality of x-axis channels and a plurality of y-axis channels. The processor 120 may sense a position of the electronic pen (e.g., stylus pen) using sensing signals (e.g., EMR signals) received from the x-axis channels and y-axis channels disposed in the digitizer 460. For example, a plurality of x-axis channels and a plurality of y-axis channels may be sequentially arranged in the digitizer 460, and the processor 120 may sense a position of the electronic pen (e.g., stylus pen) using sensing signals (e.g., EMR signals) received from three consecutive channels (e.g., three adjacent channels).

According to an embodiment, the digitizer 460 may be invisible from the outside by the display 410, electronic components, and device objects.

For example, the digitizer 460 may be disposed integrally with the flat display 410 or may be disposed adjacent to the flat display 410. For example, in the case that the digitizer 460 is applied to the flat display 410, the digitizer 460 may include one electro magnetic resonance (EMR) sheet (or EMR film). A plurality of x-axis channels and a plurality of y-axis channels for detecting a position of the electronic pen (e.g., stylus pen) may be disposed on one EMR sheet.

For example, the digitizer 460 may be disposed integrally with the flexible display or the foldable display or may be disposed adjacent to the flexible display or the foldable display. For example, the digitizer 460 may be disposed in a lower part (e.g., under) of the display 410 (e.g., the display 201 of FIGS. 2 and 3) in the z-axis direction (e.g., the z-axis direction of FIGS. 2A and 2B).

For example, in the case that the digitizer 460 is applied to the flexible display or the foldable display, the digitizer 460 may include a plurality of electro magnetic resonance (EMR) sheets (or EMR films). A plurality of x-axis channels and a plurality of y-axis channels for detecting a position of the electronic pen (e.g., stylus pen) may be disposed at the plurality of EMR sheets.

Although not shown in FIG. 4, the electronic device 400 includes a side key. The side key is described hereinbefore in relation to the key input device 219 of electronic device 200 of FIGS. 2A, 2B, 2C and 2D. Although not shown in FIG. 4, the electronic device 400 includes a plurality of vibration structures, as described hereinbefore in relation to the electronic device 200 of FIGS. 2A, 2B, 2C and 2D.

FIG. 5 is a block diagram showing components of an electronic device 500. The electronic device 500 includes a side key 520. The side key 520 (e.g., side button(s)) The side key 520 is described hereinbefore in relation to the key input device 219 of electronic device 200 of FIGS. 2A, 2B, 2C and 2D. The side key 520 is configured to provide a haptic function, i.e., is configured to vibrate.

With reference to FIG. 5, the electronic device 500 includes a side key 520, a plurality of vibration structures 530, a plurality of sensors 540, a vibration structure driving integrated circuit (IC) 550, a sensor driving IC 560, a processor 120 (e.g., the processor 120 of FIG. 1, the processor 120 of FIG. 4), and a memory 130 (e.g., the memory 130 of FIG. 1, the memory 130 of FIG. 4).

The side key 520 includes a plurality of key structures 521, 522, and 523 configured to allow a user key input. The first key structure 521 is for a user's first key input, the second key structure 522 is for a user's second key input, and the third key structure 523 is for a user's third key input.

According to an embodiment, the plurality of vibration structures 530 may be disposed inside a housing (e.g., the housings 210 and 220 of FIG. 2A, the housing 310 of FIG. 3A) to provide a vibration to the side key 520 (e.g., a plurality of side buttons). One of the plurality of vibration structures 530 may provide a vibration to one of the key structures. The plurality of vibration structures 530 may include a first vibration structure 531, a second vibration structure 532, and a third vibration structure 533. For example, the first vibration structure 531 may vibrate based on a first input vibration signal. The first vibration structure 531 may be disposed to contact at least a portion of the first key structure 521 to provide (e.g., transfer) a vibration to the first key structure 521. For example, the second vibration structure 532 may vibrate based on a second input vibration signal. The second vibration structure 532 may be disposed to contact at least a portion of the second key structure 522 to provide (e.g., transfer) a vibration to the second key structure 522. For example, the third vibration structure 533 may vibrate based on a third input vibration signal. The third vibration structure 533 may be disposed to contact at least a portion of the third key structure 523 to provide (e.g., transfer) a vibration to the third key structure 523. For example, each of the first vibration structure 531, the second vibration structure 532, and the third vibration structure 533 may include a piezo actuator, a haptic actuator, a vibration element, or a vibration plate.

In this way, a vibration is applied to the side key 520 (e.g., a plurality of side buttons) by the plurality of vibration structures 530; thus, the side key 520 (e.g., a plurality of side buttons) may provide a haptic function.

According to an embodiment, the plurality of sensors 540 may sense a user key input or a user interaction with the side key 520, e.g., a pressing or a touch of the side key 520. The plurality of sensors 540 may include a first sensor 541, a second sensor 542, and a third sensor 543. The first sensor 541 (e.g., pressure sensor, ultrasonic sensor, or touch sensor) may sense pressing or a touch of the first key structure 521. The second sensor 542 (e.g., pressure sensor, ultrasonic sensor, or touch sensor) may sense pressing or a touch of the second key structure 522. The third sensor 543 (e.g., pressure sensor, ultrasonic sensor, touch sensor) may sense pressing or a touch of the third key structure 523.

According to an embodiment, the vibration structure driving IC 550 may drive or control the plurality of vibration structures 530 based on the control of the processor 120.

According to an embodiment, the sensor driving IC 560 may drive or control the plurality of sensors 540 based on the control of the processor 120.

According to an embodiment, the memory 130 may include instructions for operating the processor 120, the vibration structure driving IC 550, and the sensor driving IC 560.

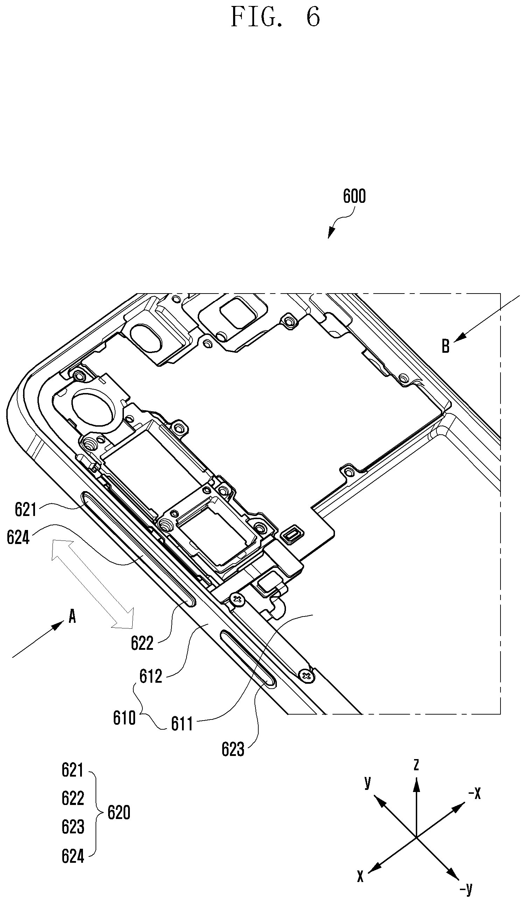

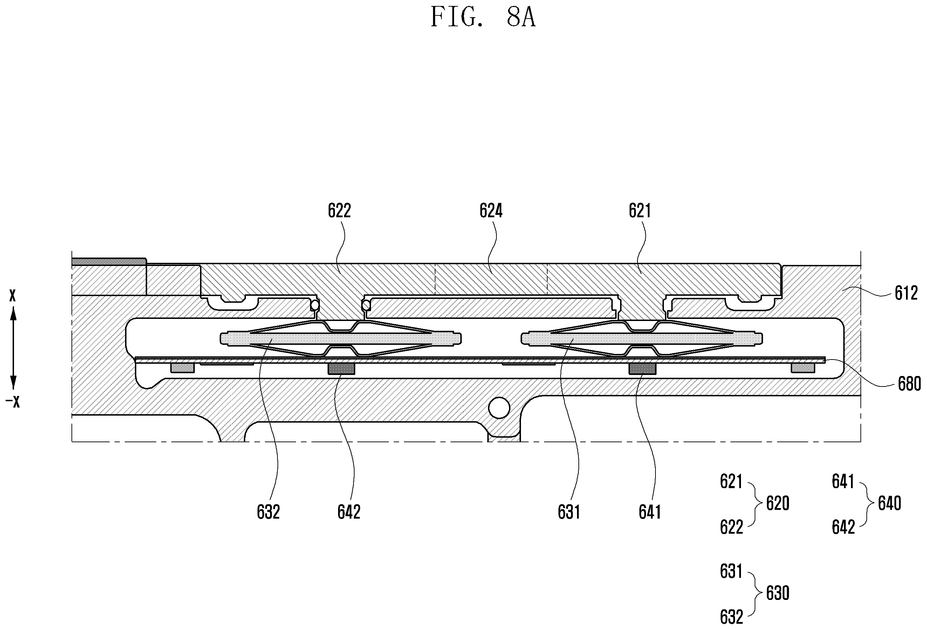

FIG. 6 is a diagram illustrating an electronic device 600 including a housing 610 and a side key 620. FIG. 7 is a diagram illustrating the side key 620 and a plurality of vibration structures 630. FIG. 8A is a cross-sectional view illustrating the side key 620, and the plurality of vibration structures 630 within the housing 610.

FIG. 6 is a diagram illustrating an electronic device including a housing (610) and a side key (620). FIG. 7 is a diagram illustrating the side key (620) and a plurality of vibration structures (630). FIG. 8a is a diagram illustrating a cross-sectional view of a plurality of vibration structures inside the side key (620) and the housing (610).

With reference to FIGS. 6 to 8A, an electronic device 600 (e.g., the electronic device 101 of FIG. 1, the electronic device 200 of FIG. 2A, the electronic device 300 of FIG. 3A, the electronic device 400 of FIG. 4, the electronic device 500 of FIG. 5) includes a housing 610 including a bottom surface 611 and a side surface 612 formed to enclose (e.g., surround) the bottom surface 611, and a side key 620 (e.g., the side key 520 of FIG. 5, a plurality of side buttons) that is configured to allow a user key input. A hole is formed in the side surface 612 (e.g., the side bezel structure 318 of FIG. 3A) of the housing 610 (e.g., the housings 210 and 220 of FIG. 2A, the housing 310 of FIG. 3A), so that an upper surface (e.g., pressing surface, touch surface, surface) of the side key 620 is exposed to the outside of the electronic device through the hole in the side surface 612 of the housing 610.

The side key 620 includes a plurality of key structures 621, 622, and 623 (e.g., the plurality of key structures 521, 522, and 523 of FIG. 5) configured to allow a user key input.

For example, FIG. 7 illustrates the first key structure 621, the second key structure 622, and the third key structure 623. The first key structure 621 is for a user's first key input, the second key structure 622 is for a user's second key input, and the third key structure 623 is for a user's third key input. As shown, the first key structure 621 and the second key structure 622 are connected through a connection part 624 to be disposed as one side key (e.g., side button). As shown, the third key structure 623 is disposed separately to the connected first and second key structures.

As shown in FIG. 7 on third key structure 623, a pattern 625 (e.g., concave and convex pattern, embossing pattern) is provided on the upper surface of a first part 623a of the third key structure 623. In this way, the user can distinguish the third key structure 623 from the first key structure 621 and the second key structure 622.

The electronic device 600 includes a plurality of vibration structures 630, including a first vibration structure 631, a second vibration structure 632, and a third vibration structure 633. These are described hereinbefore in relation to FIG. 5. For example, the plurality of vibration structures 630 may be disposed inside the side surface 612 of the housing 610 to provide (e.g., transfer) a vibration to the side key 620 (e.g., a plurality of side buttons). For example, the plurality of vibration structures 630 may include a first vibration structure 631, a second vibration structure 632, and a third vibration structure 633. For example, each of the first vibration structure 631, the second vibration structure 632, and the third vibration structure 633 may include a piezo actuator, a haptic actuator, a vibration element, or a vibration plate.

For example, FIG. 8A illustrates the first vibration structure 631 and the second vibration structure 632 among the first vibration structure 631, the second vibration structure 632, and the third vibration structure 633 constituting the plurality of vibration structures 630.

As shown in FIG. 7, the first vibration structure 631 is disposed to contact a portion of the first key structure 621 to provide (e.g., transfer) a vibration to the first key structure 621. For example, a first part 621a of the first key structure 621 may be exposed to the outside so that the user may press this part. A second part 621b connected to the first part 621a of the first key structure 621 may be disposed inside the housing 610. A lower end portion of the second part 621b of the first key structure 621 may have an inclined shape such that the end thereof is pointed. The lower end portion of the second part 621b of the first key structure 621 may be inserted (e.g., received) into a first groove 631a formed in the first vibration structure 631. The lower end portion of the second part 621b of the first key structure 621 is inserted (e.g., received) into the first groove 63 1a formed in the first vibration structure 631; in this way, the first key structure 621 is fixed over the first vibration structure 631.

A similar configuration can be applied to the second and third key structures, to fix them over the second and third vibration structures, respectively. In effect, in relation to the second key structure 622, a lower end of the second part 622b of the second key structure 622, can be inserted (e.g., received) into a second groove 632a formed in the second vibration structure 632. In effect, in relation to the third key structure 623, a lower end of the second part 623b of the third key structure 623, can be inserted (e.g., received) into a third groove 633a formed in the third vibration structure 633.

In this way, a vibration is applied to the side key 620 (e.g., a plurality of side buttons) by the plurality of vibration structures 630; thus, the side key 620 (e.g., a plurality of side buttons) may provide a haptic function.

According to an embodiment, the electronic device 600 may include a plurality of sensors 640 (e.g., the plurality of sensors 540 of FIG. 5) for sensing a user key input or a user interaction with the side key 520, e.g., a pressing (or touch) of the side key 620.

According to an embodiment, the plurality of sensors 640 and the plurality of vibration structures 630 may be disposed on a printed circuit board 680.

The plurality of sensors 640 may include a first sensor 641 (e.g., pressure sensor, ultrasonic sensor, touch sensor) for sensing pressing of the first key structure 621, and a second sensor 642 (e.g., pressure sensor, ultrasonic sensor, touch sensor) for sensing pressing of the second key structure 622. Although not illustrated in FIG. 8A, the plurality of sensors 640 may include a third sensor (not illustrated) (e.g., pressure sensor, ultrasonic sensor, touch sensor) for sensing pressing of the third key structure 623. For example, the first sensor 641 (e.g., pressure sensor, ultrasonic sensor, or touch sensor) may sense pressing or a touch of the first key structure 621. The second sensor 642 (e.g., pressure sensor, ultrasonic sensor, or touch sensor) may sense pressing or a touch of the second key structure 622. The third sensor (not illustrated) (e.g., pressure sensor, ultrasonic sensor, touch sensor) may sense pressing or a touch of the third key structure 623.

According to an embodiment, the electronic device 600 may include a vibration structure driving IC (e.g., the vibration structure driving IC 550 of FIG. 5) for operating the plurality of vibration structures 630.

According to an embodiment, the electronic device 600 may include a sensor driving IC (e.g., the sensor driving IC 560 of FIG. 5) for operating the plurality of sensors 540.

According to an embodiment, the electronic device 600 may include a processor (e.g., the processor 120 of FIG. 1, the processor 120 of FIG. 5) for controlling operations of the vibration structure driving IC 550 and the sensor driving IC 560.

According to an embodiment, the electronic device 600 may include a memory (e.g., the memory 130 of FIG. 1, the memory 130 of FIG. 5) operatively connected to the processor 120. For example, the memory 130 may include instructions for operating the processor 120, the vibration structure driving IC 550, and the sensor driving IC 560.

According to an embodiment, the vibration structure driving IC 550 may drive the plurality of vibration structures 630 based on the control of the processor 120.

According to an embodiment, the sensor driving IC 560 may drive the plurality of sensors 640 based on the control of the processor 120.

According to an embodiment, the memory 130 may include instructions for operating the processor 120, the vibration structure driving IC 550, and the sensor driving IC 560.

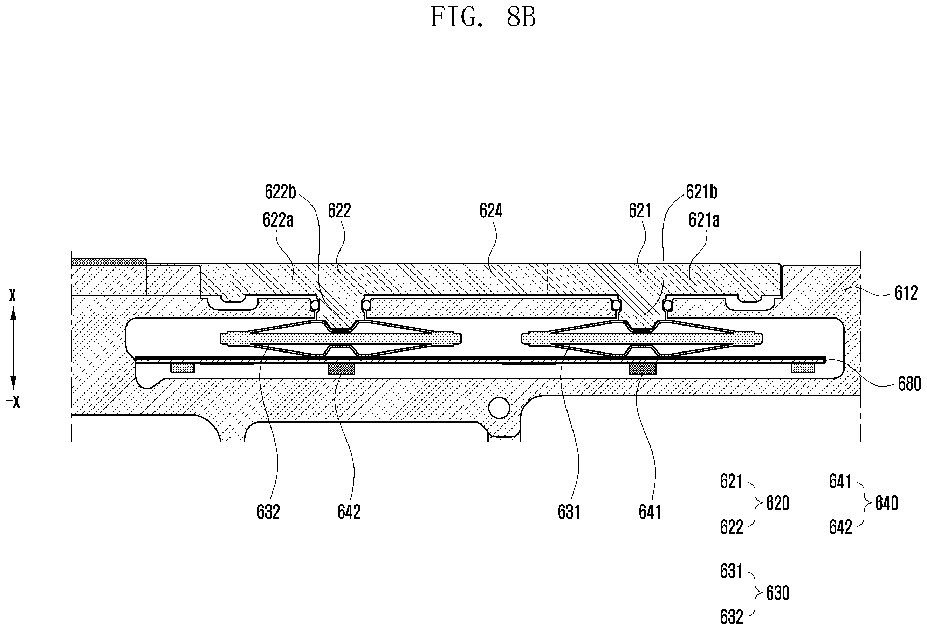

FIG. 8B is a cross-sectional view illustrating a side surface, a side key, and a plurality of vibration structures of the housing. When describing the plurality of vibration structures 630 of the side key 620 of FIG. 8B, a detailed description of the same (or similar) constitution as that of FIGS. 7 and 8A may be omitted.

FIG. 8C is a cross-sectional view illustrating a side surface, a side key, and a vibration structure of the housing. When describing the plurality of vibration structures 630 of the side key 620 of FIG. 8C, a detailed description of the same (or similar) constitution as that of FIG. 8A or 8B may be omitted.

With reference to FIGS. 6, 7, and 8C, an electronic device 600 according to an embodiment of the disclosure may include a housing 610 including a bottom surface 611 and a side surface 612 formed to enclose (e.g., surround) the bottom surface 611, and a side key 620 for a user key input. For example, a hole may be formed at the side surface 612 (e.g., the side bezel structure 318 of FIG. 3A) of the housing 610, and an upper surface (e.g., pressing surface, touch surface, surface) of the side key 620 may be exposed to the outside through the hole of the side surface 612 of the housing 610.

According to an embodiment, the side key 620 of the electronic device 600 according to an embodiment of the disclosure may include one complex key structure 650 (e.g., broad key structure) and one side structure (e.g., the third key structure 623 of FIG. 7).

For example, an upper surface (e.g., pressing surface, touch surface, surface) of one complex key structure 650 (e.g., broad key structure) and an upper surface (e.g., pressing surface, touch surface, surface) of one side structure 623 may be exposed to the outside through the hole formed at the side surface 612 of the housing 610.

For example, the upper surface (e.g., pressing surface, touch surface, surface) of one complex key structure 650 (e.g., broad key structure) may be exposed to the outside through a first hole formed at the side surface 612 of the housing 610.

For example, the upper surface (e.g., pressing surface, touch surface, surface) of one side structure 623 may be exposed to the outside through a second hole formed at the side surface 612 of the housing 610.

For example, the first key structure 621 and the second key structure 622 of FIG. 8A or 8B may be integrated to form one complex key structure 650 (e.g., broad key structure).

For example, the complex key structure 650 (e.g., broad key structure) may include a first part 651 and a second part 652. The first part 651 may include a first area 653 for receiving a first button input, and a second area 654 for receiving a second button input.

For example, one side structure 623 may be disposed to receive a third button input.

For example, the first area 653 of the complex key structure 650 (e.g., broad key structure) may be one first button (e.g., side key). For example, the second area 654 of the complex key structure 650 (e.g., broad key structure) may be one first button (e.g., side key).

For example, the first area 653 and the second area 654 of the first part 651 may be connected through a connection part 655 (e.g., central portion, the connection part 624 of FIG. 8A). When viewed from the outside, the first area 653, the connection part 655, and the second area 654 may be connected as one and viewed as a side button (e.g., side key) in the form of an elongate bar. The complex key structure 650 (e.g., broad key structure) and the third key structure 623 may be disposed separately (see FIG. 6).

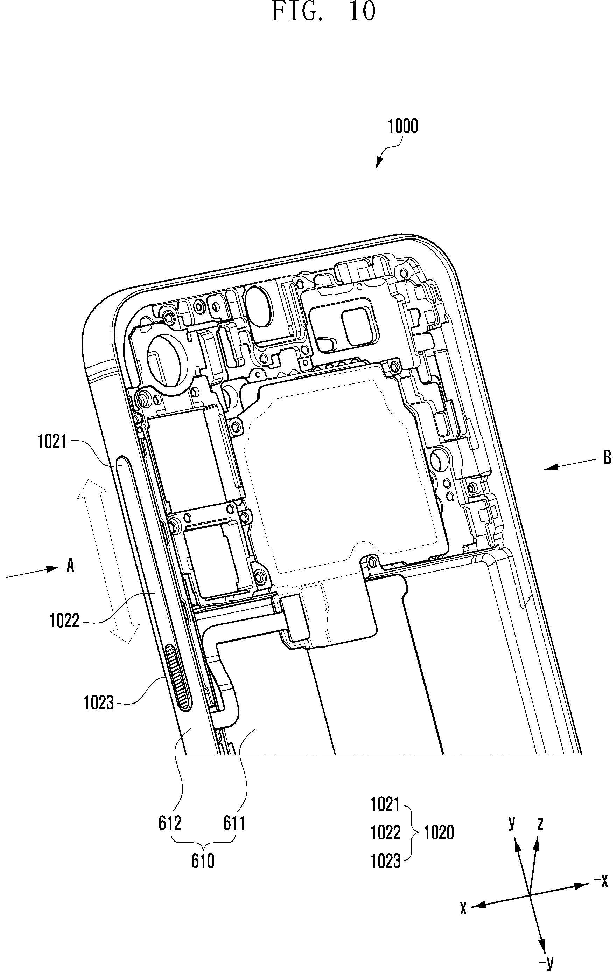

Although not illustrated in FIG. 8C, the complex key structure 650 (e.g., broad key structure) and the third key structure 623 may be disposed to be connected (see FIG. 10).

According to an embodiment, the electronic device 600 may include a plurality of vibration structures 630 (e.g., the plurality of vibration structures 530 of FIG. 5) for providing (e.g., transferring) a vibration to the side key 620. For example, the plurality of vibration structures 630 may be disposed inside the side surface 612 of the housing 610 to provide (e.g., transfer) a vibration to the side key 620 (e.g., a plurality of side buttons).

For example, the plurality of vibration structures 630 may include a first vibration structure 660 (e.g., complex vibration structure, broad vibration structure) that may provide (e.g., transfer) a vibration to the complex key structure 650 (e.g., broad key structure). For example, the first vibration structure 631 and the second vibration structure 632 of FIGS. 7 and 8B may be integrated to form one first vibration structure 660 (e.g., complex vibration structure, broad vibration structure)

Although not illustrated in FIG. 8C, the plurality of vibration structures 630 may include a second vibration structure (e.g., the third vibration structure 633 of FIG. 7) that may provide (e.g., transfer) a vibration to the side key structure 623. FIG. 8C illustrates a first vibration structure 660 (e.g., complex vibration structure or broad vibration structure) of a plurality of vibration structures.

For example, each of the first vibration structure 660 (e.g., complex vibration structure, broad vibration structure), and the second vibration structure (e.g., the third vibration structure 633 of FIG. 7) may include a piezo actuator, a haptic actuator, a vibration element, or a vibration plate.

For example, the complex key structure 650 (e.g., broad key structure) may include a first part 651 exposed to the outside and a second part 652 disposed to contact the first vibration structure 660 (e.g., complex vibration structure, broad vibration structure). The first part 651 and the second part 652 of the complex key structure 650 (e.g., broad key structure) may be connected, and at least a portion of the second part 652 may be disposed inside the side surface 612 of the housing 610.

For example, a lower end portion of the second part 652 of the complex key structure 650 (e.g., broad key structure) may have an inclined shape such that the end thereof is pointed. The lower end portion of the second part 652 may be inserted (e.g., received) into a groove (e.g., the first groove 631a of FIG. 7) formed in the first vibration structure 660 (e.g., complex vibration structure, broad vibration structure). The second part 652 of the complex key structure 650 (e.g., broad key structure) is inserted (e.g., received) into the groove (e.g., the groove 631a of FIG. 7) formed in the first vibration structure 660 (e.g., complex vibration structure, broad vibration structure); thus, the complex key structure 650 (e.g., broad key structure) may be fixed over the first vibration structure 660 (e.g., complex vibration structure, broad vibration structure).

A vibration is applied to the side key 620 (e.g., a plurality of side buttons) by the plurality of vibration structures 630; thus, the side key 620 (e.g., a plurality of side buttons) may provide a haptic function.

According to an embodiment, the electronic device 600 may include a plurality of sensors 640 (e.g., the plurality of sensors 540 of FIG. 5) for sensing pressing (or touch) of the side key 620.

According to an embodiment, the plurality of sensors 640 and the plurality of vibration structures 630 may be disposed on the printed circuit board 680.

For example, the plurality of sensors 640 may include a first sensor 641 (e.g., pressure sensor, ultrasonic sensor, touch sensor), a second sensor 642, and a third sensor 643 for sensing pressing of the complex key structure 650 (e.g., broad key structure). The first sensor 641 may be disposed to sense pressing of a first area 653 (e.g., pressing of a first button) of the complex key structure 650 (e.g., broad key structure). The second sensor 642 may be disposed to sense pressing of a second area 654 (e.g., pressing of a second button) of the complex key structure 650 (e.g., broad key structure). The third sensor 643 may be disposed to sense pressing of the connection part 655 (e.g., central part) of the complex key structure 650 (e.g., broad key structure).

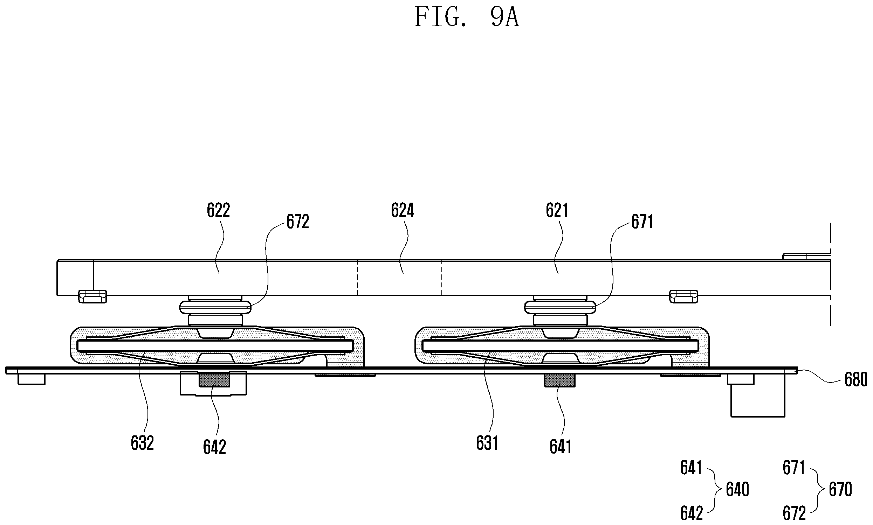

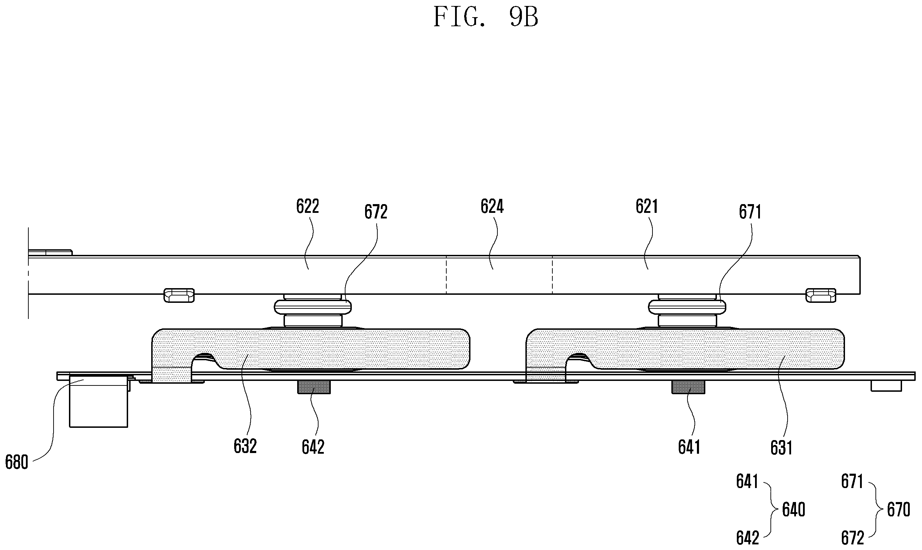

Although not illustrated in FIG. 8C, the plurality of sensors 640 may further include a sensor (not illustrated) (e.g., pressure sensor, ultrasonic sensor, touch sensor) for sensing pressing of the third key structure 623. FIG. 9A is a cross-sectional view illustrating a side surface of a housing in which a side key and a plurality of vibration structures are disposed when viewed in a direction A of FIG. 6. FIG. 9B is a cross-sectional view illustrating a side surface of a housing in which a side key and a plurality of vibration structures are disposed when viewed in a direction B of FIG. 6.

With reference to FIGS. 6, 9A, and 9B, the electronic device 600 may include a waterproof member 670 (e.g., waterproof ring) for preventing moisture from entering the housing 610 via the portion in which the side key 620 is disposed.

According to an embodiment, the waterproof member 670 (e.g., waterproof ring) may include a first waterproof member 671 (e.g., first waterproof ring) and a second waterproof member 672 (e.g., second waterproof ring). For example, the first waterproof member 671 (e.g., first waterproof ring) may be disposed to be fitted into the second part 621b of the first key structure 621. For example, the second waterproof member 672 (e.g., second waterproof ring) may be disposed to be fitted into the second part 622b of the second key structure 622. Although not illustrated in FIGS. 9A and 9B, the waterproof member 670 (e.g., waterproof ring) may include a third waterproof member (not illustrated) (e.g., third waterproof ring). The third waterproof member (not illustrated) (e.g., third waterproof ring) may be disposed to be fitted into the second part 623b of the third key structure 623.

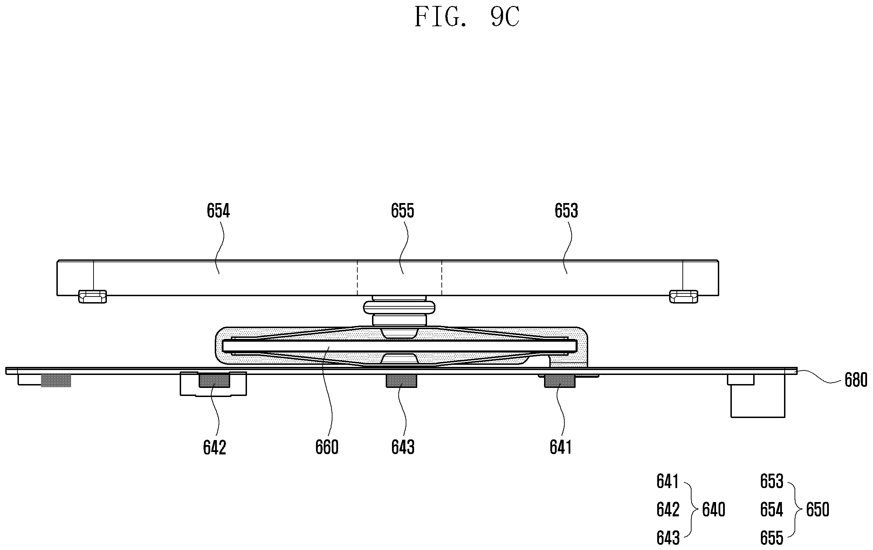

FIG. 9C is a cross-sectional view illustrating a side surface of a housing in which a side key and a vibration structure are disposed when viewed in a direction A of FIG. 6. When describing the side key 620 and the vibration structure 660 of FIG. 9C, a detailed description of the same (or similar) constitution as those of FIG. 8C may be omitted.

With reference to FIGS. 6, 7, and 9C, according to an embodiment, a first key structure 621 and a second key structure 622 of FIGS. 9A and 9B may be integrated to form one complex key structure 650 (e.g., broad key structure). For example, a first part 653 and a second part 654 of the complex key structure 650 (e.g., broad key structure) may be connected through a connection part 655 (e.g., the central portion, the connection part 624 of FIG. 8A) to be disposed as a side key (e.g., side button). For example, the first part 653 of the complex key structure 650 (e.g., broad key structure) may be a button (e.g., side key). For example, the second part 654 of the complex key structure 650 (e.g., broad key structure) may be a button (e.g., side key).

Although not illustrated in FIG. 9C, the complex key structure 650 (e.g., broad key structure) and a third key structure (e.g., the third key structure 623 of FIG. 7) may be disposed separately.

According to an embodiment, the electronic device 600 may include a plurality of vibration structures (e.g., the plurality of vibration structures 630 of FIG. 7, the plurality of vibration structures 530 of FIG. 5) for providing (e.g., transferring) a vibration to the side key 620. For example, the plurality of vibration structures 630 may be disposed inside a side surface 612 of the housing 610 to provide (e.g., transfer) a vibration to the side key 620 (e.g., a plurality of side buttons).

For example, the plurality of vibration structures 630 may include a first vibration structure 660 (e.g., complex vibration structure, broad vibration structure) that may provide (e.g., transfer) a vibration to a complex key structure 650 (e.g., broad key structure). For example, the first vibration structure 631 and the second vibration structure 632 of FIGS. 7 and 9A may be integrated to form one first vibration structure 660 (e.g., complex vibration structure, broad vibration structure)

Although not illustrated in FIG. 9C, the plurality of vibration structures 630 may include a third vibration structure (e.g., the third vibration structure 633 of FIG. 7) that may provide (e.g., transfer) a vibration to the third key structure 623. FIG. 9C illustrates the first vibration structure 660 (e.g., complex vibration structure, broad vibration structure) among the first vibration structure 660 (e.g., complex vibration structure, broad vibration structure) and the third vibration structure 633 constituting the plurality of vibration structures 630.

For example, each of the first vibration structure 660 (e.g., complex vibration structure, broad vibration structure), and the third vibration structure (e.g., the third vibration structure 633 of FIG. 7) may include a piezo actuator, a haptic actuator, a vibration element, or a vibration plate.

A vibration is applied to the side key 620 (e.g., a plurality of side buttons) by the plurality of vibration structures 630; thus, the side key 620 (e.g., a plurality of side buttons) may provide a haptic function.

According to an embodiment, the electronic device 600 may include a plurality of sensors 640 (e.g., the plurality of sensors 540 of FIG. 5) for sensing pressing (or touch) of the side key 620.

According to an embodiment, the plurality of sensors 640 and the plurality of vibration structures 630 may be disposed on a printed circuit board 680.

For example, the plurality of sensors 640 may include a first sensor 641 (e.g., pressure sensor, ultrasonic sensor, touch sensor), a second sensor 642, and a third sensor 643 for sensing pressing of the complex key structure 650 (e.g., broad key structure). The first sensor 641 may be disposed to sense pressing of a first part 653 of the complex key structure 650 (e.g., broad key structure). The second sensor 642 may be disposed to sense pressing of a second part 654 of the complex key structure 650 (e.g., broad key structure). The third sensor 643 may be disposed to sense pressing of a connection part 655 (e.g., central part) of the complex key structure 650 (e.g., broad key structure).

Although not illustrated in FIG. 9C, the plurality of sensors 640 may further include a sensor (not illustrated) (e.g., pressure sensor, ultrasonic sensor, touch sensor) for sensing pressing of the third key structure 623.

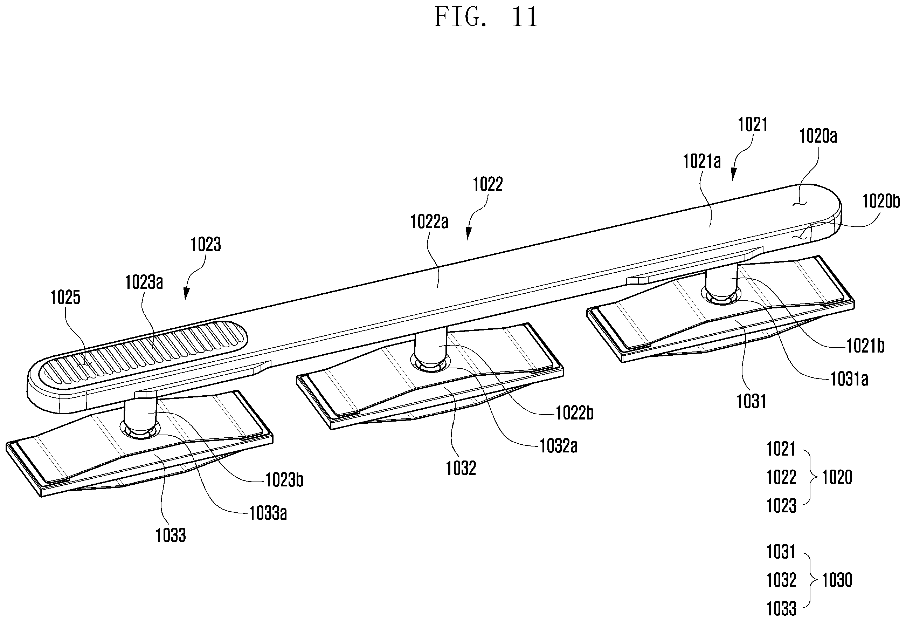

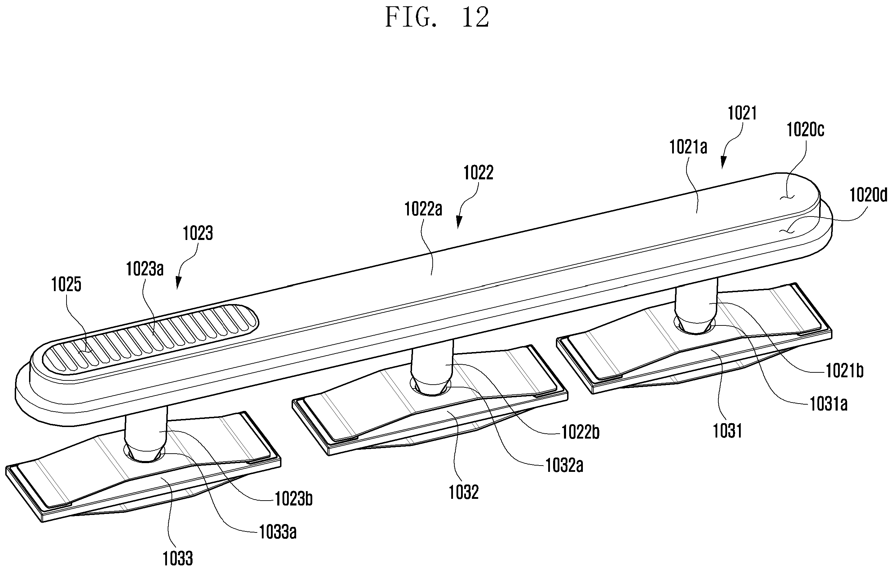

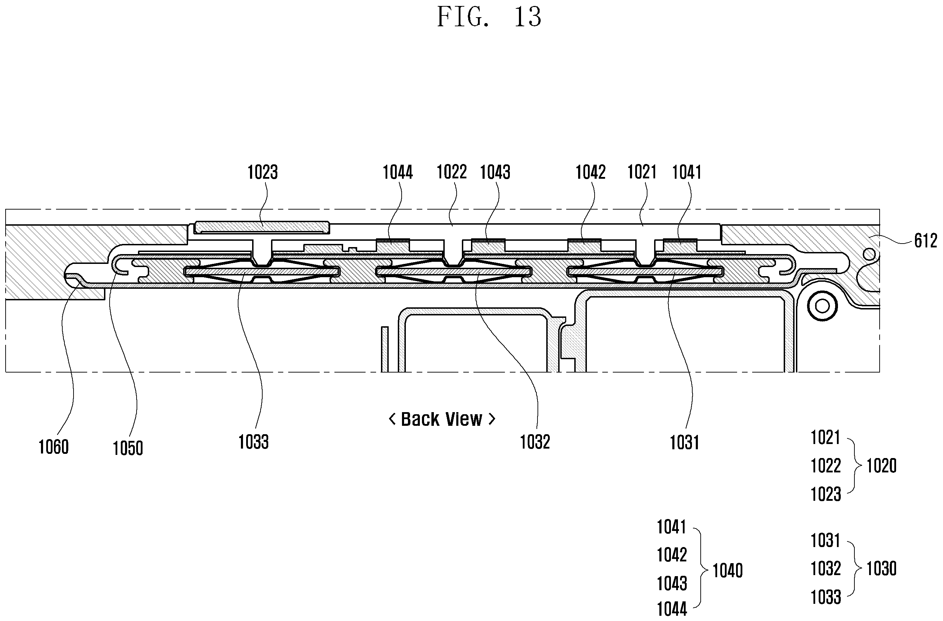

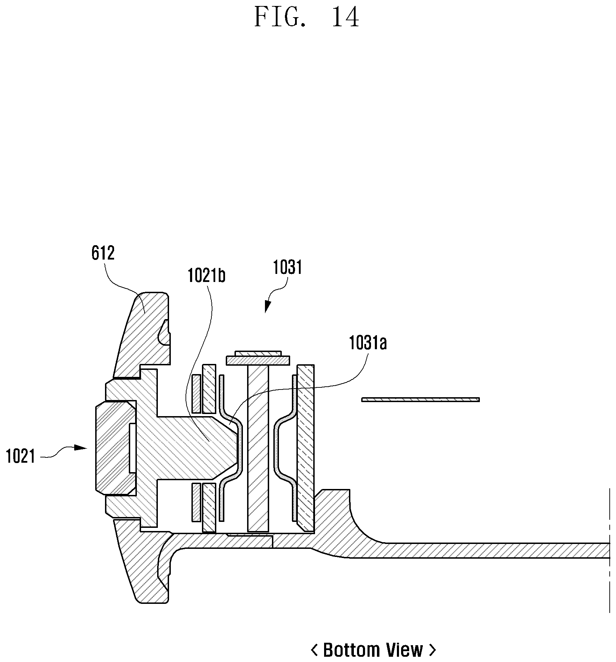

FIG. 10 is a diagram illustrating an electronic device 1000 including a housing 610 and a side key 1020. FIG. 11 is a diagram illustrating the side key 1020 and a plurality of vibration structures 1030. FIG. 12 is a diagram illustrating an alternative configuration of the side key 1020 and a plurality of vibration structures 1030. FIG. 13 is a cross-sectional view illustrating the side key 1020, and the plurality of vibration structures 1030 within the housing 610. FIG. 14 is a cross-sectional view illustrating the side key 1020 and the plurality of vibration structures 1030 within the housing 610 when viewed in a direction A of FIG. 10.

With reference to FIGS. 10 to 14, an electronic device 1000 (e.g., the electronic device 101 of FIG. 1, the electronic device 200 of FIG. 2A, the electronic device 300 of FIG. 3A, the electronic device 400 of FIG. 4, the electronic device 500 of FIG. 5) includes a housing 610 including a bottom surface 611 and a side surface 612 formed to enclose (e.g., surround) the bottom surface 611 and a side key 1020 (e.g., the side key 520 of FIG. 5, a plurality of side buttons) that is configured to allow a user key input. A hole is formed in the side surface 612 (e.g., the side bezel structure 318 of FIG. 3A) of the housing 610, so that an upper surface (e.g., pressing surface, touch surface, surface) of the side key 1020 is exposed to the outside of the electronic device through the hole in the side surface 612 of the housing 610.

For example, the side key 1020 may include a plurality of key structures 1021, 1022, and 1023 (e.g., the plurality of key structures 521, 522, and 523 of FIG. 5) for a user key input. For example, the side key 1020 may include may include a first key structure 1021 for a user's first key input, a second key structure 1022 for a user's second key input, and a third key structure 1023 for a user's third key input. For example, the first key structure 1021, the second key structure 1022, and the third key structure 1023 may be connected to form one side key (e.g., side button).

A pattern 1025 (e.g., concave and convex pattern, embossing pattern) is formed at an upper surface of a first part 1023a of the third key structure 1023 so as to distinguish the third key structure 1023 from the first key structure 1021 and the second key structure 1022.

According to an embodiment, the electronic device 1000 may include a plurality of vibration structures 1030 (e.g., the plurality of vibration structures 530 of FIG. 5) for providing (e.g., transferring) a vibration to the side key 1020. For example, the plurality of vibration structures 1030 may be disposed inside the side surface 612 of the housing 610 to provide (e.g., transfer) a vibration to the side key 1020 (e.g., a plurality of side buttons). For example, the plurality of vibration structures 1030 may include a first vibration structure 1031, a second vibration structure 1032, and a third vibration structure 1033. For example, each of the first vibration structure 1031, the second vibration structure 1032, and the third vibration structure 1033 may include a piezo actuator, a haptic actuator, a vibration element, or a vibration plate.

As shown in FIGS. 11 and 12, the first vibration structure 1031 is disposed to contact a portion of the first key structure 1021 to provide (e.g., transfer) a vibration to the first key structure 1021. For example, a first part 1021a of the first key structure 1021 may be exposed to the outside so that the user may press this part. A portion of a second part 1021b connected to the first part 1021a of the first key structure 1021 may be disposed inside the housing 610. A lower end portion of the second part 1021b of the first key structure 1021 may have an inclined shape such that the end thereof is pointed. The lower end portion of the second part 1021b of the first key structure 1021 may be inserted (e.g., received) into a first groove 1031a formed in the first vibration structure 1031. The lower end portion of the second part 1021b of the first key structure 1021 is inserted (e.g., received) into the first groove 1031a formed in the first vibration structure 1031; in this way, the first key structure 1021 is fixed over the first vibration structure 1031.

A similar configuration can be applied to the second and third key structures, to fix them over the second and third vibration structures, respectively. In effect, in relation to the second key structure 1022, a lower end of the second part 1022b of the second key structure 1022, can be inserted (e.g., received) into a second groove 1032a formed in the second vibration structure 1032. In effect, in relation to the third key structure 1023, a lower end of the second part 1023b of the third key structure 1023, can be inserted (e.g., received) into a third groove 1033a formed in the third vibration structure 1033.

A vibration is applied to the side key 1020 (e.g., a plurality of side buttons) by the plurality of vibration structures 1030; thus, the side key 1020 (e.g., a plurality of side buttons) may provide a haptic function.

According to an embodiment, the electronic device 1000 may include a plurality of sensors 1040 (e.g., the plurality of sensors 540 of FIG. 5) for sensing pressing (or touch) of the side key 1020. For example, as shown in FIG. 13, the plurality of sensors 1040 includes a first sensor 1041 (e.g., pressure sensor, ultrasonic sensor, touch sensor), a second sensor 1042 (e.g., pressure sensor, ultrasonic sensor, touch sensor), a third sensor 1043 (e.g., pressure sensor, ultrasonic sensor, touch sensor), and a fourth sensor 1044 (e.g., pressure sensor, ultrasonic sensor, touch sensor).

For example, the first sensor 1041 (e.g., pressure sensor, ultrasonic sensor, touch sensor) and the second sensor 1042 (e.g., pressure sensor, ultrasonic sensor, touch sensor) may be disposed to sense a touch or pressing of the first key structure 1021, and they may be disposed around the first key structure 1021.

For example, the third sensor 1032 (e.g., pressure sensor, ultrasonic sensor, touch sensor) and the fourth sensor 1044 (e.g., pressure sensor, ultrasonic sensor, touch sensor) may be disposed to sense a touch or pressing of the second key structure 1022, and they may be disposed around the third key structure 1023.

According to an embodiment, the electronic device 1000 may include a fixing plate 1050 for fixing the first key structure 1021, the second key structure 1022, and the third key structure 1023 of the side key 1020 in position.

According to an embodiment, the electronic device 1000 may include a support plate 1060 for supporting the plurality of vibration structures 1030.

As illustrated in FIG. 11, an upper surface portion 1020a and a body portion 2020b of the side key 1020 may be produced separately, and then the upper surface portion 1020a and the body portion 2020b may be bonded.

As illustrated in FIG. 12, the upper surface portion 1020c and the body portion 2020d of the side key 1020 may be integrally formed.

According to an embodiment, the electronic device 1000 may include a vibration structure driving IC (e.g., the vibration structure driving IC 550 of FIG. 5) for operating the plurality of vibration structures 1030.

According to an embodiment, the electronic device 1000 may include a sensor driving IC (e.g., the sensor driving IC 560 of FIG. 5) for operating the plurality of sensors 1040.

According to an embodiment, the electronic device 1000 may include a processor (e.g., the processor 120 of FIG. 1, the processor 120 of FIG. 5) for controlling operations of the vibrating structure driving IC 550 and the sensor driving IC 560.

According to an embodiment, the electronic device 1000 may include a memory (e.g., the memory 130 of FIG. 1, the memory 130 of FIG. 5) operatively connected to the processor 120. For example, the memory 130 may include instructions for operating the processor 120, the vibration structure driving IC 550, and the sensor driving IC 560.

According to an embodiment, the vibration structure driving IC 550 may drive the plurality of vibration structures 1030 based on the control of the processor 120.

According to an embodiment, the sensor driving IC 560 may drive the plurality of sensors 1040 based on the control of the processor 120.

According to an embodiment, the memory 130 may include instructions for operating the processor 120, the vibration structure driving IC 550, and the sensor driving IC 560.

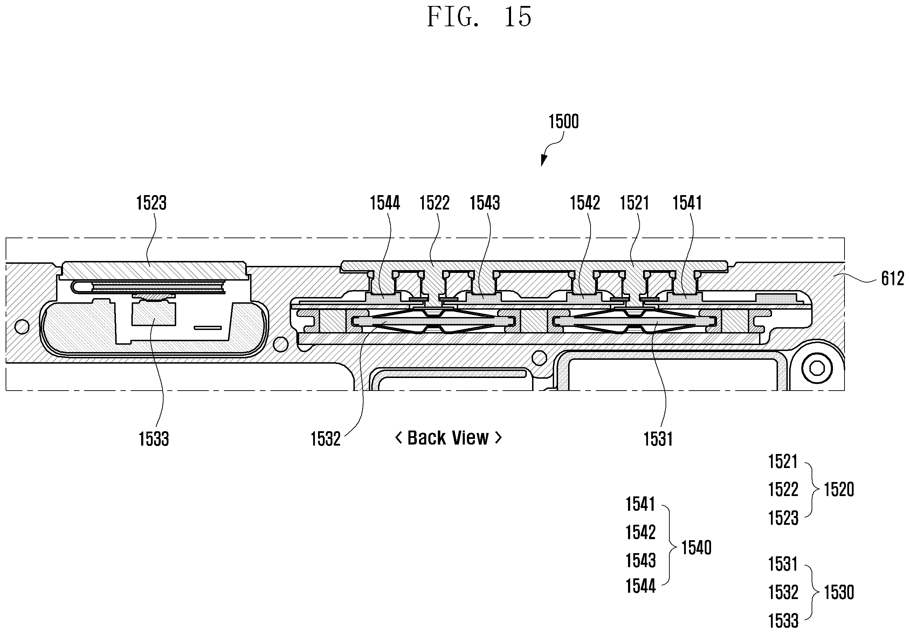

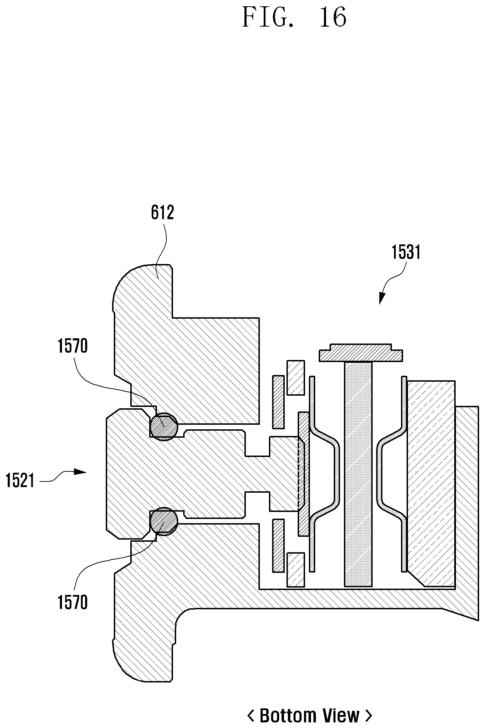

FIG. 15 is a cross-sectional view illustrating a side key 1520, a plurality of vibration structures 1530, and a plurality of sensors 1540 of an electronic device 1500. FIG. 16 is a diagram a key structure of a side key and a vibration structure.

With reference to FIGS. 15 and 16, an electronic device 1500 (e.g., the electronic device 101 of FIG. 1, the electronic device 200 of FIG. 2A, the electronic device 300 of FIG. 3A, the electronic device 400 of FIG. 4, the electronic device 500 of FIG. 5) may include a housing (e.g., the housing 610 of FIG. 10) including a bottom surface (e.g., the bottom surface 611 of FIG. 10) and a side surface (e.g., the side surface 612 of FIG. 10) formed to enclose (e.g., surround) the bottom surface 611, and a side key 1520 (e.g., the side key 520 of FIG. 5, a plurality of side buttons) that is configured to allow a user key input. A hole is formed in the side surface 612 of the housing 610, so that an upper surface (e.g., pressing surface, touch surface, surface) of the side key 1520 is exposed to the outside of the electronic device through the hole in the side surface 612 of the housing 610.

For example, the side key 1020 may include a first key structure 1521 for a user's first key input, a second key structure 1522 for a user's second key input, and a third key structure 1523 for a user's third key input.

A concave and convex pattern (e.g., embossing pattern) may be formed at an upper surface of the third key structure 1523. In this way, the user can distinguish the third key structure 1523 from the first key structure 1521 and the second key structure 1522.

According to an embodiment, the electronic device 1500 may include a plurality of vibration structures 1530 (e.g., the plurality of vibration structures 530 of FIG. 5) for providing (e.g., transferring) a vibration to the side key 1520. For example, the plurality of vibration structures 1530 may be disposed inside the side surface 612 of the housing 610 to provide (e.g., transfer) a vibration to the side key 1520 (e.g., a plurality of side buttons). For example, the plurality of vibration structures 1530 may include a first vibration structure 1531, a second vibration structure 1532, and a third vibration structure 1533. For example, each of the first vibration structure 1531, the second vibration structure 1532, and the third vibration structure 1533 may include a piezo actuator, a haptic actuator, a vibration element, or a vibration plate.

According to an embodiment, the first vibration structure 1531 may be disposed to contact at least a portion of the first key structure 1521 to provide (e.g., transfer) a vibration to the first key structure 1521.

According to an embodiment, the second vibration structure 1532 may be disposed to contact at least a portion of the second key structure 1522 to provide (e.g., transfer) a vibration to the second key structure 1522.

According to an embodiment, the third vibration structure 1533 may be disposed to contact at least a portion of the third key structure 1523 to provide (e.g., transfer) a vibration to the third key structure 1523.

A vibration is applied to the side key 1520 (e.g., a plurality of side buttons) by the plurality of vibration structures 1530; thus, the side key 1520 (e.g., a plurality of side buttons) may provide a haptic function.

According to an embodiment, the electronic device 1500 may include a plurality of sensors 1540 (e.g., the plurality of sensors 540 of FIG. 5) for sensing pressing (or touch) of the side key 1520. For example, the plurality of sensors 1540 may include a first sensor 1541 (e.g., pressure sensor, ultrasonic sensor, touch sensor), a second sensor 1542 (e.g., pressure sensor, ultrasonic sensor, touch sensor), a third sensor 1543 (e.g., pressure sensor, ultrasonic sensor, and touch sensor), and a fourth sensor 1544 (e.g., pressure sensor, ultrasonic sensor, and touch sensor).

For example, the first sensor 1541 (e.g., pressure sensor, ultrasonic sensor, touch sensor) and the second sensor 1542 (e.g., pressure sensor, ultrasonic sensor, touch sensor) may be disposed to sense a touch or pressing of the first key structure 1521. The first sensor 1541 (e.g., pressure sensor, ultrasonic sensor, touch sensor) and the second sensor 1542 (e.g., pressure sensor, ultrasonic sensor, touch sensor) may be disposed around the first key structure 1521.

For example, the second sensor 1542 (e.g., pressure sensor, ultrasonic sensor, touch sensor) and the third sensor 1543 (e.g., pressure sensor, ultrasonic sensor, touch sensor) may be disposed to sense a touch or pressing of the second key structure 1522. The second sensor 1542 (e.g., pressure sensor, ultrasonic sensor, touch sensor) and the third sensor 1543 (e.g., pressure sensor, ultrasonic sensor, touch sensor) may be disposed around the second key structure 1522.

For example, the third sensor 1032 (e.g., pressure sensor, ultrasonic sensor, touch sensor) and the fourth sensor 1544 (e.g., pressure sensor, ultrasonic sensor, touch sensor) may be disposed to sense a touch or pressing of the third key structure 1523. The third sensor 1032 (e.g., pressure sensor, ultrasonic sensor, touch sensor) and the fourth sensor 1544 (e.g., pressure sensor, ultrasonic sensor, touch sensor) may be disposed around the third key structure 1523.

According to an embodiment, the electronic device 1500 may include a vibration structure driving IC (e.g., the vibration structure driving IC 550 of FIG. 5) for operating the plurality of vibration structures 1530.

According to an embodiment, the electronic device 1500 may include a sensor driving IC (e.g., the sensor driving IC 560 of FIG. 5) for operating the plurality of sensors 1540.

According to an embodiment, the electronic device 1500 may include a processor (e.g., the processor 120 of FIG. 1, the processor 120 of FIG. 5) for controlling operations of the vibrating structure driving IC 550 and the sensor driving IC 560.

According to an embodiment, the electronic device 1500 may include a memory (e.g., the memory 130 of FIG. 1, the memory 130 of FIG. 5) operatively connected to the processor 120. For example, the memory 130 may include instructions for operating the processor 120, the vibration structure driving IC 550, and the sensor driving IC 560.

According to an embodiment, the vibration structure driving IC 550 may drive the plurality of vibration structures 1530 based on the control of the processor 120.

According to an embodiment, the sensor driving IC 560 may drive the plurality of sensors 1540 based on the control of the processor 120.

According to an embodiment, the memory 130 may include instructions for operating the processor 120, the vibration structure driving IC 550, and the sensor driving IC 560.

As shown in FIG. 16, the electronic device 1500 includes a waterproof member 1570 (e.g., waterproof ring) for waterproofing, i.e., preventing moisture from entering, a portion in which the side key 1520 is disposed.

According to an embodiment, the waterproof member 1570 (e.g., waterproof ring) may be disposed to be fitted into at least a portion of the first key structure 1521. Although not illustrated in the drawing, the waterproof member 1570 (e.g., waterproof ring) may be disposed to be fitted into at least a portion of the second key structure 1522. The waterproof member 1570 (e.g., waterproof ring) may be disposed to be fitted into at least a portion of the third key structure 1523.

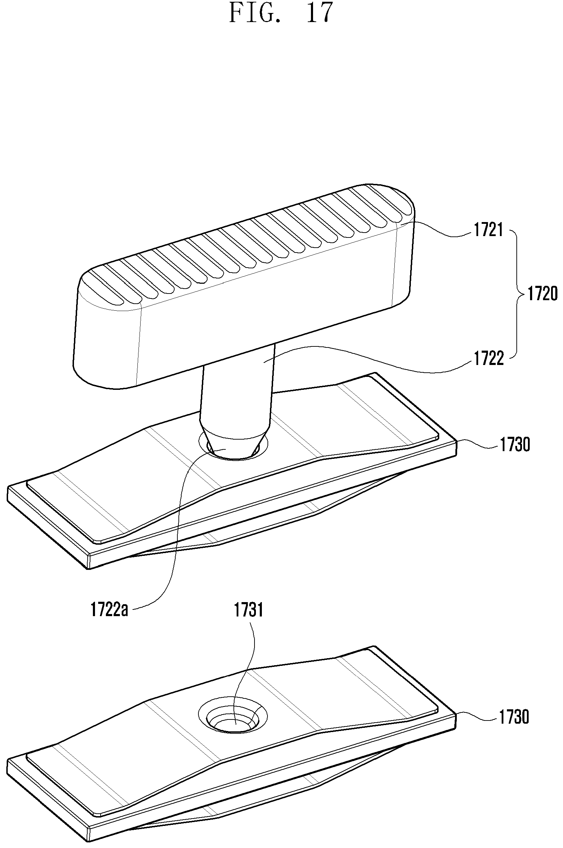

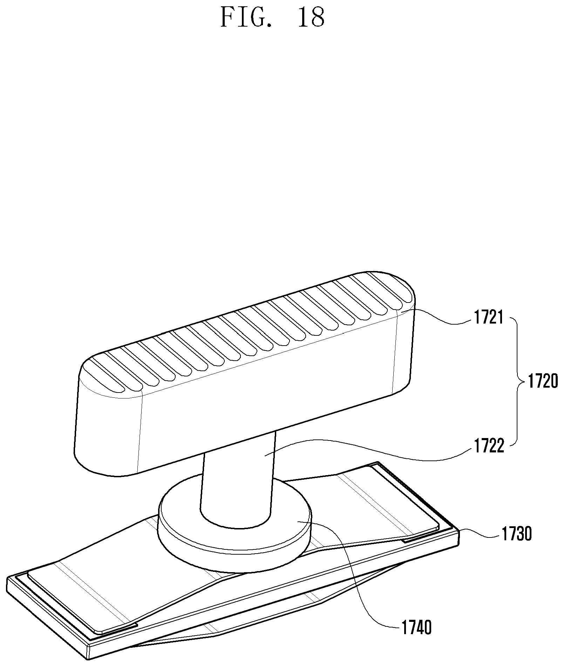

FIG. 17 is a diagram illustrating a key structure and a vibration structure. FIG. 18 is a diagram illustrating a key structure and a vibration structure.

With reference to FIGS. 17 and 18, a vibration structure 1730 may be disposed to contact at least a portion of a key structure 1720 to provide (e.g., transfer) a vibration to the key structure 1720. For example, a first part 1721 of the key structure 1720 may be exposed to the outside so that the user may press a key. At least a portion of a second part 1722 connected to the first part 1721 of the key structure 1720 may be disposed inside the side surface (e.g., the side surface 612 of FIG. 10) of the housing (e.g., the housing 610 of FIG. 10). A lower end portion 1722a of the second part 1722 of the key structure 1720 may have an inclined shape such that the end thereof is pointed. For example, a groove 1731 may be formed at an upper part (e.g., upper surface) of the vibrating structure 1730. The lower end portion 1722a of the second part 1722 of the key structure 1720 may be inserted (e.g., received) into a groove 1731 formed in the vibration structure 1730. The lower end portion 1722a of the second part 1722 of the key structure 1720 is inserted (e.g., received) into the groove 1731 formed in the vibration structure 1730; thus, the key structure 1720 may be fixed, i.e., secured, over the vibration structure 1730.

For example, when a vibration is applied to the key structure 1720 by the vibration structure 1730; the side key also vibrates to provide a haptic function. The larger an area of contact between the vibration structure 1730 and the lower end portion 1722a of the second part 1722 of the key structure 1720, the more effectively a vibration generated in the vibration structure 1730 may be transferred to the key structure 1720. When the lower end portion 1722a of the second part 1722 of the key structure 1720 is inserted into the groove 1731 formed in the vibrating structure 1730 in a semi-fixed(e.g., partial movement is allowed) form, the area of contact is increased.

For example, when the user presses the side key, a force may be applied to move the vibrating structure 1730 in a vertical direction and a side direction. When the lower end portion 1722a of the second part 1722 of the key structure 1720 is inserted into the groove 1731 formed in the vibrating structure 1730 in a semi-fixed(e.g., partial movement is allowed) form, the key structure 1720 is semi-fixed (e.g., partial movement is allowed) by the groove 1731 formed in the vibrating structure 1730; in this way, the key structure 1720 is prevented from deviating significantly from a determined position.

According to one embodiment, a contact extension member (1740) (e.g., a contact extension structure, a contact extension ring) may be disposed on the second portion (1722) of the key structure (1720).

For example, the contact extension member (1740) (e.g., a contact extension structure, a contact extension ring) may be arranged in a fitted manner within the second portion (1722) of the key structure (1720).

For example, the contact extension member (1740) (e.g., a contact extension structure, a contact extension ring) may be positioned to be in contact with the upper surface (e.g., top) of the vibration structure (1730).

The contact extension member (1740) (e.g., a contact extension structure, a contact extension ring) is arranged to be in contact with the vibration structure (1730), thereby expanding the contact area between the key structure (1720) and the vibration structure (1730). Due to the contact extension member (1740) (e.g., a contact extension structure, a contact extension ring), vibrations generated by the vibration structure (1730) can be transmitted to the key structure (1720) more effectively.

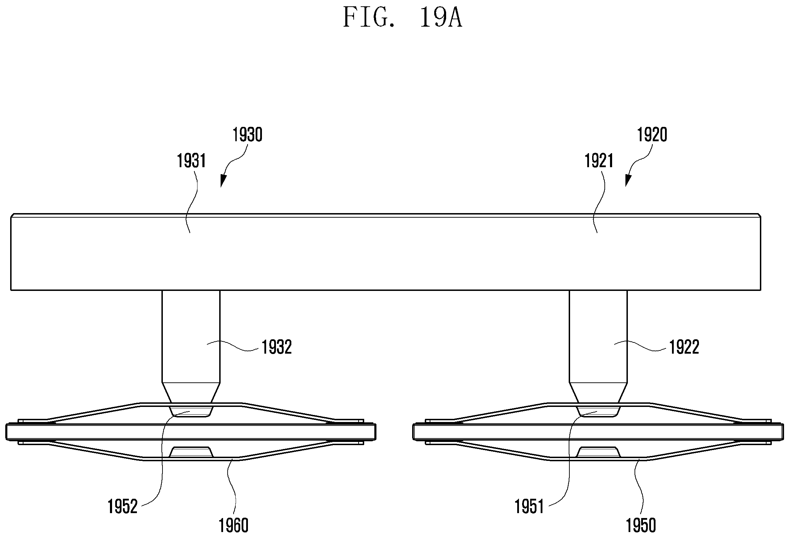

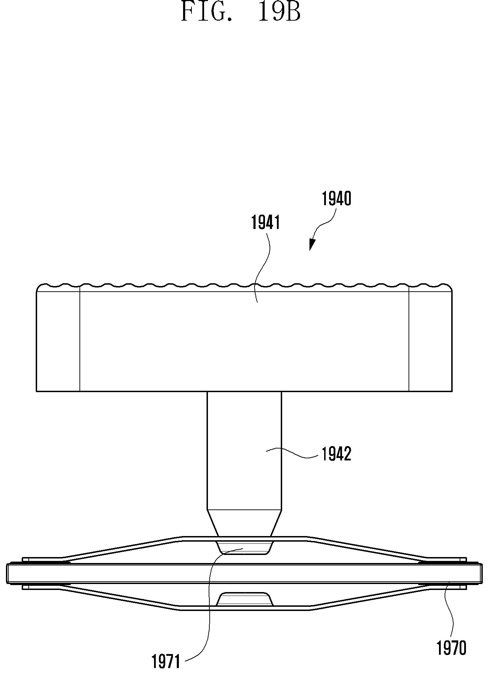

FIGS. 19A and 19B are diagrams illustrating a side key and a plurality of vibration structures disposed to contact each other.

With reference to FIGS. 19A and 19B, a side key (e.g., the side key 1020 of FIG. 10) may include a first key structure 1920, a second key structure 1930, and a third key structure 1940. A plurality of vibration structures 1950, 1960, and 1970 may include a first vibration structure 1950, a second vibration structure 1960, and a third vibration structure 1970.

According to an embodiment, the first key structure 1920 may include a first part 1921 disposed to be exposed to the outside of the housing (e.g., the housing 610 of FIG. 10) and a second part 1922 connected to the first part 1921 and having at least a portion disposed inside the housing 610. For example, an end portion of the second part 1922 of the first key structure 1920 may be inserted into a groove 1951 formed in the first vibration structure 1950. A contact point is formed between the second part 1922 of the first key structure 1920 and the first vibration structure 1950; thus, a vibration generated by the first vibration structure 1950 can be transferred to the first key structure 1920.

According to an embodiment, the second key structure 1930 may include a first part 1931 disposed to be exposed to the outside of the housing (e.g., the housing 610 of FIG. 10) and a second part 1932 connected to the first part 1931 and having at least a portion disposed inside the housing 610. For example, an end portion of the second part 1932 of the second key structure 1930 may be inserted into a groove 1961 formed in the second vibration structure 1960. A contact point is formed between the second part 1932 of the second key structure 1930 and the second vibration structure 1960; thus, a vibration generated by the second vibration structure 1960 can be transferred to the second key structure 1930.

According to an embodiment, the first key structure 1920 and the second key structure 1930, and the third key structure 1940 may be disposed at a predetermined interval to be separated from each other. The third key structure 1940 may include a first part 1941 disposed to be exposed to the outside of the housing (e.g., the housing 610 of FIG. 10) and a second part 1942 connected to the first part 1941 and having at least a portion disposed inside the housing 610. For example, an end portion of the second part 1942 of the third key structure 1940 may be inserted into a groove 1971 formed in the third vibration structure 1970. A contact point is formed between the second part 1942 of the third key structure 1940 and the third vibration structure 1970; thus, a vibration generated by the third vibration structure 1970 can be transferred to the third key structure 1940.

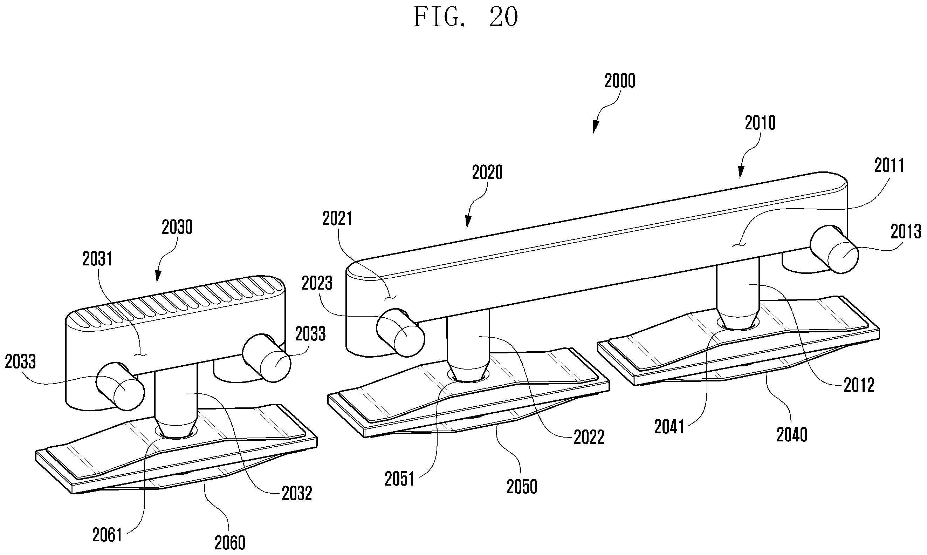

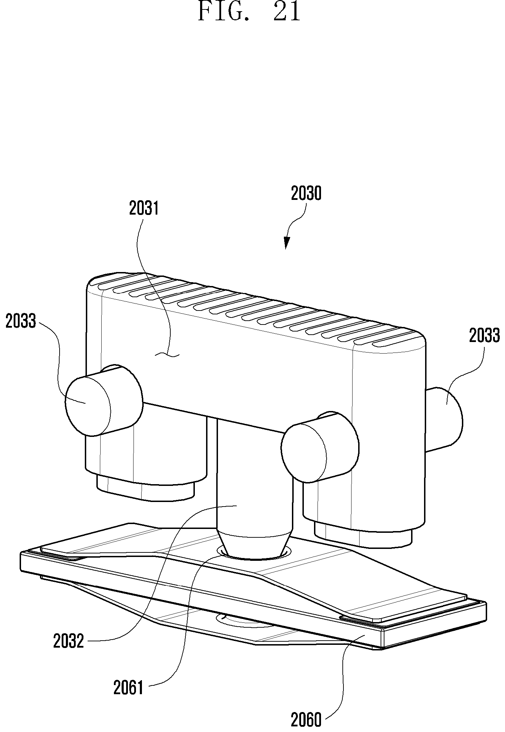

FIGS. 20 and 21 are diagrams illustrating a key structure and a vibration structure.

With reference to FIGS. 20 and 21, an electronic device (e.g., the electronic device 101 of FIG. 1, the electronic device 200 of FIG. 2A, the electronic device 300 of FIG. 3A, the electronic device 400 of FIG. 4, the electronic device 500 of FIG. 5, and the electronic device 600 of FIG. 6) according to an embodiment of the disclosure may include a side key 2000 (e.g., the side key 520 of FIG. 5, the side key 620 of FIG. 6) for a user key input, and a plurality of vibration structures 2040, 2050, and 2060 (e.g., the plurality of vibration structures 630 of FIG. 7).

According to an embodiment, a hole may be formed at the side surface (e.g., the side surface 612 of FIG. 6) of the housing (e.g., the housing 610 of FIG. 6), and an upper surface (e.g., pressing surface, touch surface, surface) of the side key 2000 may be exposed to the outside through the hole of the side surface 612 of the housing 610.

For example, the side key 2000 may include a plurality of key structures 2010, 2020, and 2030 (e.g., the plurality of key structures 521, 522, and 523 of FIG. 5, the plurality of key structures 621, 622, and 623 of FIG. 6) for a user key input. For example, the plurality of key structures 2010, 2020, and 2030 may include a first key structure 2010 for a user's first key input, a second key structure 2020 for a user's second key input, and a third key structure 2030 for a user's third key input. For example, the first key structure 2010 and the second key structure 2020 may be connected to be disposed as one side key (e.g., side button). For example, the third key structure 2030, and the first key structure 2010 and the second key structure 2020 may be disposed to be separated at a predetermined interval.

For example, a concave and convex pattern (e.g., embossing pattern) may be formed at an upper surface (e.g., surface) of a first part 2031 of the third key structure 2030 so as to distinguish the third key structure 2030 from the first key structure 2010 and the second key structure 2020.

According to an embodiment, the plurality of vibration structures 2040, 2050, and 2060 may be disposed inside the side surface 612 of the housing 610 to provide (e.g., transfer) a vibration to the side key 2000 (e.g., a plurality of side buttons). For example, the plurality of vibration structures 2040, 2050, and 2060 may include a first vibration structure 2040, a second vibration structure 2050, and a third vibration structure 2060. For example, each of the first vibration structure 2040, the second vibration structure 2050, and the third vibration structure 2060 may include a piezo actuator, a haptic actuator, a vibration element, or a vibration plate.

According to an embodiment, the first vibration structure 2040 may be disposed to contact at least a portion of the first key structure 2010 to provide (e.g., transfer) a vibration to the first key structure 2010. For example, a first part **2011** of the first key structure 2010 may be exposed to the outside so that the user may press a key. At least a portion of a second part 2012 connected to the first part **2011** of the first key structure 2010 may be disposed inside the side surface 612 of the housing 610. A lower end portion of the second part 2012 of the first key structure 2010 may have an inclined shape such that the end thereof is pointed. The lower end portion of the second part 2012 of the first key structure 2010 may be inserted (e.g., received) into a first groove 2041 formed in the first vibration structure 2040. The lower end portion of the second part 2012 of the first key structure 2010 is inserted (e.g., received) into the first groove 2041 formed in the first vibration structure 2040; thus, the first key structure 2010 may be fixed, i.e. secured, over the first vibration structure 2040.

According to an embodiment, a hole may be formed in at least a portion of the first part 2011 of the first key structure 2010. A first fixing pin 2013 may be disposed to be inserted into the hole formed in the first part 2011 of the first key structure 2010. The first fixing pin 2013 may be inserted into the hole formed in the first part 2011 of the first key structure 2010; thus, the location of the first key structure 2010 with respect to the housing is fixed or constrained within a determined range. For example, the first fixing pin 2013 may be disposed to be inserted into the hole formed in the first part 2011 of the first key structure 2010 so that the first key structure 2010 does not deviate from a configured position in the vertical direction when a pressure is applied to the first key structure 2010 by the user. For example, in order to prevent the first key structure 2010 from being deviated to the outside of the housing 610, the first fixing pin 2013 may be disposed to be inserted into the hole formed in the first part 2011 of the first key structure 2010.

According to an embodiment, the second vibration structure 2050 may be disposed to contact at least a portion of the second key structure 2020 to provide (e.g., transfer) a vibration to the second key structure 2020. For example, a first part 2021 of the second key structure 2020 may be exposed to the outside so that the user may press a key. At least a portion of a second part 2022 connected to the first part 2021 of the second key structure 2020 may be disposed inside the side surface 612 of the housing 610. A lower end portion of the second part 2022 of the second key structure 2020 may have an inclined shape such that the end thereof is pointed. The lower end portion of the second part 2022 of the second key structure 2020 may be inserted (e.g., received) into a second groove 2051 formed in the second vibration structure 2050. The lower end portion of the second part 2022 of the second key structure 2020 is inserted (e.g., received) into the second groove 2051 formed in the second vibration structure 2050; thus, the second key structure 2020 may be fixed over the second vibration structure 2050.

According to an embodiment, a hole may be formed in at least a portion of the first part 2021 of the second key structure 2020. A second fixing pin 2023 may be disposed to be inserted into the hole formed in the first part 2021 of the second key structure 2020. The second fixing pin 2023 is inserted into the hole formed in the first part 2021 of the second key structure 2020; thus, the second key structure 2020 may be fixed within a determined range. For example, when a pressure is applied to the second key structure 2020 by the user, the second fixing pin 2023 may be disposed to be inserted into the hole formed in the first part 2021 of the second key structure 2020 so that the second key structure 2020 does not deviate from a configured position in the vertical direction. For example, in order to prevent the second key structure 2020 from being deviated to the outside of the housing 610, the second fixing pin 2023 may be disposed to be inserted into the hole formed in the first part 2021 of the second key structure 2020.

According to an embodiment, the third vibration structure 2060 may be disposed to contact at least a portion of the third key structure 2030 to provide (e.g., transfer) a vibration to the third key structure 2030. For example, a first part 2031 of the third key structure 2030 may be exposed to the outside so that the user may press a key. At least a portion of a second part 2032 connected to the first part 2031 of the third key structure 2030 may be disposed inside the side surface 612 of the housing 610. A lower end portion of the second part 2032 of the third key structure 2030 may have an inclined shape such that the end thereof is pointed. The lower end portion of the second part 2032 of the third key structure 2030 may be inserted (e.g., received) into a third groove 2061 formed in the third vibration structure 2060. The lower end portion of the second part 2032 of the third key structure 2030 is inserted (e.g., received) into the third groove 2061 formed in the third vibration structure 2060; thus, the third key structure 2030 may be fixed over the third vibration structure 2060.

According to an embodiment, a hole may be formed in at least a portion of the first part 2031 of the third key structure 2030. A third fixing pin 2033 may be disposed to be inserted into the hole formed in the first part 2021 of the third key structure 2030. The third fixing pin 2033 is inserted into the hole formed in the first part 2031 of the third key structure 2030; thus, the third key structure 2030 may be fixed, i.e., constrained, within a determined range. For example, the third fixing pin 2033 may be disposed to be inserted into the hole formed in the first part 2031 of the third key structure 2030 so that the third key structure 2030 does not deviate from a configured position in the vertical direction when a pressure is applied to the third key structure 2030 by the user. For example, in order to prevent the third key structure 2030 from being deviated to the outside of the housing 610, the third fixing pin 2033 may be disposed to be inserted into the hole formed in the first part 2031 of the third key structure 2030.

A vibration is applied to the side key 2000 (e.g., a plurality of side buttons) by a plurality of vibration structures 2040, 2050, and 2060; thus, the side key 2000 (e.g., a plurality of side buttons) may provide a haptic function.

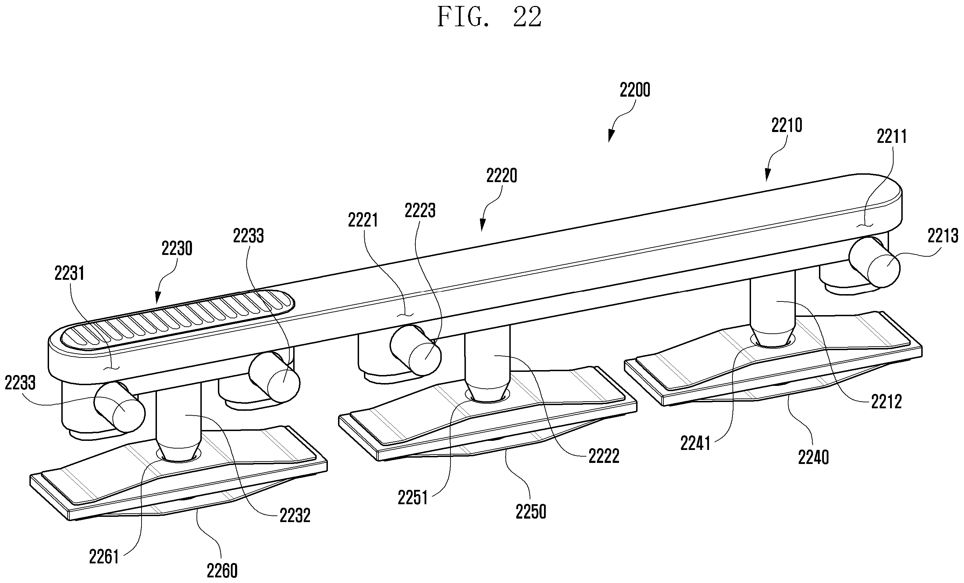

FIG. 22 is a diagram illustrating a key structure and a vibration structure.

With reference to FIG. 22, an electronic device (e.g., the electronic device 101 of FIG. 1, the electronic device 200 of FIG. 2A, the electronic device 300 of FIG. 3A, the electronic device 400 of FIG. 4, the electronic device 500 of FIG. 5, and the electronic device 600 of FIG. 6) according to an embodiment of the disclosure may include a side key 2200 (e.g., the side key 520 of FIG. 5, the side key 1020 of FIG. 11) for a user key input, and a plurality of vibration structures 2240, 2250, and 2260 (e.g., the plurality of vibration structures 1030 of FIG. 11).

According to an embodiment, a hole may be formed at the side surface (e.g., the side surface 612 of FIG. 10) of the housing (e.g., the housing 610 of FIG. 10), and an upper surface (e.g., pressing surface, touch surface, surface) of the side key 2200 may be exposed to the outside through the hole of the side surface 612 of the housing 610.

For example, the side key 2200 may include a plurality of key structures 2210, 2220, and 2230 (e.g., the plurality of key structures 521, 522, and 523 of FIG. 5, the plurality of key structures 1021, 2022, and 2023 of FIG. 11) for a user key input. For example, the plurality of key structures 2210, 2220, and 2230 may include a first key structure 2210 for a user's first key input, a second key structure 2220 for a user's second key input, and a third key structure 2230 for a user's third key input. For example, the first key structure 2210, the second key structure 2220, and the third key structure 2230 may be connected to be disposed as one side key (e.g., side button).

For example, a concave and convex pattern (e.g., embossing pattern) may be formed at an upper surface (e.g., surface) of a first part 2231 of the third key structure 2230 so as to distinguish the third key structure 2230 from the first key structure 2210 the second key structure 2220.

According to an embodiment, the plurality of vibration structures 2240, 2250, and 2260 may be disposed inside the side surface 612 of the housing 610 to provide (e.g., transfer) a vibration to the side key 2200 (e.g., a plurality of side buttons). For example, the plurality of vibration structures 2240, 2250, and 2260 may include a first vibration structure 2240, a second vibration structure 2250, and a third vibration structure 2260. For example, each of the first vibration structure 2240, the second vibration structure 2250, and the third vibration structure 2260 may include a piezo actuator, a haptic actuator, a vibration element, or a vibration plate.

According to an embodiment, the first vibration structure 2240 may be disposed to contact at least a portion of the first key structure 2210 to provide (e.g., transfer) a vibration to the first key structure 2210. For example, a first part 2211 of the first key structure 2210 may be exposed to the outside so that the user may press a key. At least a portion of a second part 2212 connected to the first part 2211 of the first key structure 2210 may be disposed inside the side surface 612 of the housing 610. A lower end portion of the second part 2212 of the first key structure 2210 may have an inclined shape such that the end thereof is pointed. The lower end portion of the second part 2212 of the first key structure 2210 may be inserted (e.g., received) into a first groove 2241 formed in the first vibration structure 2240. The lower end portion of the second part 2212 of the first key structure 2210 is inserted (e.g., received) into the first groove 2241 formed in the first vibration structure 2240; thus, the first key structure 2210 may be fixed, i.e., secured, over the first vibration structure 2240.

According to an embodiment, a hole may be formed in at least a portion of the first part 2211 of the first key structure 2210. A first fixing pin 2213 may be disposed to be inserted into the hole formed in the first part 2211 of the first key structure 2210. The first fixing pin 2213 is inserted into the hole formed in the first part 2211 of the first key structure 2210; thus, the relative position of the first key structure 2210 with respect to the housing may be fixed, i.e., constrained, within a determined range. For example, the first fixing pin 2213 may be disposed to be inserted into the hole formed in the first part 2211 of the first key structure 2210 so that the first key structure 2210 does not deviate from a configured position in the vertical direction when a pressure is applied to the first key structure 2210 by the user. For example, in order to prevent the first key structure 2210 from being deviated to the outside of the housing 610, the first fixing pin 2213 may be disposed to be inserted into the hole formed in the first part 2211 of the first key structure 2210.

According to an embodiment, the second vibration structure 2250 may be disposed to contact at least a portion of the second key structure 2220 to provide (e.g., transfer) a vibration to the second key structure 2220. For example, a first part 2221 of the second key structure 2220 may be exposed to the outside so that the user may press a key. At least a portion of a second part 2222 connected to the first part 2221 of the second key structure 2220 may be disposed inside the side surface 612 of the housing 610. A lower end portion of the second part 2222 of the second key structure 2220 may have an inclined shape such that the end thereof is pointed. The lower end portion of the second part 2222 of the second key structure 2220 may be inserted (e.g., received) into a second groove 2251 formed in the second vibration structure 2250. The lower end portion of the second part 2222 of the second key structure 2220 is inserted (e.g., received) into the second groove 2251 formed in the second vibration structure 2250; thus, the second key structure 2220 may be fixed over the second vibration structure 2250.

According to an embodiment, a hole may be formed in at least a portion of the first part 2221 of the second key structure 2220. A second fixing pin 2223 may be disposed to be inserted into the hole formed in the first part 2221 of the second key structure 2220. The second fixing pin 2223 is inserted into the hole formed in the first part 2221 of the second key structure 2220; thus, the second key structure 2220 may be fixed within a determined range. For example, the second fixing pin 2223 may be disposed to be inserted into the hole formed in the first part 2221 of the second key structure 2220 so that the second key structure 2220 does not deviate from a configured position in the vertical direction when a pressure is applied to the second key structure 2220 by the user. For example, in order to prevent the second key structure 2220 from being deviated to the outside of the housing 610, the second fixing pin 2223 may be disposed to be inserted into the hole formed in the first part 2221 of the second key structure 2220.

According to an embodiment, the third vibration structure 2260 may be disposed to contact at least a portion of the third key structure 2230 to provide (e.g., transfer) a vibration to the third key structure 2230. For example, a first part 2231 of the third key structure 2230 may be exposed to the outside so that the user may press a key. At least a portion of a second part 2232 connected to the first part 2231 of the third key structure 2230 may be disposed inside the side surface 612 of the housing 610. A lower end portion of the second part 2232 of the third key structure 2230 may have an inclined shape such that the end thereof is pointed. The lower end portion of the second part 2232 of the third key structure 2230 may be inserted (e.g., received) into a third groove 2261 formed in the third vibration structure 2260. The lower end portion of the second part 2232 of the third key structure 2230 is inserted (e.g., received) into the third groove 2261 formed in the third vibrating structure 2260; thus, the third key structure 2230 may be fixed over the third vibrating structure 2260.

According to an embodiment, a hole may be formed in at least a portion of the first part 2231 of the third key structure 2230. A third fixing pin 2233 may be disposed to be inserted into the hole formed in the first part 2221 of the third key structure 2230. The third fixing pin 2233 is inserted into the hole formed in the first part 2231 of the third key structure 2230; thus, the third key structure 2230 may be fixed within a determined range. For example, the third fixing pin 2233 may be disposed to be inserted into the hole formed in the first part 2231 of the third key structure 2230 so that the third key structure 2230 does not deviate from a configured position in the vertical direction when a pressure is applied to the third key structure 2230 by the user. For example, in order to prevent the third key structure 2230 from being deviated to the outside of the housing 610, the third fixing pin 2233 may be disposed to be inserted into the hole formed in the first part 2231 of the third key structure 2230.

A vibration is applied to the side key 2200 (e.g., a plurality of side buttons) by a plurality of vibration structures 2240, 2250, and 2260; thus, the side key 2200 (e.g., a plurality of side buttons) may provide a haptic function.

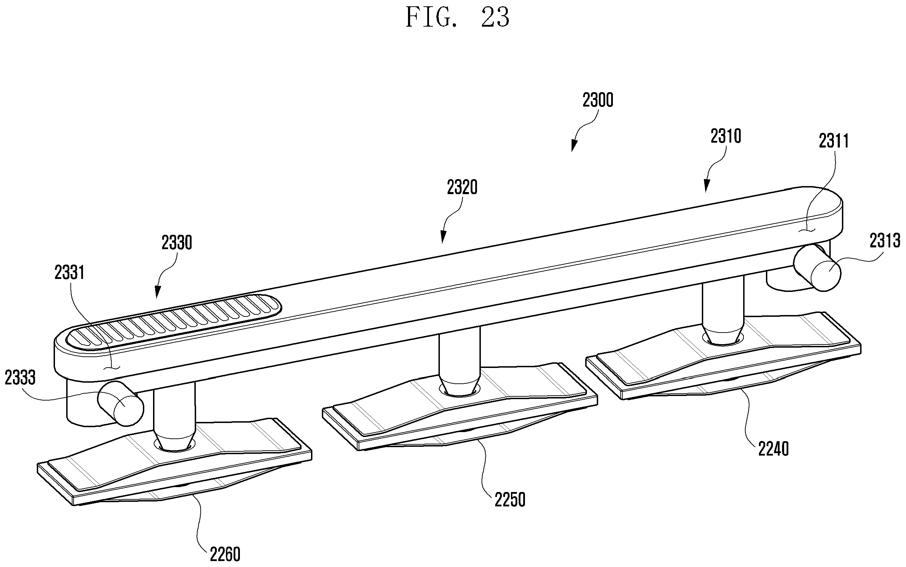

FIG. 23 is a diagram illustrating a key structure and a vibration structure.

With reference to FIG. 23, an electronic device (e.g., the electronic device 101 of FIG. 1, the electronic device 200 of FIG. 2A, the electronic device 300 of FIG. 3A, the electronic device 400 of FIG. 4, the electronic device 500 of FIG. 5, and the electronic device 600 of FIG. 6) according to an embodiment of the disclosure may include a side key 2300 (e.g., the side key 520 of FIG. 5, the side key 1020 of FIG. 11) for a user key input, and a plurality of vibration structures 2240, 2250, and 2260 (e.g., the plurality of vibration structures 1030 of FIG. 11).

According to an embodiment, a hole may be formed at the side surface (e.g., the side surface 612 of FIG. 10) of the housing (e.g., the housing 610 of FIG. 10), and an upper surface (e.g., pressing surface, touch surface, surface) of the side key 2300 may be exposed to the outside through the hole of the side surface 612 of the housing 610.

For example, the side key 2300 may include a plurality of key structures 2310, 2320, and 2330 (e.g., the plurality of key structures 521, 522, and 523 of FIG. 5, the key structures 1021, 1022, and 1023 of FIG. 11) for a user key input. For example, the plurality of key structures 2310, 2320, and 2330 may include a first key structure 2310 for a user's first key input, a second key structure 2320 for a user's second key input, and a third key structure 2330 for a user's third key input. For example, the first key structure 2310, the second key structure 2320, and the third key structure 2330 may be connected to be disposed as one side key (e.g., side button).

For example, a concave and convex pattern (e.g., embossing pattern) may be formed at an upper surface (e.g., surface) of a first part 2331 of the third key structure 2330 so as to distinguish the third key structure 2330 from the first key structure 2310 and the second key structure 2320.

According to an embodiment, the plurality of vibration structures 2240, 2250, and 2260 are disposed inside the side surface 612 of the housing 610 to provide (e.g., transfer) a vibration to the side key 2300 (e.g., a plurality of side buttons). For example, the plurality of vibration structures 2240, 2250, and 2260 may include a first vibration structure 2240, a second vibration structure 2250, and a third vibration structure 2260. For example, each of the first vibration structure 2240, the second vibration structure 2250, and the third vibration structure 2260 may include a piezo actuator, a haptic actuator, a vibration element, or a vibration plate.

According to an embodiment, the first vibration structure 2240 may be disposed to contact at least a portion of the first key structure 2310 to provide (e.g., transfer) a vibration to the first key structure 2310. For example, a first part 2311 of the first key structure 2310 may be exposed to the outside so that the user may press a key. At least a portion of a second part 2312 connected to the first part 2311 of the first key structure 2310 may be disposed inside the side surface 612 of the housing 610. A lower end portion of the second part 2312 of the first key structure 2310 may have an inclined shape such that the end thereof is pointed. The lower end portion of the second part 2312 of the first key structure 2310 may be inserted (e.g., received) into a first groove 2241 formed in the first vibration structure 2240. The lower end portion of the second part 2312 of the first key structure 2310 is inserted (e.g., received) into the first groove 2241 formed in the first vibration structure 2240; thus, the first key structure 2310 may be fixed over the first vibration structure 2240.

According to an embodiment, a hole may be formed in at least a portion of the first part 2311 of the first key structure 2310. A first fixing pin 2313 may be disposed to be inserted into the hole formed in the first part 2311 of the first key structure 2310. The first fixing pin 2313 is inserted into the hole formed in the first part 2311 of the first key structure 2310; thus, the location of the first key structure 2310 with respect to the housing may be fixed, i.e., constrained, within a predetermined range. For example, the first fixing pin 2313 may be disposed to be inserted into the hole formed in the first part 2311 of the first key structure 2310 so that the first key structure 2310 does not deviate from a configured position in the vertical direction when a pressure is applied to the first key structure 2310 by the user. For example, in order to prevent the first key structure 2310 from being deviated to the outside of the housing 610, the first fixing pin 2313 may be disposed to be inserted into the hole formed in the first part 2311 of the first key structure 2310.

According to an embodiment, the second vibration structure 2250 may be disposed to contact at least a portion of the second key structure 2320 to provide (e.g., transfer) a vibration to the second key structure 2320. For example, a first part 2321 of the second key structure 2320 may be exposed to the outside so that the user may press a key. At least a portion of a second part 2322 connected to the first part 2321 of the second key structure 2320 may be disposed inside the side surface 612 of the housing 610. A lower end portion of the second part 2322 of the second key structure 2320 may have an inclined shape such that the end thereof is pointed. The lower end portion of the second part 2322 of the second key structure 2320 may be inserted (e.g., received) into a second groove 2251 formed in the second vibration structure 2250. The lower end portion of the second part 2322 of the second key structure 2320 is inserted (e.g., received) into the second groove 2251 formed in the second vibration structure 2250; thus, the second key structure 2320 may be fixed over the second vibration structure 2250.

According to an embodiment, the third vibration structure 2260 may be disposed to contact at least a portion of the third key structure 2330 to provide (e.g., transfer) a vibration to the third key structure 2330. For example, a first part 2331 of the third key structure 2330 may be exposed to the outside so that the user may press a key. At least a portion of a second part 2332 connected to the first part 2331 of the third key structure 2330 may be disposed inside the side surface 612 of the housing 610. A lower end portion of the second part 2332 of the third key structure 2330 may have an inclined shape such that the end thereof is pointed. The lower end portion of the second part 2332 of the third key structure 2330 may be inserted (e.g., received) into a third groove 2261 formed in the third vibration structure 2260. The lower end portion of the second part 2332 of the third key structure 2330 is inserted (e.g., received) into the third groove 2261 formed in the third vibrating structure 2260; thus, the third key structure 2330 may be fixed over the third vibrating structure 2260.

According to an embodiment, a hole may be formed in at least a portion of a first part 2331 of the third key structure 2330. A second fixing pin 2333 may be disposed to be inserted into the hole formed in the first part 2321 of the third key structure 2330. The second fixing pin 2333 is inserted into the hole formed in the first part 2331 of the third key structure 2330; thus, the third key structure 2330 may be fixed within a determined range. For example, the second fixing pin 2333 may be disposed to be inserted into the hole formed in the first part 2331 of the third key structure 2330 so that the third key structure 2330 does not deviate from a configured position in the vertical direction when a pressure is applied to the third key structure 2330 by the user. For example, in order to prevent the third key structure 2330 from being deviated to the outside of the housing 610, the second fixing pin 2333 may be disposed to be inserted into the hole formed in the first part 2331 of the third key structure 2330.

A vibration is applied to the side key 2300 (e.g., a plurality of side buttons) by a plurality of vibration structures 2240, 2250, and 2260; thus, the side key 2300 (e.g., a plurality of side buttons) may provide a haptic function.

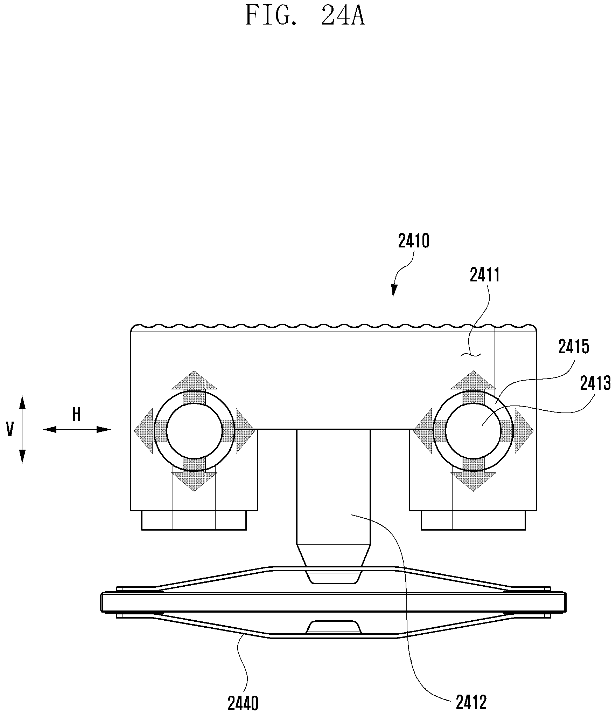

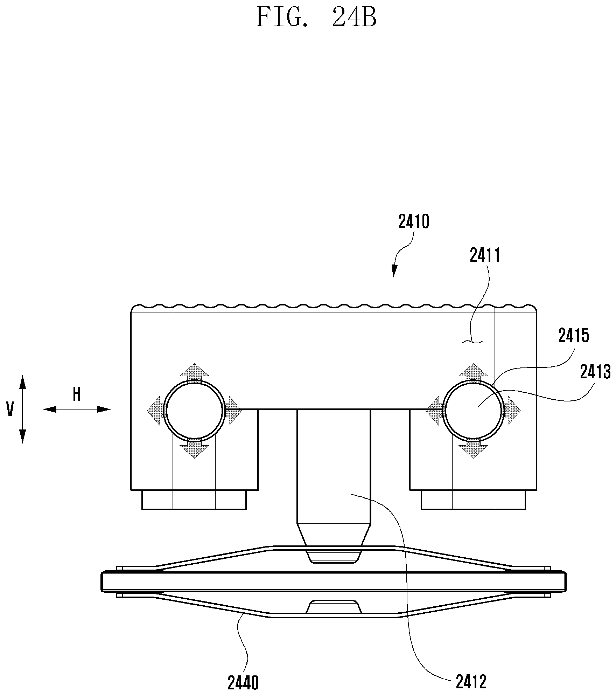

FIGS. 24A and 24B are diagrams illustrating a key structure and a vibration structure.

With reference to FIGS. 24A and 24B, , a second part 2412 of a key structure 2410 may be disposed to contact a vibration structure 2440. A vibration generated in the vibration structure 2440 may be transferred to the key structure 2410.

A hole 2415 (e.g., 1 or 2 holes) may be formed in at least a portion of a first part 2411 of the key structure 2410. For example, the hole 2415 (1 or 2 holes) formed in at least a portion of the first part 2411 of the key structure 2410 may be formed in a circular shape with the same diameter in a vertical direction and a horizontal direction.

For example, a fixing pin 2413 (e.g., 1 or 2 fixing pins) may be disposed to be inserted into the hole 2415 formed in the first part 2411 of the key structure 2410. The fixing pin 2413 (e.g., 1 or 2 fixing pins) is inserted into the hole 2415 formed in the first part 2411 of the key structure 2410; thus, the location of the key structure 2410 with respect to the housing may be fixed within a determined range.

According to an embodiment, the range that the key structure 2410 may be moved upward, downward, leftward, and rightward may be determined by the size (e.g., diameter) of the hole 2415 formed in the first part 2411 of the key structure 2410.

For example, a fixing pin 2413 (e.g., 1 or 2 fixing pins) may be disposed to be inserted into the hole formed in the first part 2411 of the key structure 2410 so that the key structure 2410 does not deviate from a configured position in the vertical direction when a pressure is applied to the key structure 2410 by the user. For example, in order to prevent the key structure 2410 from being deviated to the outside of the housing 610, the fixing pin 2413 (e.g., 1 or 2 fixing pins) may be disposed to be inserted into the hole formed in the first part 2411 of the key structure 2410.

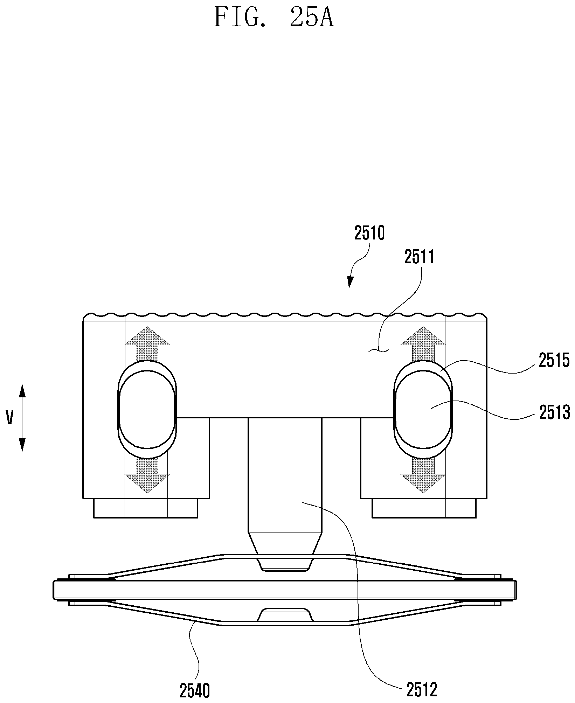

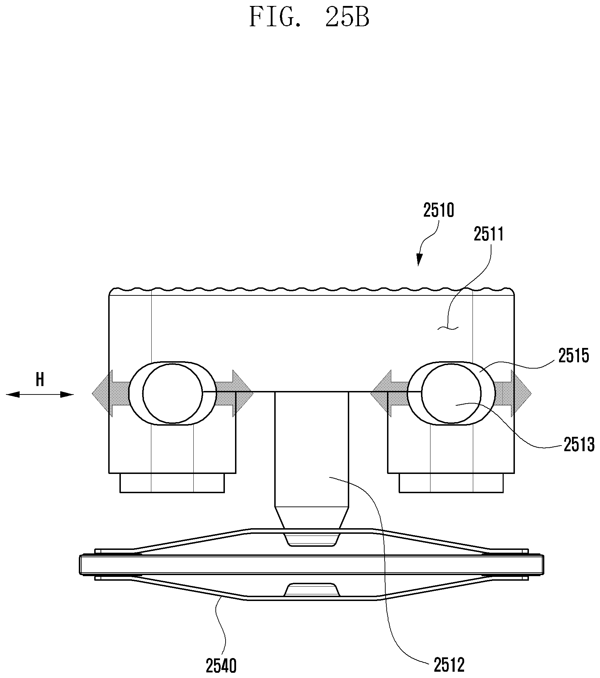

FIGS. 25A and 25B are diagrams illustrating a key structure and a vibration structure.

With reference to FIGS. 25A and 25B, a second part 2512 of a key structure 2510 may be disposed to contact a vibration structure 2540. A vibration generated in the vibration structure 2540 may be transferred to the key structure 2510.

A hole 2515 (e.g., 1 or 2 holes) may be formed in at least a portion of a first part 2511 of the key structure 2510.

For example, the hole 2515 (1 or 2 holes) formed in at least a portion of the first part 2511 of the key structure 2510 may be formed in an oval shape with a long length in a vertical direction.

For example, a fixing pin 2513 (e.g., 1 or 2 fixing pins) may be disposed to be inserted into the hole 2515 formed in the first part 2511 of the key structure 2510. The fixing pin 2513 (e.g., 1 or 2 fixing pins) is inserted into the hole 2515 formed in the first part 2511 of the key structure 2510; thus, the location of the key structure 2510 with respect to the housing may be fixed within a determined range.

According to an embodiment, the range that the key structure 2510 may be moved upward, downward, leftward, and rightward may be determined by a shape and size (e.g., diameter) of the hole 2515 formed in the first part 2511 of the key structure 2510.

For example, the hole 2515 (e.g., 1 or 2 holes) is formed in an oval shape having a longer length in the vertical direction; thus, the key structure 2510 may have a narrower movement range in a horizontal direction and have a wider movement range in a vertical direction.

For example, a fixing pin 2513 (e.g., 1 or 2 fixing pins) may be disposed to be inserted into the hole formed in the first part 2511 of the key structure 2510 so that the key structure 2510 does not deviate from a configured position in the vertical direction when a pressure is applied to the key structure 2510 by the user. For example, in order to prevent the key structure 2510 from being deviated to the outside of the housing 610, a fixing pin 2513 (e.g., 1 or 2 fixing pins) may be disposed to be inserted into the hole formed in the first part 2511 of the key structure 2510.

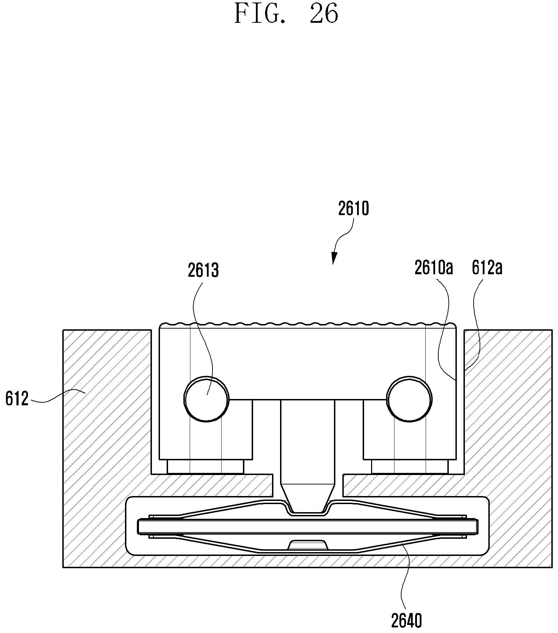

FIG. 26 is a diagram illustrating a key structure disposed at a side surface of a housing.

With reference to FIG. 26, at least a portion of a key structure 2610 may be disposed to contact a vibration structure 2640. A vibration generated in the vibration structure 2640 may be transferred to the key structure 2610.

A hole (1 or 2 holes) may be formed in at least a portion of the key structure 2610. For example, the hole (1 or 2 holes) formed in at least a portion of the key structure 2610 may be formed in a circular shape with the same diameter in the vertical direction and the horizontal direction.

For example, a fixing pin 2613 (e.g., 1 or 2 fixing pins) may be disposed to be inserted into the hole formed in the key structure 2610. The fixing pin 2613 (e.g., 1 or 2 fixing pins) is inserted into the hole formed in the key structure 2610; thus, the location of the key structure 2610 with respect to the housing may be fixed within a determined range.

For example, in order to prevent the key structure 2610 from being deviated from a configured position in the vertical direction when a pressure is applied to the key structure 2610 by the user, a fixing pin 2613 (e.g., 1 or 2 fixing pins) may be disposed to be inserted into the hole formed in the key structure 2610. For example, in order to prevent the key structure 2610 from being deviated to the outside of the housing 610, the fixing pin 2613 (e.g., 1 or 2 fixing pins) may be disposed to be inserted into the hole formed in the key structure 2610.

According to an embodiment, an inner side 612a of the side surface 612 of the housing in which the key structure 2610 is disposed may be flat. An outer side 2610a of the key structure 2610 disposed adjacent to the inner side 612a of the side surface 612 of the housing may be flat. Even if the inner side 612a of the side surface 612 of the housing is flat, the key structure 2610 may be fixed without being deviated from the housing to the hole formed in the key structure 2610 by the fixing pin 2613 (e.g., 1 or 2 fixing pins).

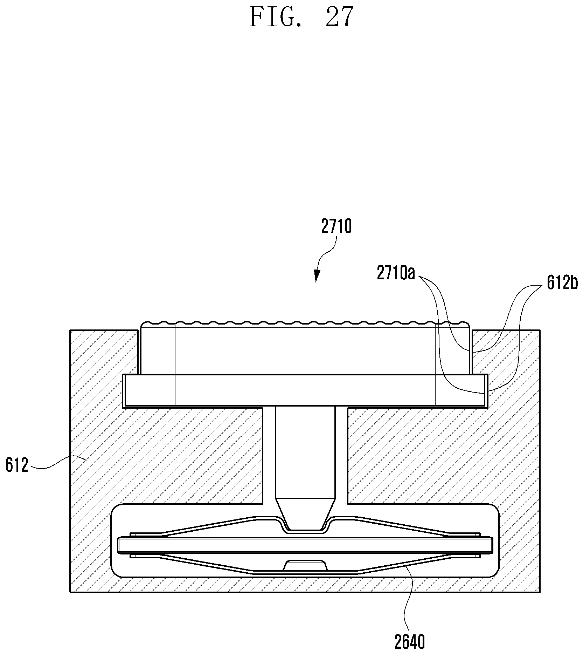

FIG. 27 is a diagram illustrating a key structure disposed at a side surface of a housing.

With reference to FIG. 27, at least a portion of a key structure 2710 may be disposed to contact a vibration structure 2640. A vibration generated in the vibration structure 2640 may be transferred to the key structure 2710.

The inside of the side surface 612 of the housing (e.g., the housing 610 of FIG. 6) in which the key structure 2710 is disposed may be formed in a step shape 612b. The outside of the key structure 2710 disposed adjacent to the inside of the side surface 612 of the housing may be formed in a step shape 2710a. Because the outside of the key structure 2710 is caught by the step shape 612b of the side surface 612 of the housing (e.g., the housing 610 of FIG. 6), the location of the key structure 2710 with respect to the housing may be fixed or constrained.

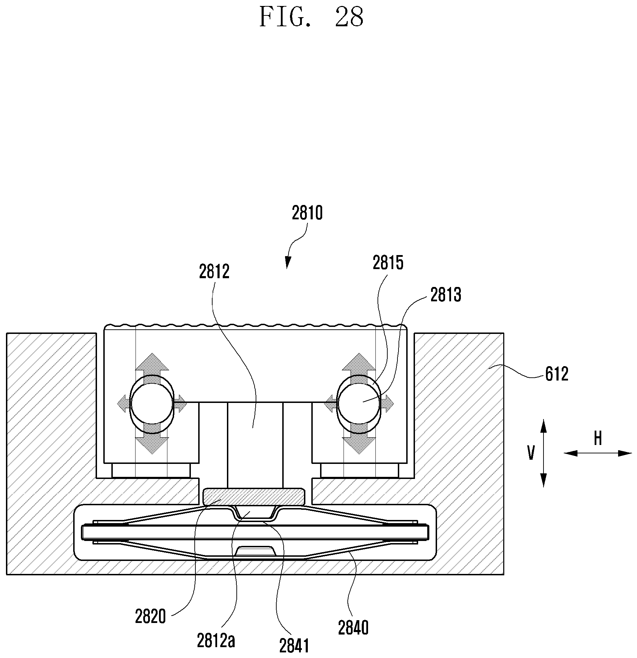

FIG. 28 is a diagram illustrating a key structure disposed at a side surface of a housing.

With reference to FIG. 28, at least a portion of a key structure 2810 may be disposed to contact a vibration structure 2840. A vibration generated in the vibration structure 2840 may be transferred to the key structure 2810.

For example, a lower end portion 2812a of a second part 2812 of the key structure 2810 may have an inclined shape such that the end thereof is pointed. The lower end portion 2812a of the second part 2812 of the key structure 2810 may be inserted (e.g., received) into a groove 2841 formed in the vibration structure 2840. The lower end portion 2812a of the second part 2812 of the key structure 2810 is inserted (e.g., received) into the groove 2841 formed in the vibration structure 2840; thus, the key structure 2810 may be fixed over the vibration structure 2840.

According to an embodiment, a contact point expansion member 2820 (e.g., contact point expansion structure, contact point expansion ring) may be disposed in the second part 2812 of the key structure 2810.

For example, the contact point expansion member 2820 (e.g., contact point expansion structure, contact point expansion ring) may be fitted into the second part 2812 of the key structure 2810.

For example, the contact point expansion member 2820 (e.g., contact point expansion structure, contact point expansion ring) may contact an upper surface (e.g., upper part) of the vibration structure 2840.

The contact point expansion member 2820 (e.g., contact point expansion structure, contact point expansion ring) is disposed to contact the vibration structure 2840; thus, a contact point between the key structure 2810 and the vibration structure 2840 is expanded or increased. This allows a vibration generated in the vibration structure 2840 to be more effectively transferred to the key structure 2810 by the contact point expansion member 2820 (e.g., contact point expansion structure, contact point expansion ring).

According to an embodiment, a hole (1 or 2 holes) may be formed in a first part of the key structure 2810. For example, the hole (e.g., 1 or 2 holes) formed in the first part of the key structure 2810 may be formed in an oval shape with a longer length in the vertical direction.

For example, a fixing pin 2813 (e.g., 1 or 2 fixing pins) may be disposed to be inserted into the hole formed in the key structure 2810. The fixing pin 2813 (e.g., 1 or 2 fixing pins) is inserted into the hole formed in the key structure 2810; thus, the location of the key structure 2810 with respect to the housing may be fixed, i.e., constrained, within a determined range.

For example, in order to prevent the key structure 2810 from being deviated from a configured position in the vertical direction when a pressure is applied to the key structure 2810 by the user, the fixing pin 2813 (e.g., 1 or 2 fixing pins) may be disposed to be inserted into the hole formed in the key structure 2810. For example, in order to prevent the key structure 2810 from being deviated to the outside of the housing (e.g., the housing 610 of FIG. 6), the fixing pin 2813 (e.g., 1 or 2 fixing pins) may be disposed to be inserted into the hole formed in the key structure 2810.

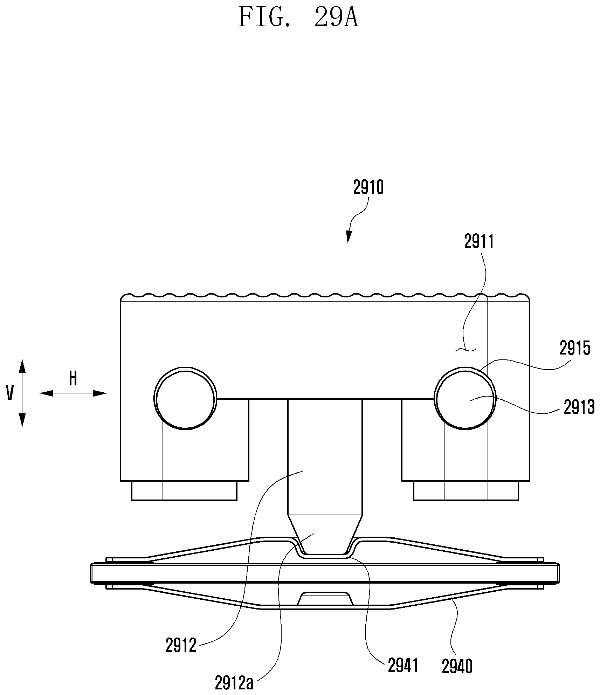

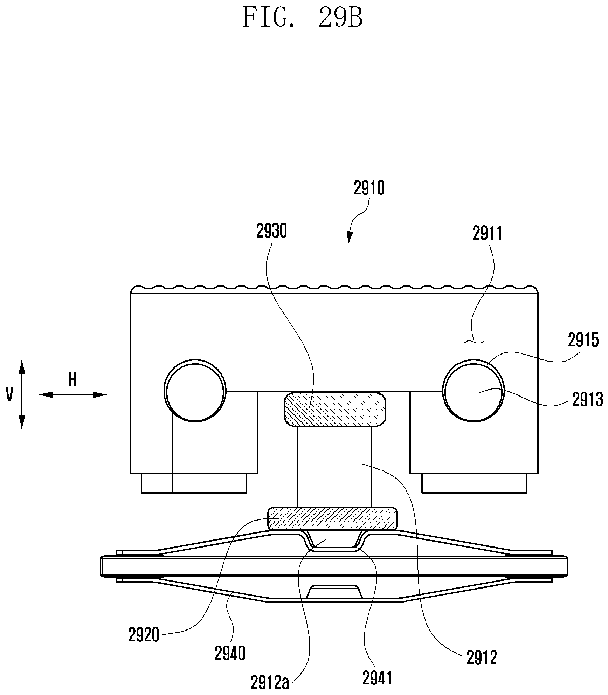

FIGS. 29A and 29B are diagrams illustrating a key structure and a vibration structure.

With reference to FIGS. 29A and 29B, a lower end portion 2912a of a second part 2912 of a key structure 2910 may be formed to have a narrow width as it goes downward, and a bottom of the lower end portion 2912a may be formed to be flat. A groove 2941 formed in a vibration structure 2940 may have a flat bottom surface.

For example, the second part 2912 of the key structure 2910 may be inserted into the groove 2941 of the vibration structure 2940; thus, the second part 2912 of the key structure 2910 and the vibration structure 2940 may be disposed to contact each other. A vibration generated in the vibration structure 2940 may be transferred to the key structure 2910.

According to an embodiment, a hole 2915 (e.g., 1 or 2 holes) may be formed in at least a portion of a first part 2911 of the key structure 2910. For example, the hole 2915 (1 or 2 holes) formed in at least a portion of the first part 2911 of the key structure 2910 may be formed in a circular shape with the same diameter in a vertical direction and a horizontal direction.

For example, a fixing pin 2913 (e.g., 1 or 2 fixing pins) may be disposed to be inserted into the hole 2915 formed in the first part 2911 of the key structure 2910. The fixing pin 2913 (e.g., 1 or 2 fixing pins) is inserted into the hole 2915 formed in the first part 2911 of the key structure 2910; thus, the key structure 2910 may be fixed within a determined range.

According to an embodiment, the range that the key structure 2910 may be moved upward, downward, leftward, and rightward may be determined by a size (e.g., diameter) of the hole 2915 formed in the first part 2911 of the key structure 2910.

For example, a fixing pin 2913 (e.g., 1 or 2 fixing pins) may be disposed to be inserted into the hole formed in the first part 2911 of the key structure 2910 so that the key structure 2910 does not deviate from a configured position in the vertical direction when a pressure is applied to the key structure 2910 by the user. For example, in order to prevent the key structure 2910 from being deviated to the outside of the housing (e.g., the housing 610 of FIG. 6), the fixing pin 2913 (e.g., 1 or 2 fixing pins) may be disposed to be inserted into the hole formed in the first part 2911 of the key structure 2910.

According to an embodiment, a contact point expansion member 2920 (e.g., contact point expansion structure, contact point expansion ring) may be disposed in a second part 2912 of the key structure 2910.

For example, the contact point expansion member 2920 (e.g., contact point expansion structure, contact point expansion ring) may be fitted into the second part 2912 of the key structure 2910.

For example, the contact point expansion member 2920 (e.g., contact point expansion structure, contact point expansion ring) may contact an upper surface (e.g., upper part) of the vibration structure 2940.

The contact point expansion member 2920 (e.g., contact point expansion structure, contact point expansion ring) may contact the vibration structure 2940; thus, a contact point between the key structure 2910 and the vibration structure 2940 may be expanded, i.e., increased. In this way, a vibration generated in the vibration structure 2940 may be more effectively transferred to the key structure 2910 by the contact point expansion member 2920 (e.g., contact point expansion structure, contact point expansion ring).

According to an embodiment, in order to waterproof a portion in which the side key is disposed, a waterproof member 2930 (e.g., waterproof ring) may be included. For example, the waterproof member 2930 (e.g., waterproof ring) may be disposed to be fitted into a second part 2912 of the key structure 2910.

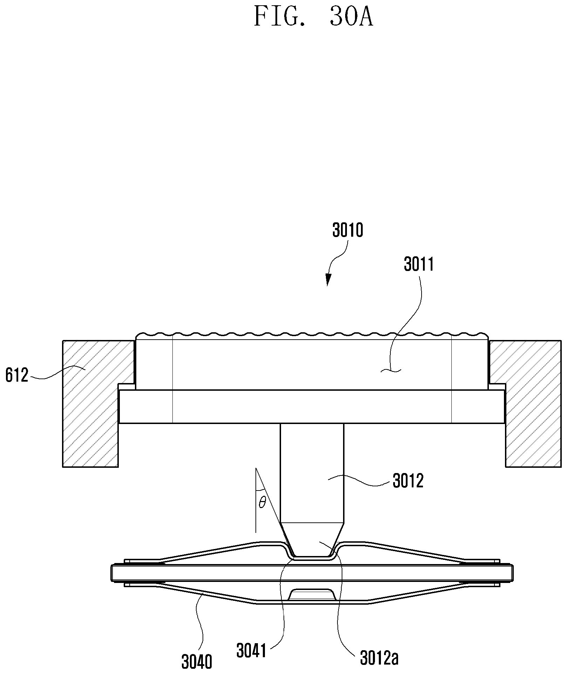

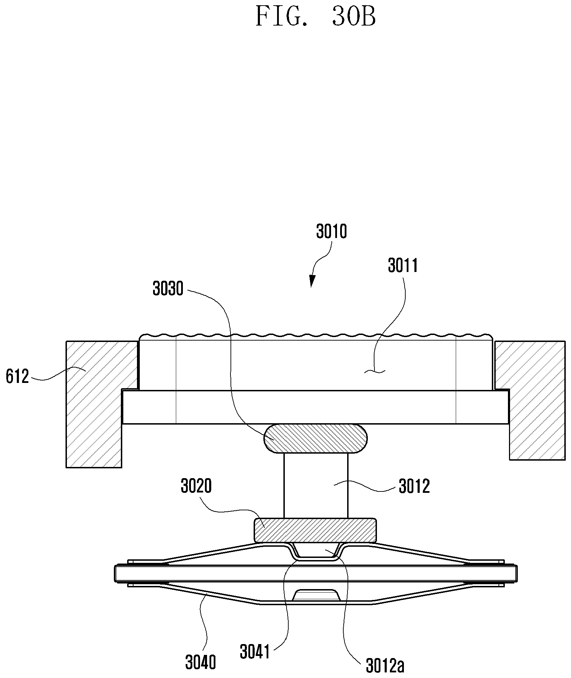

FIGS. 30A and 30B are diagrams illustrating a key structure and a vibration structure.

With reference to FIGS. 30A and 30B, a first part 3011 of a key structure 3010 may be disposed to be exposed to the outside of the housing (e.g., the housing 610 of FIG. 6). For example, a lower end portion of a second part 3012 of the key structure 3010 may be formed to have a narrow width as it goes downward, and a bottom of the lower end portion may be formed to be flat.

For example, a groove 3041 formed in a vibration structure 3040 may have a flat bottom surface. For example, the second part 3012 of the key structure 3010 is inserted into the groove 3041 of the vibration structure 3040; thus, the second part 3012 of the key structure 3010 and the vibration structure 3040 may be disposed to contact each other. A vibration generated in the vibration structure 3040 may be transferred to the key structure 3010. For example, by adjusting an inclination angle θ of a lower end portion of the second part 3012, a contact area between the second part 3012 and the vibration structure 3040 may be adjusted.

According to an embodiment, a contact point expansion member 3020 (e.g., contact point expansion structure, contact point expansion ring) may be disposed in the second part 3012 of the key structure 3010.

For example, the contact point expansion member 3020 (e.g., contact point expansion structure, contact point expansion ring) may be fitted into the second part 3012 of the key structure 3010.

For example, the contact point expansion member 3020 (e.g., contact point expansion structure, contact point expansion ring) may contact an upper surface (e.g., upper part) of the vibration structure 3040.

The contact point expansion member 3020 (e.g., contact point expansion structure, contact point expansion ring) contacts the vibration structure 3040; thus, a contact point between the key structure 3010 and the vibration structure 3040 is expanded, i.e., increased. In this way, a vibration generated in the vibration structure 3040 can be more effectively transferred to the key structure 3010 by the contact point expansion member 3020 (e.g., contact point expansion structure, contact point expansion ring).

According to an embodiment, in order to waterproof a portion in which the side key is disposed, a waterproof member 3030 (e.g., waterproof ring) may be included. For example, the waterproof member 3030 (e.g., waterproof ring) may be disposed to be fitted into the second part 3012 of the key structure 3010.

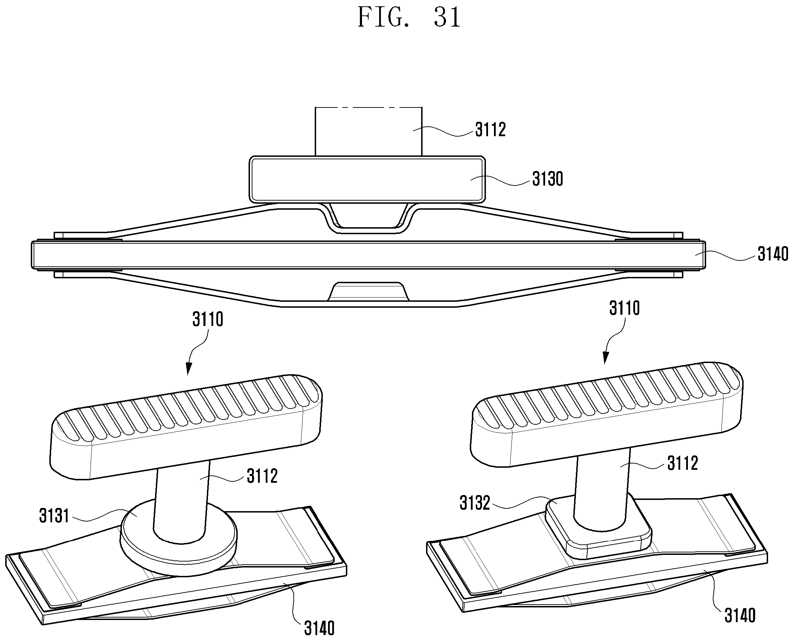

FIG. 31 is a diagram illustrating a key structure and a vibration structure.

With reference to FIG. 31, a vibration structure 3140 may be disposed to contact at least a portion of a key structure 3110 to provide (e.g., transfer) a vibration to the key structure 3110. For example, a first part of the key structure 3110 may be exposed to the outside of the housing (e.g., the housing 610 of FIG. 10) so that the user may press the key. At least a portion of a second part 3112 connected to the first part of the key structure 3110 may be disposed inside the side surface (e.g., the side surface 612 of FIG. 10) of the housing (e.g., the housing 610 of FIG. 10). A lower end portion of the second part 3112 of the key structure 3110 may be formed to have a narrower width as it goes downward, and a bottom of the lower end portion may be flat.

For example, a groove may be formed in an upper part (e.g., upper surface) of the vibration structure 3140. The groove formed in the vibration structure 3140 may have a flat bottom surface. The lower end portion of the second part 3112 of the key structure 3110 may be inserted (e.g., received) into a groove formed in the vibration structure 3140. The lower end portion of the second part 3112 of the key structure 3110 is inserted (e.g., received) into a groove formed in the vibration structure 3140; thus, the key structure 3110 may be fixed over the vibration structure 3140.

For example, a vibration may be applied to the key structure 3110 by the vibration structure 3140; thus, the side key may provide a haptic function. The larger an area of a contact point between the vibration structure 3140 and the lower end portion of the second part 3112 of the key structure 3110, the more effectively a vibration generated in the vibration structure 3140 may be transferred to the key structure 3110. When the lower end portion of the second part 3112 of the key structure 3110 is inserted into the groove formed in the vibrating structure 3140 in a semi-fixed(e.g., partial movement is allowed) form, an area of the contact point may be expanded.

According to an embodiment, contact point expansion members 3131 and 3132 (e.g., contact point expansion structure, contact point expansion ring) may be disposed in the second part 3112 of the key structure 3110.

For example, the contact point expansion members 3131 and 3132 (e.g., contact point expansion structure, contact point expansion ring) may be fitted into the second part 3112 of the key structure 3110.

For example, the contact point expansion members 3131 and 3132 (e.g., contact point expansion structure, contact point expansion ring) may contact an upper surface (e.g., upper part) of the vibration structure 3140.

For example, the contact point expansion member 3131 may be formed in a circular outer shape.

For example, the contact point expansion member 3132 may be formed in a rectangular outer shape.

For example, the contact point expansion members 3131 and 3132 (e.g., contact point expansion structure, contact point expansion ring) may contact the vibration structure 3140; thus, a contact point between the key structure 3110 and the vibration structure 3140 may be expanded. A vibration generated in the vibration structure 3140 may be more effectively transferred to the key structure 3110 by the contact point expansion members 3131 and 3132 (e.g., contact point expansion structure, contact point expansion ring).

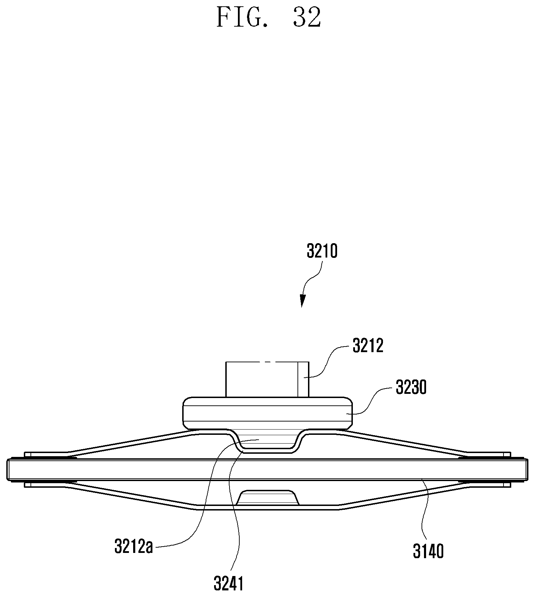

FIG. 32 is a diagram illustrating a key structure and a vibration structure.

With reference to FIG. 32, a vibration structure 3240 may be disposed to contact at least a portion of a key structure 3210 to provide (e.g., transfer) a vibration to a key structure 3210. For example, a first part of the key structure 3210 may be exposed to the outside of the housing (e.g., the housing 610 of FIG. 10) so that the user may press the key. At least a portion of a second part 3212 connected to the first part of the key structure 3210 may be disposed inside a side surface (e.g., the side surface 612 of FIG. 10) of the housing (e.g., the housing 610 of FIG. 10). A lower end portion 3212a of the second part 3212 of the key structure 3210 may be formed to have a narrow width as it goes downward, and a bottom of the lower end portion 3212a may be formed to be flat.

For example, a groove 3241 may be formed in an upper part (e.g., upper surface) of the vibrating structure 3240. The groove 3241 formed in the vibration structure 3240 may have a flat bottom surface. A lower end portion 3212a of the second part 3212 of the key structure 3210 may be inserted (e.g., received) into the groove 3241 formed in the vibration structure 3240. The lower end portion 3212a of the second part 3212 of the key structure 3210 is inserted (e.g., received) into the groove 3241 formed in the vibration structure 3240; thus, the key structure 3210 may be fixed over the vibration structure 3240.

For example, a vibration is applied to the key structure 3210 by the vibration structure 3240; thus, the side key may provide a haptic function. The larger an area of a contact point between the vibration structure 3240 and the lower end portion 3212a of the second part 3212 of the key structure 3210, the more effectively a vibration generated in the vibration structure 3240 may be transferred to the key structure 3210. When the lower end portion 3212a of the second part 3212 of the key structure 3210 is inserted into the groove formed in the vibrating structure 3240 in a semi-fixed(e.g., partial movement is allowed) form, the area of the contact point is expanded.

According to an embodiment, a contact point expansion member 3230 (e.g., contact point expansion structure, contact point expansion ring) may be disposed in the second part 3212 of the key structure 3210.

For example, the contact point expansion member 3230 (e.g., contact point expansion structure, contact point expansion ring) may be formed integrally with the second part 3212 of the key structure 3210.

For example, the contact point expansion member 3230 (e.g., contact point expansion structure, contact point expansion ring) may contact an upper surface (e.g., upper part) of the vibration structure 3240.

For example, the contact point expansion member 3230 may be formed in a circular outer shape.

For example, the contact point expansion member 3230 may be formed in a rectangular outer shape.

For example, the contact point expansion member 3230 (e.g., contact point expansion structure, contact point expansion ring) contacts the vibration structure 3240; thus, a contact point between the key structure 3210 and the vibration structure 3240 is expanded, i.e., increased. A vibration generated in the vibration structure 3240 may be more effectively transferred to the key structure 3210 by the contact point expansion member 3230 (e.g., contact point expansion structure, contact point expansion ring).

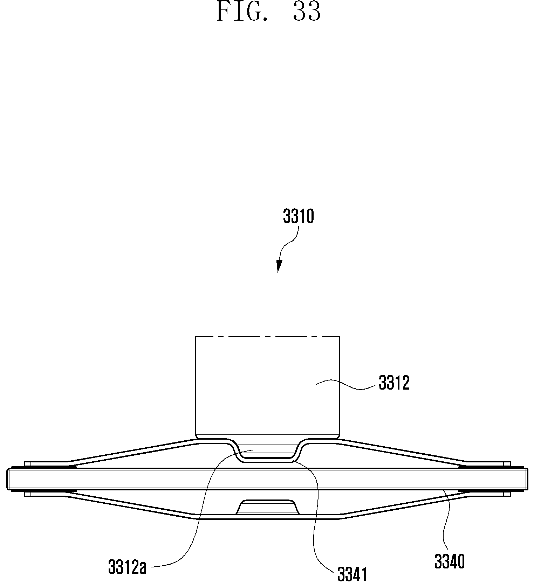

FIG. 33 is a diagram illustrating a key structure and a vibration structure.

With reference to FIG. 33, a vibration structure 3340 may be disposed to contact at least a portion of a key structure 3310 to provide (e.g., transfer) a vibration to the key structure 3310. For example, a first part of the key structure 3310 may be exposed to the outside of the housing (e.g., the housing 610 of FIG. 10) so that the user may press the key. At least a portion of a second part 3312 connected to the first part of the key structure 3310 may be disposed inside a side surface (e.g., the side surface 612 of FIG. 10) of the housing (e.g., the housing 610 of FIG. 10). A lower end portion 3312a of the second part 3312 of the key structure 3310 may be formed to have a narrow width as it goes downward, and a bottom of the lower end portion 3312a may be formed to be flat.

For example, a groove 3341 may be formed in an upper part (e.g., upper surface) of the vibrating structure 3340. The groove 3341 formed in the vibration structure 3340 may have a flat bottom surface. The lower end portion 3312a of the second part 3312 of the key structure 3310 may be inserted (e.g., received) into the groove 3341 formed in the vibration structure 3340. The lower end portion 3312a of the second part 3312 of the key structure 3310 is inserted (e.g., received) into the groove 3341 formed in the vibration structure 3340; thus, the key structure 3310 may be fixed over the vibration structure 3340.

For example, a vibration is applied to the key structure 3310 by the vibration structure 3340; thus, the side key may provide a haptic function. The larger an area of a contact point between the vibration structure 3340 and the lower end portion 3312a of the second part 3312 of the key structure 3310, the more effectively a vibration generated in the vibration structure 3340 may be transferred to the key structure 3310. When the lower end portion 3312a of the second part 3312 of the key structure 3310 is inserted into the groove 3341 formed in the vibrating structure 3340 in a semi-fixed(e.g., partial movement is allowed) form, an area of the contact point may be expanded.

For example, a width of the second part 3312 of the key structure 3310 may be formed to be wider than that of the groove 3341 formed in the vibration structure 3340. The width of the second part 3312 of the key structure 3310 is formed to be wider than that of the groove 3341 formed in the vibration structure 3340; thus, at least a portion of a lower surface of the second part 3312 of the key structure 3310 may be disposed to contact an upper surface of the vibration structure 3340. The width of the second part 3312 of the key structure 3310 is formed to be wider than that of the groove 3341 formed in the vibration structure 3340; thus, a contact point between the key structure 3310 and the vibration structure 3340 is expanded, i.e., increased. In this way, a vibration generated in the vibration structure 3340 is more effectively transferred to the key structure 3310 by the contact point expansion member 3230 (e.g., contact point expansion structure, contact point expansion ring).

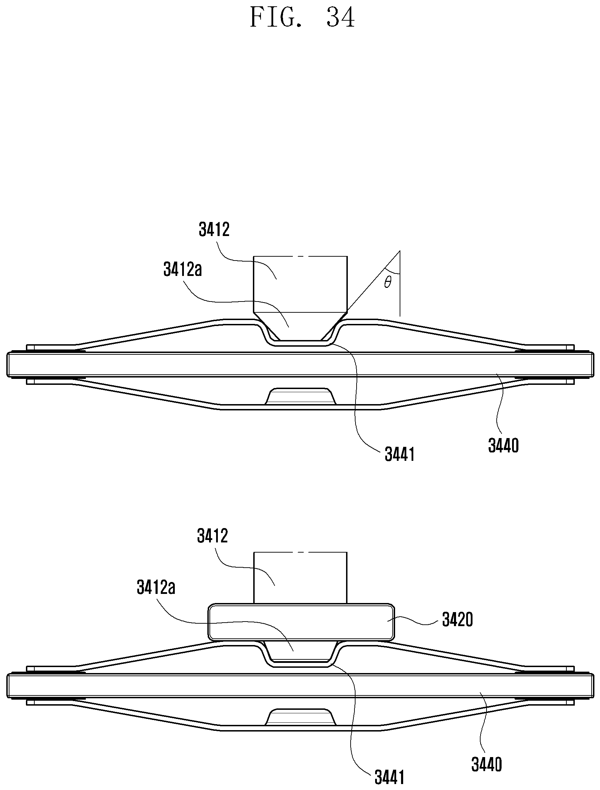

FIG. 34 is a diagram illustrating a key structure and a vibration structure.

With reference to FIG. 34, a lower end portion 3412a of a second part 3412 of the key structure may be formed to have a narrower width as it goes downward, and a bottom of the lower end portion 3412a may be flat.

For example, a groove 3441 formed in a vibration structure 3440 may have a flat bottom surface. For example, the second part 3412 of the key structure may be inserted into the groove 3441 of the vibration structure 3440; thus, the second part 3412 of the key structure and the vibration structure 3440 may be disposed to contact each other. A vibration generated in the vibration structure 3440 may be transferred to the key structure. For example, by adjusting an inclination angle θ of the lower end portion 3412a of the second part 3412, a contact area between the second part 3412 and the vibration structure 3440 may be adjusted.

According to an embodiment, a contact point expansion member 3420 (e.g., contact point expansion structure, contact point expansion ring) may be disposed in the second part 3412 of the key structure.

For example, the contact point expansion member 3420 (e.g., contact point expansion structure, contact point expansion ring) may be fitted into the second part 3412 of the key structure.

For example, the contact point expansion member 3420 (e.g., contact point expansion structure, contact point expansion ring) may contact an upper surface (e.g., upper part) of the vibration structure 3440.

The contact point expansion member 3420 (e.g., contact point expansion structure, contact point expansion ring) is disposed to contact the vibration structure 3440; thus, a contact point between the key structure and the vibration structure 3440 may be expanded. A vibration generated in the vibration structure 3440 may be more effectively transferred to the key structure by the contact point expansion member 3420 (e.g., contact point expansion structure, contact point expansion ring).

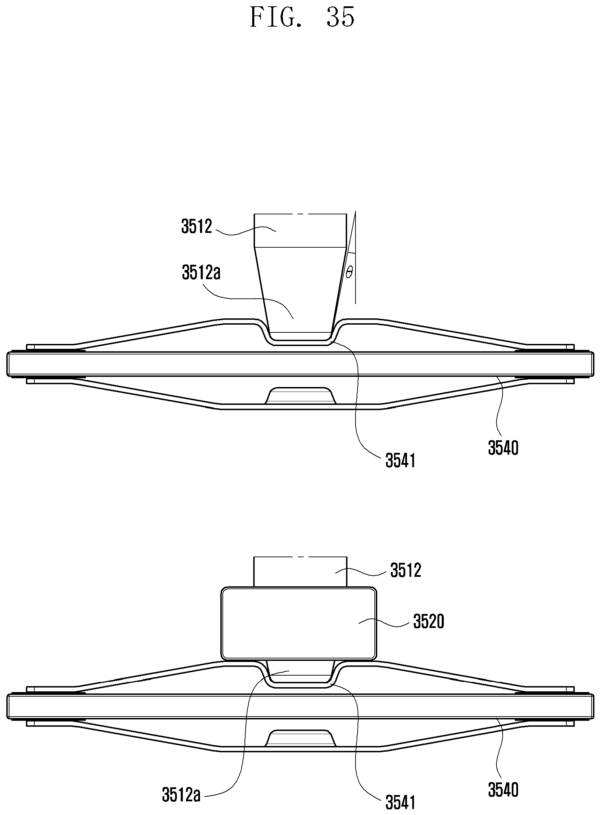

FIG. 35 is a diagram illustrating a key structure and a vibration structure.

With reference to FIG. 35, a lower end portion 3512a of a second part 3512 of the key structure may be formed to have a narrower width as it goes downward, and a bottom of the lower end portion 3512a may be formed to be flat.

For example, a groove 3541 formed in a vibration structure 3540 may have a flat bottom surface. For example, the second part 3512 of the key structure may be inserted into the groove 3541 of the vibration structure 3540; thus, the second part 3512 of the key structure and the vibration structure 3540 may be disposed to contact each other. A vibration generated in the vibration structure 3540 may be transferred to the key structure. For example, by adjusting an inclination angle θ of the lower end portion 3512a of the second part 3512, a contact area between the second part 3512 and the vibration structure 3540 may be adjusted.

According to an embodiment, a contact point expansion member 3520 (e.g., contact point expansion structure, contact point expansion ring) may be disposed in the second part 3512 of the key structure.

For example, the contact point expansion member 3520 (e.g., contact point expansion structure, contact point expansion ring) may be disposed integrally with the second part 3512 of the key structure.

For example, the contact point expansion member 3520 (e.g., contact point expansion structure, contact point expansion ring) may be fitted into the second part 3512 of the key structure.

For example, the contact point expansion member 3520 (e.g., contact point expansion structure, contact point expansion ring) may contact an upper surface (e.g., upper part) of the vibration structure 3540.

The contact point expansion member 3520 (e.g., contact point expansion structure, contact point expansion ring) contacts the vibration structure 3540; thus, an area of the contact point between the key structure and the vibration structure 3540 is expanded, i.e., increased. A vibration generated in the vibration structure 3540 may be more effectively transferred to the key structure by the contact point expansion member 3520 (e.g., contact point expansion structure, contact point expansion ring).

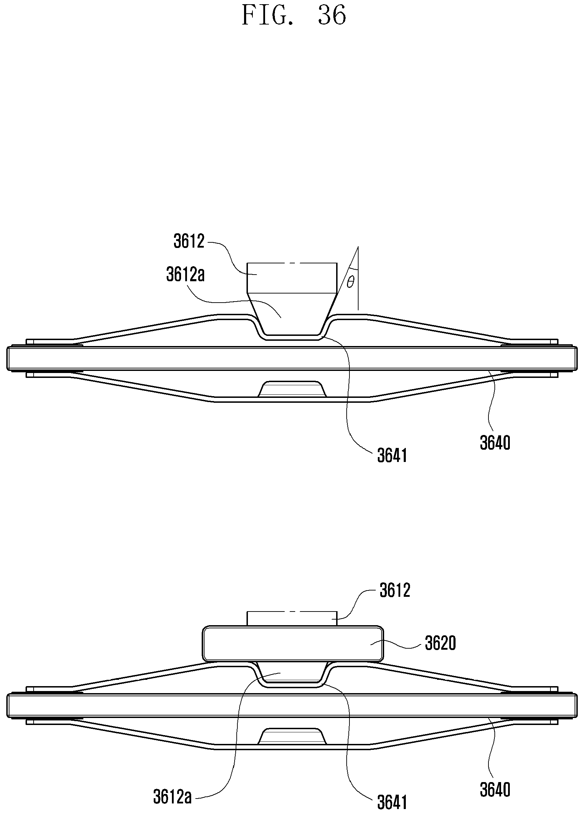

FIG. 36 is a diagram illustrating a key structure and a vibration structure.

With reference to FIG. 36, a lower end portion 3612a of a second part 3612 of the key structure may be formed to have a narrower width as it goes downward, and a bottom of the lower end portion 3612a may be formed to be flat.

For example, a groove 3641 formed in a vibration structure 3640 may have a flat bottom surface. For example, the second part 3612 of the key structure may be inserted into the groove 3641 of the vibration structure 3640; thus, the second part 3612 of the key structure and the vibration structure 3640 may be disposed to contact each other. A vibration generated in the vibration structure 3640 may be transferred to the key structure. For example, by adjusting an inclination angle θ of the lower end portion 3612a of the second part 3612, a contact area between the second part 3612 and the vibration structure 3640 may be adjusted.

According to an embodiment, a contact point expansion member 3620 (e.g., contact point expansion structure, contact point expansion ring) may be disposed in the second part 3612 of the key structure.

For example, the contact point expansion member 3620 (e.g., contact point expansion structure, contact point expansion ring) may be disposed integrally with the second part 3612 of the key structure.

For example, the contact point expansion member 3620 (e.g., contact point expansion structure, contact point expansion ring) may be fitted into the second part 3612 of the key structure.

For example, the contact point expansion member 3620 (e.g., contact point expansion structure, contact point expansion ring) may contact an upper surface (e.g., upper part) of the vibration structure 3640.

The contact point expansion member 3620 (e.g., contact point expansion structure, contact point expansion ring) is disposed to contact the vibration structure 3640; thus, a contact point between the key structure and the vibration structure 3640 may be expanded. A vibration generated in the vibration structure 3640 may be more effectively transferred to the key structure by the contact point expansion member 3620 (e.g., contact point expansion structure, contact point expansion ring).

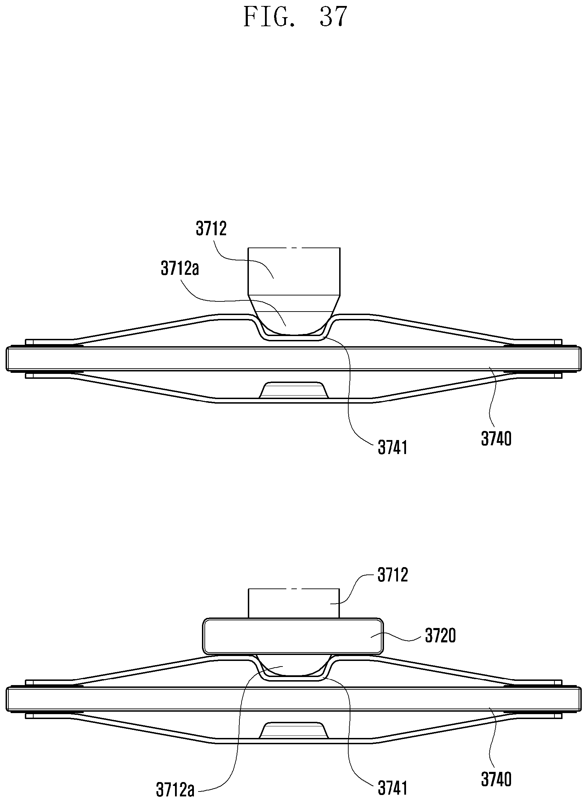

FIG. 37 is a diagram illustrating a key structure and a vibration structure.

With reference to FIG. 37, a lower end portion 3712a of a second part 3712 of the key structure may be formed to have a narrower width as it goes downward, and a bottom of the lower end portion 3712a may be formed in a concave shape (e.g., hemispherical shape).

For example, a groove 3741 formed in the vibration structure 3740 may have a flat bottom surface. For example, the second part 3712 of the key structure may be inserted into the groove 3741 of the vibration structure 3740; thus, the second part 3712 of the key structure and the vibration structure 3740 may be disposed to contact each other. A vibration generated in the vibration structure 3740 may be transferred to the key structure. For example, by adjusting an inclination angle θ of the lower end portion 3712a of the second part 3712, a contact area between the second part 3712 and the vibration structure 3740 may be adjusted.

According to an embodiment, a contact point expansion member 3720 (e.g., contact point expansion structure, contact point expansion ring) may be disposed in the second part 3712 of the key structure.

For example, the contact point expansion member 3720 (e.g., contact point expansion structure, contact point expansion ring) may be disposed integrally with the second part 3712 of the key structure.

For example, the contact point expansion member 3720 (e.g., contact point expansion structure, contact point expansion ring) may be fitted into the second part 3712 of the key structure.

For example, the contact point expansion member 3720 (e.g., contact point expansion structure, contact point expansion ring) may be disposed to contact an upper surface (e.g., upper part) of the vibration structure 3740.

The contact point expansion member 3720 (e.g., contact point expansion structure, contact point expansion ring) contacts the vibration structure 3740; thus, a contact point between the key structure and the vibration structure 3740 is expanded, i.e., increased. A vibration generated in the vibration structure 3740 may be more effectively transferred to the key structure by the contact point expansion member 3720 (e.g., contact point expansion structure, contact point expansion ring).

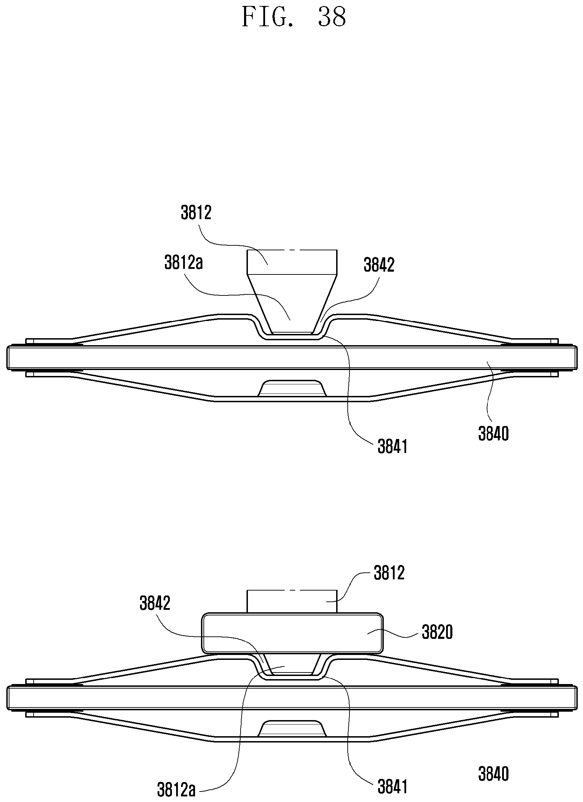

FIG. 38 is a diagram illustrating a key structure and a vibration structure.

With reference to FIG. 38, a lower end portion 3812a of a second part 3812 of the key structure may be formed to have a narrower width as it goes downward, and a bottom of the lower end portion 3812a may be formed to be flat.

For example, a groove 3841 formed in the vibration structure 3840 may have a flat bottom surface. For example, the second part 3812 of the key structure may be inserted into the groove 3841 of the vibration structure 3840; thus, the second part 3812 of the key structure and the vibration structure 3840 may be disposed to contact each other. A vibration generated in the vibration structure 3840 may be transferred to the key structure. For example, by adjusting an inclination angle θ of the lower end portion 3812a of the second part 3812, a contact area between the second part 3812 and the vibration structure 3840 may be adjusted.

For example, there may be provided a gap 3842 between a side surface of the groove 3841 formed in the vibration structure 3840 and the lower end portion 3812a of the second part 3812 of the key structure. Thus, the key structure may move, e.g., vibrate, more smoothly.

According to an embodiment, a contact point expansion member 3820 (e.g., contact point expansion structure, contact point expansion ring) may be disposed in the second part 3812 of the key structure.

For example, the contact point expansion member 3820 (e.g., contact point expansion structure, contact point expansion ring) may be disposed integrally with the second part 3812 of the key structure.

For example, the contact point expansion member 3820 (e.g., contact point expansion structure, contact point expansion ring) may be fitted into the second part 3812 of the key structure.

For example, the contact point expansion member 3820 (e.g., contact point expansion structure, contact point expansion ring) may be disposed to contact an upper surface (e.g., upper part) of the vibration structure 3840.

The contact point expansion member 3820 (e.g., contact point expansion structure, contact point expansion ring) contacts the vibration structure 3840; thus, a contact point between the key structure and the vibration structure 3840 is expanded. A vibration generated in the vibration structure 3840 may be more effectively transferred to the key structure by the contact point expansion member 3820 (e.g., contact point expansion structure, contact point expansion ring).

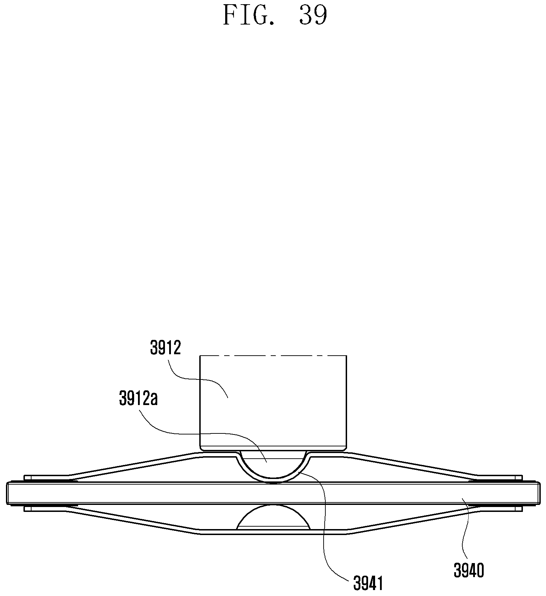

FIG. 39 is a diagram illustrating a key structure and a vibration structure.

With reference to FIG. 39, a lower end portion 3912a of a second part 3912 of the key structure may be formed in a convex shape (e.g., hemispherical shape).

For example, a bottom surface of a groove 3941 formed in a vibration structure 3940 may be formed in a concave shape (e.g., hemispherical shape). For example, the second part 3912 of the key structure may be inserted into the groove 3941 of the vibration structure 3940; thus, the second part 3912 of the key structure and the vibration structure 3940 may be disposed to contact each other.

For example, a width of the second part 3912 of the key structure may be formed to be wider than that of the groove 3941 formed in the vibration structure 3940. The width of the second part 3912 of the key structure is formed to be wider than that of the groove 3941 formed in the vibration structure 3940; thus, at least a portion of a lower surface of the second part 3912 of the key structure contacts an upper surface of the vibration structure 3940. The width of the second part 3912 of the key structure is formed to be wider than that of the groove 3941 formed in the vibration structure 3940; thus, an area of the contact point between the key structure and the vibration structure 3940 is expanded, i.e., increased. In this way, a vibration generated in the vibration structure 3940 can be more effectively transferred to the key structure by the contact point expansion member 3230 (e.g., contact point expansion structure, contact point expansion ring).

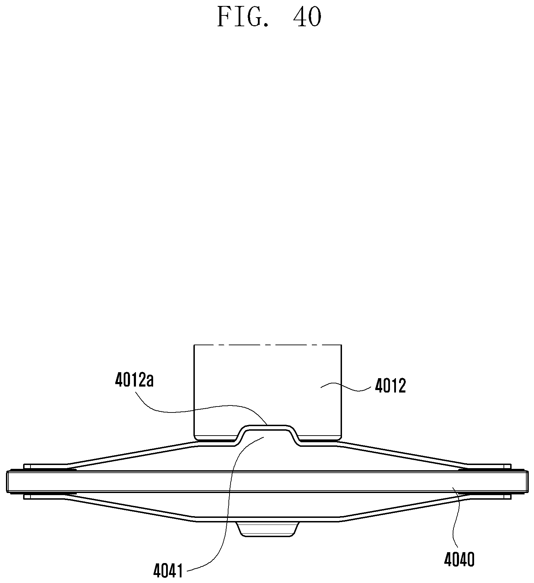

FIG. 40 is a diagram illustrating a key structure and a vibration structure.

With reference to FIG. 40, a groove 4012a may be formed at a lower end portion of a second part 4012 of the key structure.

For example, a convex-shaped protrusion 4041 may be formed at an upper surface of a vibration structure 4040. The protrusion 4041 of the vibrating structure 4040 is inserted into the groove 4012a formed at a lower end portion of the second part 4012 of the key structure; thus, the second part 4012 of the key structure and the vibrating structure 4040 may be disposed to contact each other.

For example, a width of the second part 4012 of the key structure may be formed to be wider than that of the protrusion 4041 formed in the vibration structure 4040. The width of the second part 4012 of the key structure is formed to be wider than that of the protrusion 4041 formed in the vibration structure 4040; thus, at least a portion of a lower surface of the second part 4012 of the key structure may be disposed to contact an upper surface of the vibration structure 4040. The width of the second part 4012 of the key structure is formed to be wider than that of the protrusion 4041 formed in the vibration structure 4040; thus, an area of a contact point between the key structure and the vibration structure 4040 is expanded, i.e., increased. In this way, a vibration generated in the vibration structure 4040 can be more effectively transferred to the key structure by the contact point expansion member 3230 (e.g., contact point expansion structure, contact point expansion ring).

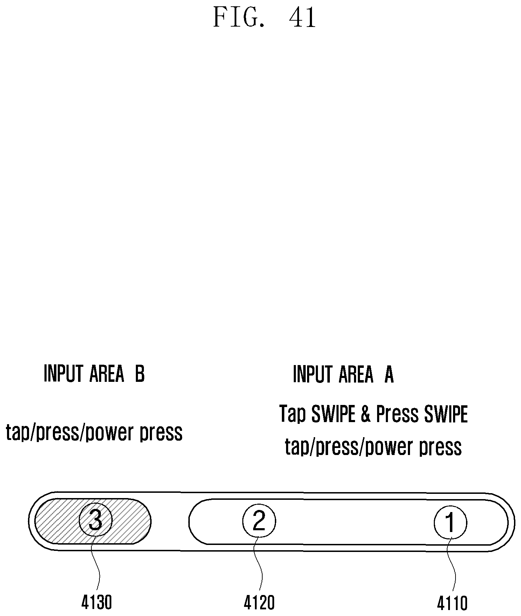

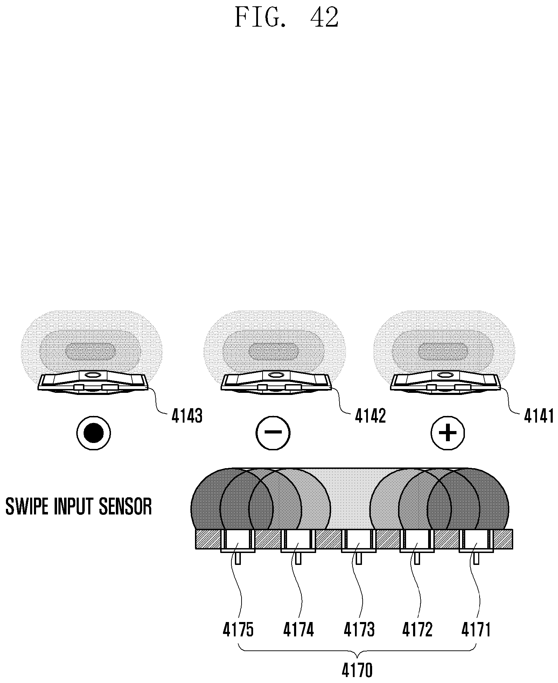

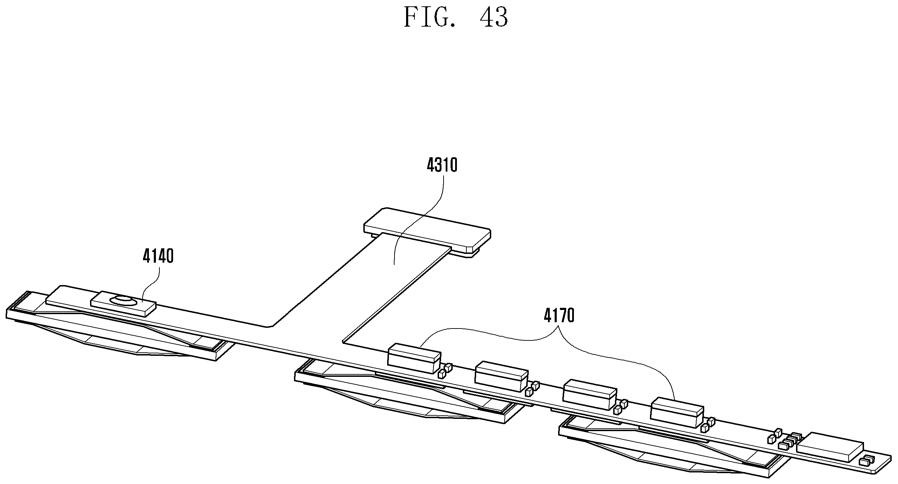

FIGS. 41 and 42 are diagrams illustrating sensing a user's swipe key input using a side key. FIG. 43 is a diagram illustrating a plurality of sensors and vibration structures disposed on a printed circuit board.

With reference to FIGS. 41 to 43, the electronic device of the disclosure may sense an input of a first key 4110, a second key 4120, and a third key 4130 using a plurality of key structures (e.g., three key structures) included in a side key 4100.

According to an embodiment, a plurality of sensors 4170 and a vibration structure 4140 may be disposed on a printed circuit board 4310.

According to an embodiment, the first key 4110 may be used as a volume up key. The second key 4120 may be used as a volume down key. The third key 4130 may be used as a home key (or power on-off key).

According to an embodiment, the user's swipe key input (e.g., sliding key input) may be sensed using the first key 4110 and the second key 4120.

In one embodiment, the "Tap SWIPE & Press SWIPE tap/press/power press" function can be performed using the A input area in FIG. 41. The B input area can be utilized to perform the "tap/press/power press" function in FIG. 41.

For example, the user's swipe key input (e.g., sliding key input) moving from the first key 4110 to the second key 4120 may be sensed using a plurality of sensors 4171, 4172, 4173, 4174, and 4175. By sensing a pressure of a key input moving from the first key 4110 to the second key 4120 using the plurality of sensors 4171, 4172, 4173, 4174, and 4175, a swipe key input (e.g., sliding key input) may be sensed.

For example, the user's swipe key input (e.g., sliding key input) moving from the second key 4120 to the first key 4110 may be sensed using the plurality of sensors 4171, 4172, 4173, 4174, and 4175. By sensing a pressure of a key input moving from the second key 4120 to the first key 4110 using the plurality of sensors 4171, 4172, 4173, 4174, and 4175, a swipe key input (e.g., sliding key input) may be sensed.

For example, by sensing a pressure applied between the first key 4110 and the second key 4120 using the plurality of sensors 4171, 4172, 4173, 4174, and 4175, a key input may be sensed.

The electronic device may perform a function according to the user's swipe key input (e.g., sliding key input).

The electronic device (e.g., the electronic device 101 of FIG. 1, the electronic device 200 of FIG. 2A, the electronic device 300 of FIG. 3A, the electronic device 400 of FIG. 4, the electronic device 500 of FIG. 5, the electronic device 600 of FIG. 6, and the electronic device 1000 of FIG. 10) according to an embodiment of the disclosure may independently provide a haptic function with a plurality of side keys disposed at one side surface (or both side surfaces) of the housing (e.g., the housing 610 of FIG. 6, the housing 610 of FIG. 10).

The electronic device (e.g., the electronic device 101 of FIG. 1, the electronic device 200 of FIG. 2A, the electronic device 300 of FIG. 3A, the electronic device 400 of FIG. 4, the electronic device 500 of FIG. 5, the electronic device 600 of FIG. 6, and the electronic device 1000 of FIG. 10) according to an embodiment of the disclosure may provide various haptic responses according to the user's side key manipulation.

The electronic device (e.g., the electronic device 101 of FIG. 1, the electronic device 200 of FIG. 2A, the electronic device 300 of FIG. 3A, the electronic device 400 of FIG. 4, the electronic device 500 of FIG. 5, the electronic device 600 of FIG. 6, and the electronic device 1000 of FIG. 10) according to an embodiment of the disclosure may prevent a plurality of side keys from being significantly deviated from original positions thereof when pressed or touched.

The electronic device (e.g., the electronic device 101 of FIG. 1, the electronic device 200 of FIG. 2A, the electronic device 300 of FIG. 3A, the electronic device 400 of FIG. 4, the electronic device 500 of FIG. 5, the electronic device 600 of FIG. 6, and the electronic device 1000 of FIG. 10) according to an embodiment of the disclosure may provide a haptic function with a plurality of side keys disposed at one side surface (or both side surfaces) of the housing (e.g., the housing 610 of FIG. 6, the housing 610 of FIG. 10) and perform a function according to the user's swipe key input (e.g., sliding key input).

The electronic device (e.g., the electronic device 101 of FIG. 1, the electronic device 200 of FIG. 2A, the electronic device 300 of FIG. 3A, the electronic device 400 of FIG. 4, the electronic device 500 of FIG. 5, the electronic device 600 of FIG. 6, and the electronic device 1000 of FIG. 10) according to an embodiment of the disclosure may provide a haptic function with a plurality of side keys disposed at one side surface (or both side surfaces) of the housing (e.g., the housing 610 of FIG. 6, the housing 610 of FIG. 10) and perform a function according to the user's scroll key input.

The electronic device (e.g., the electronic device 101 of FIG. 1, the electronic device 200 of FIG. 2A, the electronic device 300 of FIG. 3A, the electronic device 400 of FIG. 4, the electronic device 500 of FIG. 5, the electronic device 600 of FIG. 6, and the electronic device 1000 of FIG. 10) according to an embodiment of the disclosure may provide a haptic function with a plurality of side keys disposed at one side surface (or both side surfaces) of the housing (e.g., the housing 610 of FIG. 6, the housing 610 of FIG. 10) and perform functions by pressing the plurality of side keys disposed at one side surface (or both side surfaces) of the housing.

The electronic device (e.g., the electronic device 101 of FIG. 1, the electronic device 200 of FIG. 2A, the electronic device 300 of FIG. 3A, the electronic device 400 of FIG. 4, the electronic device 500 of FIG. 5, the electronic device 600 of FIG. 6, and the electronic device 1000 of FIG. 10) according to an embodiment of the disclosure may provide a haptic function with a plurality of side keys disposed at one side surface (or both side surfaces) of the housing (e.g., the housing 610 of FIG. 6, the housing 610 of FIG. 10) and perform functions by touching the plurality of side keys.

The electronic device (e.g., the electronic device 101 of FIG. 1, the electronic device 200 of FIG. 2A, the electronic device 300 of FIG. 3A, the electronic device 400 of FIG. 4, the electronic device 500 of FIG. 5, the electronic device 600 of FIG. 6, and the electronic device 1000 of FIG. 10) according to an embodiment of the disclosure may sense the user's touch on a plurality of side keys, thereby reducing a thickness of the plurality of side keys.

The side key 620 illustrated in FIGS. 6 and 7 may be applied to the electronic device 200 (e.g., foldable electronic device) of FIGS. 2A to 2D or the electronic device 300 (e.g., flat panel type electronic device) of FIGS. 3A and 3B.

The side key 620 illustrated in FIGS. 6 and 7 may be applied to a foldable electronic device that may be in-folded or out-folded in a horizontal direction (e.g., x-axis direction) or a foldable electronic device that may be in-folded or out-folded in a vertical direction (e.g., y-axis direction).

The side key 620 illustrated in FIGS. 6 and 7 may be applied to an electronic device (e.g., slidable electronic device) disposed to slide in a first direction (e.g., slide in the x-axis direction) or to slide in a second direction (e.g., slide in the y-axis direction) to change a size of a screen.

The side key 1020 illustrated in FIGS. 10 and 11 may be applied to the electronic device 200 (e.g., foldable electronic device) of FIGS. 2A to 2D or the electronic device 300 (e.g., flat panel type electronic device) of FIGS. 3A and 3B.

The side key 1020 illustrated in FIGS. 10 and 11 may be applied to a foldable electronic device that may be in-folded or out-folded in the horizontal direction (e.g., x-axis direction) or a foldable electronic device that may be in-folded or out-folded in the vertical direction (e.g., y-axis direction).

The side key 1020 illustrated in FIGS. 10 and 11 may be applied to an electronic device (e.g., slidable electronic device) disposed to slide in a first direction (e.g., slide in the x-axis direction) or to slide in a second direction (e.g., slide in the y-axis direction) to change a size of a screen.

## Claims

1. An electronic device (600) comprising:
a housing (610) including a side surface (612),
wherein a hole is formed in the side surface (612) of the housing (610);
a side key (620) including a first part exposed to the outside through the hole in the side surface (612) and a second part connected to the first part and having a portion disposed inside the side surface 612;
a plurality of vibration structures (630) disposed to contact a second part of the side key (620); and
a plurality of sensors (640) configured to sense pressing or a touch of the side key (620).

2. The electronic device (600) of claim 1, wherein the side key (620) comprises:
a first key structure (621) including a first part exposed to the outside for pressing or a touch, and a second part having a first side connected to the first part and a second side contacting a portion of the plurality of vibration structures 630;
a second key structure (622) including a third part exposed to the outside for pressing or a touch, and a fourth part having a first side connected to the third part and a second side contacting a portion of the plurality of vibration structures 630; and
a third key structure (623) including a fifth part exposed to the outside for pressing or a touch, and a sixth part having a first side connected to the fifth part and a second side contacting a portion of the plurality of vibration structures 630.

3. The electronic device (600) of claim 2, wherein the first part of the first key structure (621) and the third part of the second key structure (622) are connected.

4. The electronic device (600) of any one of claims 2 or 3, wherein the fifth part of the third key structure (623) is separated from the first part of the first key structure (621) and the third part of the second key structure (622).

5. The electronic device (600) of any one of claims 2 to 4, wherein the plurality of vibration structures (630) comprise:
a first vibration structure (631 ) disposed to contact the second part of the first key structure (621) to apply a first vibration to the first key structure (621);
a second vibration structure (632) disposed to contact the fourth part of the second key structure (622) to apply a second vibration to the second key structure (622); and
a third vibration structure (633) disposed to contact the sixth part of the third key structure (623) to apply a third vibration to the third key structure (623).

6. The electronic device (600) of any one of claims 2 to 5, wherein the first vibration structure (631) comprises a first groove (631a) formed to insert at least a portion of the second part of the first key structure (621),
the second vibration structure (632) comprises a second groove (632a) formed to insert at least a portion of the fourth part of the second key structure (622), and
the third vibration structure (633) comprises a third groove (633a) formed to insert at least a portion of the sixth part of the third key structure (623).

7. The electronic device (600) of any one of claims 2 to 6, wherein the plurality of sensors (640) comprise:
a first sensor (641) configured to sense pressing or touch of the first key structure (621);
a second sensor (642) configured to sense pressing or touch of the second key structure (622); and
a third sensor (643) configured to sense pressing or touch of the third key structure (623).

8. The electronic device (600) of claim 7, wherein the first sensor (641), the second sensor (642), and the third sensor (643)are configured to sense pressing of the side key (620) and are disposed in a lower part of the plurality of vibration structures (630).

9. The electronic device (600) of any one of claims 1 to 6, wherein the plurality of sensors 640 or 1040 comprise:
a first sensor 1041 configured to sense a touch of a first part of the first key structure 621 or 1021;
a second sensor 1042 configured to sense a touch of a third part of the second key structure 622 or 1022; and
a third sensor 1043 configured to sense a touch of a fifth part of the third key structures 623 or 1023.

10. The electronic device (600) of claim 9, wherein the first sensor (1041), the second sensor (1042), and the third sensor (1043) are configured to sense touch of the side key (1020) and are disposed in an upper part of the plurality of vibration structures (1030).

11. The electronic device (600) of claim 7 or 9, further comprising:
a vibration structure driving integrated circuit (IC) 550 configured to operate the plurality of vibration structures; and
a sensor driving integrated circuit (IC) 560 configured to operate the plurality of sensors 640 and 1040.

12. The electronic device (600) of claim 11, further comprising a processor 120 configured to control an operation of the vibration structure driving IC 550 and the sensor driving IC 560.

13. The electronic device (600) of claim 6, wherein at least a portion of the second part (621b) of the first key structure (621) is inserted into and disposed in the first groove (631a).

14. The electronic device (600) of claim 6, wherein at least a portion of the second part (623b) of the second key structure (623) is inserted into and disposed in the second groove (622a).

15. The electronic device (600) of claim 6, comprising:
a first contact extension member disposed in a fitted manner on the second part (621b) of the first key structure (621); and
a second contact extension member disposed in a fitted manner on the second part (623b) of the second key structure (623);
wherein the first contact extension member is disposed to be in contact with an upper surface of the first vibration structure (631),
and the second contact extension member is disposed to be in contact with an upper surface of the second vibration structure (632).
